# EUROPEAN PATENT APPLICATION

(11) **EP 0 933 683 A2**
(43) Date of publication of application: **04.08.1999**
(21) Application number: 99108501.0
(22) Date of filing: 18.08.1993
(51) Int. Cl.: G03F 7/09, H01L 21/027, C23C 16/32, C23C 14/06, H01L 21/3213, H01L 21/314, C23C 16/30, C23C 16/40

(54) **Method of forming a resist pattern by using an optimized silicon carbide anti-reflective layer**

(30) Priority: 20.08.1992 JP 24431492; 31.10.1992 JP 31607392; 29.12.1992 JP 35975092
(62) Divisional of application: 93113219.5
(71) Applicant: SONY CORPORATION, Tokyo (JP)
(72) Inventor: Ogawa, Tohru, Shinagawa-ku, Tokyo (JP); Gocho, Tetsuo, Shinagawa-ku, Tokyo (JP)
(74) Representative: MÜLLER & HOFFMANN Patentanwälte

(57) **Abstract**

The present invention relates to a method of forming a resist pattern comprising the steps of forming an anti-reflective layer on an underlying metallic material, forming a photoresist layer on said anti-reflective layer, exposing said photoresist to monochromatic light, and developing said photoresist, wherein said anti-reflective layer is a silicon carbide layer and wherein the reflection refractive index n and the absorption refractive index k of said anti-reflective layer have a value near the optimal reflection refractive index and the optimal absorption refractive index, respectively, wherein said optimal reflection refractive index and said optimal absorption refractive index are obtainable by a method comprising the steps of
(I) determining an equi-contour line for the amount of energy absorption in a photoresist of an optionally determined film thickness using said reflection refractive index and said absorption refractive index of said anti-reflective layer as parameters,
(II) determining equi-contour lines for the amount of photoresist absorption for a plurality of resist film thicknesses in the same manner as in (I) above,
(III) finding a common region for the amount of the photoresist absorption for each of the equi-contour lines obtained in (II) above and setting the refractive indices defined by the common region as optimal refractive indices for the anti-reflective layer in the condition defined initially in (I) above,
(IV) determining the optical condition for the anti-reflective layer by conducting the same procedures as described above while changing the thickness of the anti-reflective layer and
(V) finding the optimal refractive indices for the anti-reflective layer for various thicknesses of the anti-reflective layer according to (IV) above.

## Description

The present invention concerns a method of determining conditions for an anti-reflective layer, a method of forming an anti-reflective layer, a method of forming a resist pattern by using a novel anti-reflective layer and a method of forming a film. In particular, it relates to a method of determining a condition of an anti-reflective layer for defining optical conditions such as a thickness and a refractive index condition, for example, reflection refractive index and absorption refractive index of an anti-reflective layer upon forming a resist pattern by exposing a photoresist on an anti-reflective layer formed on an underlying material by a monochromatic light, a method of forming the anti-reflective layer utilizing the above-mentioned method and a method of forming a resist pattern by using a novel anti-reflective layer, and a method of forming a film which can be used in the above mentioned method of forming the anti-reflective layer. The present invention can be utilized suitably, for example, to a case of setting an anti-reflective layer disposed for preventing the standing wave effect when photolithography is used or a case of forming a resist pattern by using an anti-reflective layer when photolithography is used upon manufacturing, for example, electronic materials (such as semi conductor devices).

For instance, in the photolithography, a KrF excimer laser beam (248 nm) is used and a lens of about 0.37 to 0.42 NA is mounted in most advanced steppers (projection exposing machine) at present (for example, Nikon NSR 1505 EX1, Canon FPA 4500). By using the steppers, research and development have been studied for design rule devices in a sub-half micron (0.5 um) region.

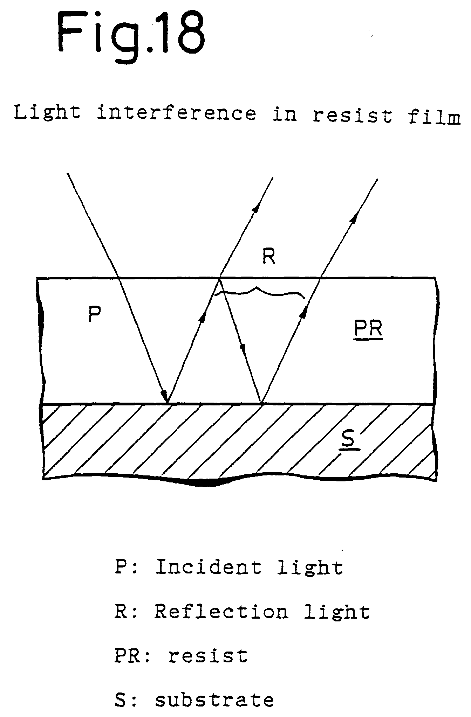

In the stepper, a monochromatic light is used as an exposing optical source. In a case of exposure by the monochromatic light, it has been generally known that a phenomenon referred to as a standing wave effect occurs. The standing wave is caused by occurrence of light interference in a resist film. That is, it is caused by interference between an incident light P and a reflection light R from the interface between a resist PR and a substrate S in the film of the resist RR (Fig. 18).

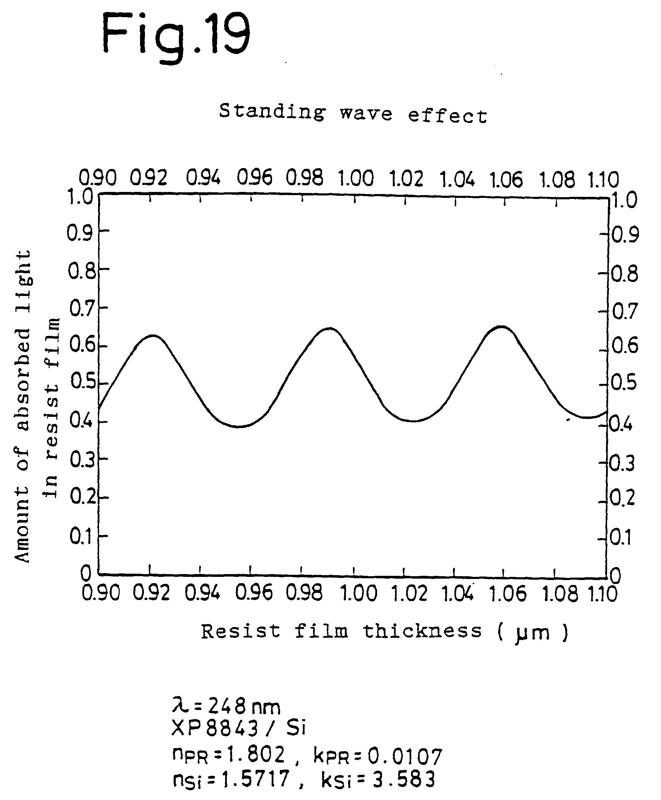

As a result, as shown in Fig. 19, the amount of light absorbed in the resist (ordinate in the graph) fluctuates depending on the thickness of the resist film (abscissa in the graph). In the present specification, the amount of light absorbed in the resist means an amount of light absorbed in the resist itself excluding the amount of light due to surface reflection, absorption by a metal if it is present in the resist, or light outgoing from the resist. The amount of the absorbed light constitutes an energy for causing light reaction to the resist.

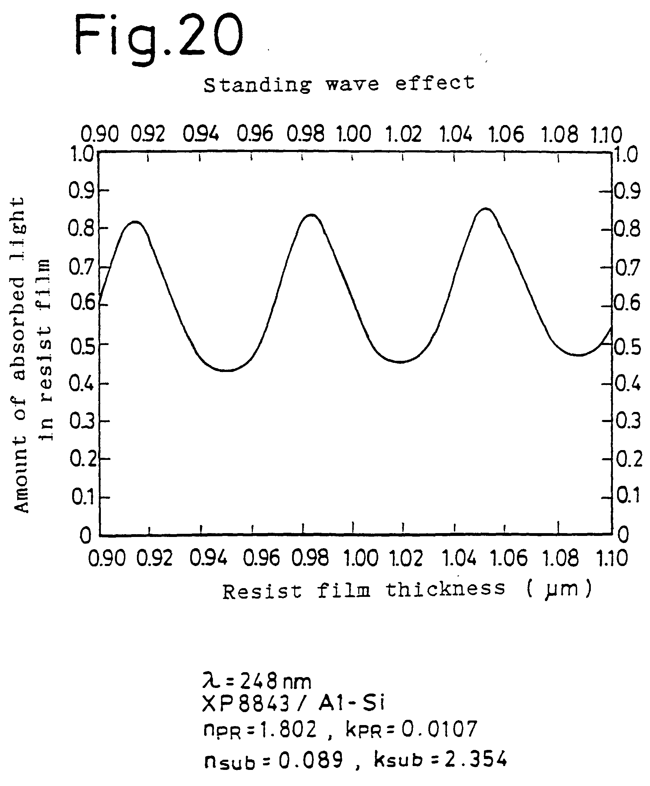

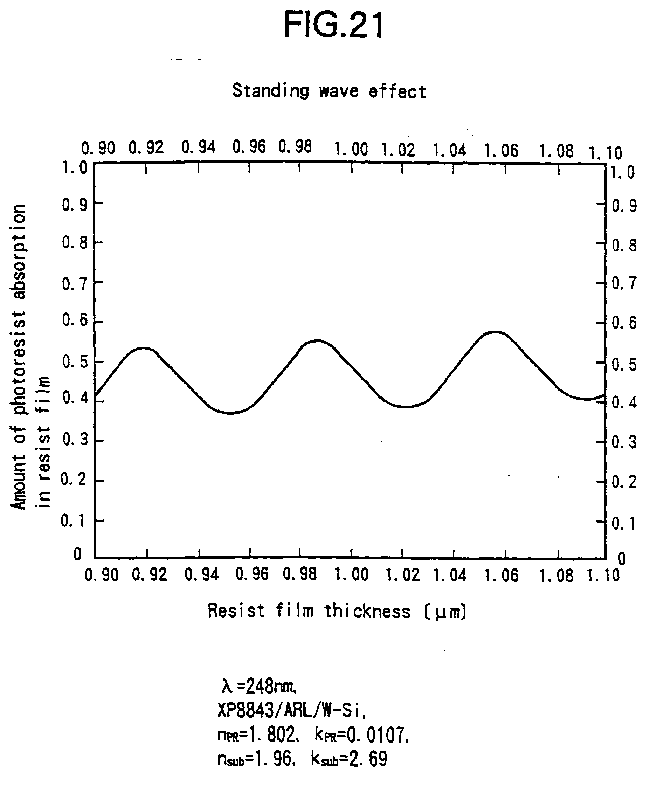

As can be seen from the comparison between Fig. 20 and Fig. 21, the extent of the fluctuation for the amount of the absorbed light differs also depending on the kind of underlying substrates. In Figs. 19, 20 and 21, XP 8843 (manufactured by Shipley Co.) is used in each of the cases and Si, Al-Si and W-Si are used as the underlying material in respective cases. That is, fluctuation for the amount of the absorbed light is determined by a complex swing reflectivity (R) (in which (R) represents that it is a vector amount having a real part and an imaginary part) considering multiple interference determined by optical constants (n, k) of the underlying material (substrate) and optical constants (n, k) of the resist.

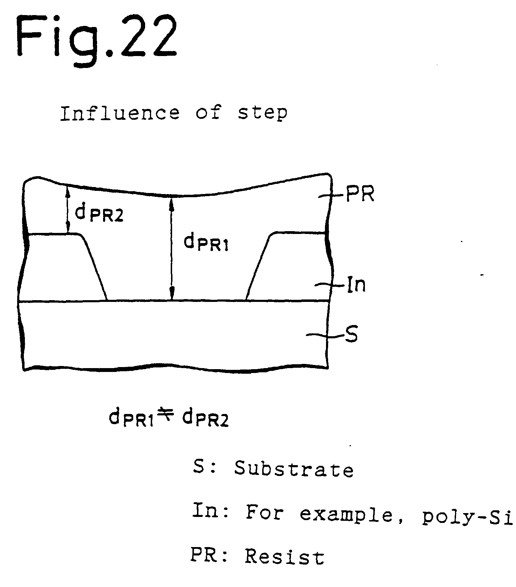

Further, in an actual device, as schematically shown in Fig. 22, unevenness is always present to the surface of a substrate. For instance, protrusions In such as poly-Si are present. Therefore, when the resist PR is coated, the thickness of the resist film varies between upper and lower portions of the step. That is, the thickness dPR2 of the resist film on the protrusion In is smaller than the thickness dPR1 of the resist film in other portions than the above. As has been described previously, the standing wave effect differs depending on the thickness of the resist film and, accordingly, fluctuation for the amount of the light absorbed in the resist changes respectively undergoing the effect of the standing wave effect. As a result, the dimension of the resist pattern obtained after exposure and development differs between the upper and the lower portions of the step.

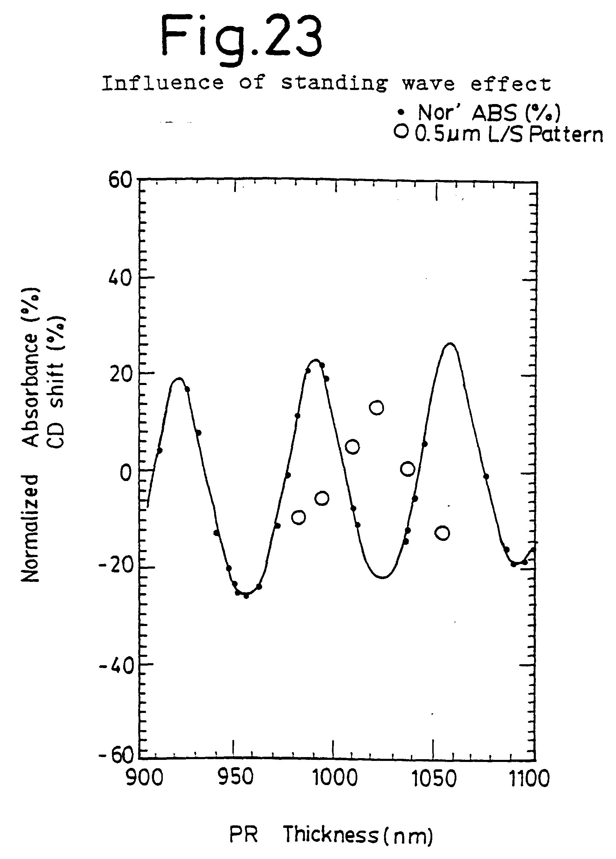

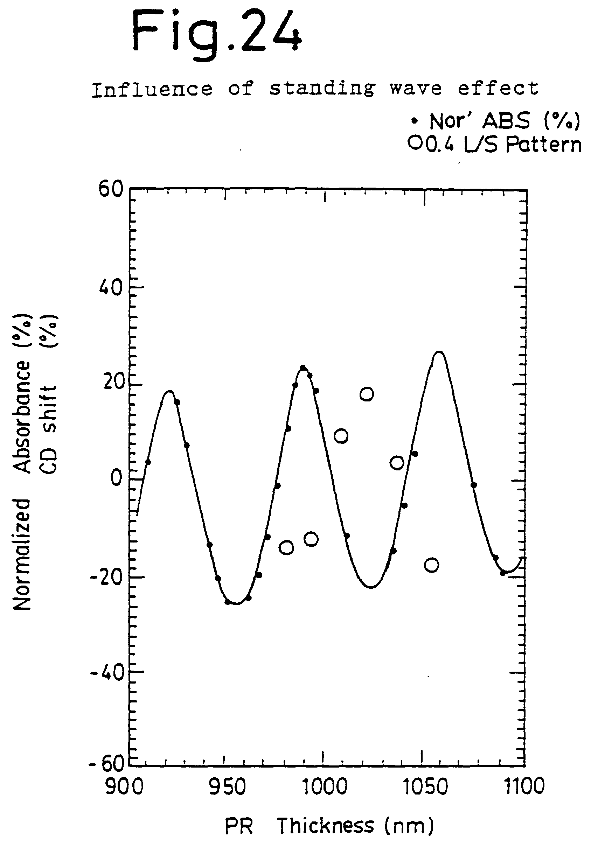

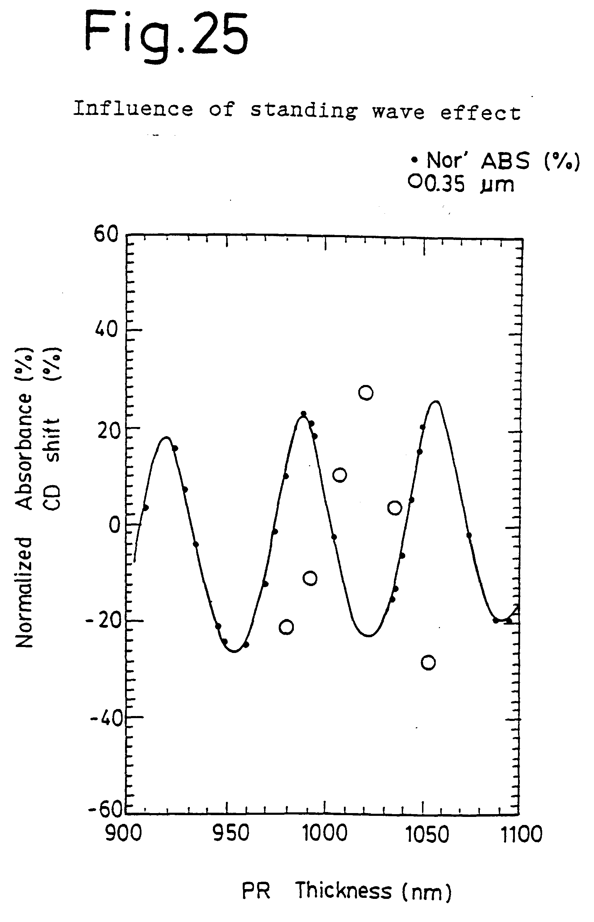

Influence of the standing wave effect on the dimension of the pattern becomes more remarkable as the pattern is finer in a case of using a stepper of an identical wave-length and an identical number of aperture. Figs. 23 - 25 show the influence of the standing wave effect on every pattern dimension in a case of using Nikon NSR 1505 EX1 as a stepper (exposure light used: 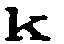 = 248 nm, KrF excimer, NA = 0.42) and using XP 8843 as a resist (chemically amplified type resist, a polyvinylphenol type resist containing optical acid generating agent, manufactured by Shipley Microelectronics Co.). It is apparent that the standing wave effect becomes remarkable as the pattern becomes finer (refer also to the scattering of critical dimension shift at 0.5 um, 0.4 um and 0.35 um line-and-space patterns shown by "open circles" in the drawings),

The above-mentioned trend is a phenomenon observed in common with all of resists.

The dimensional accuracy of a resist pattern in a photolithographic step upon manufacturing a device such as a semiconductor device is generally ±5%. Although it is considered that an accuracy coarser than ±5% in total may be practically tolerable. However, it is desirable that the pattern accuracy upon resist exposure is within ±5%, if occurrence of scattering due to other factors such as focus is also taken into consideration. For attaining the dimensional accuracy of ±5%, it is essential to reduce the standing wave effect.

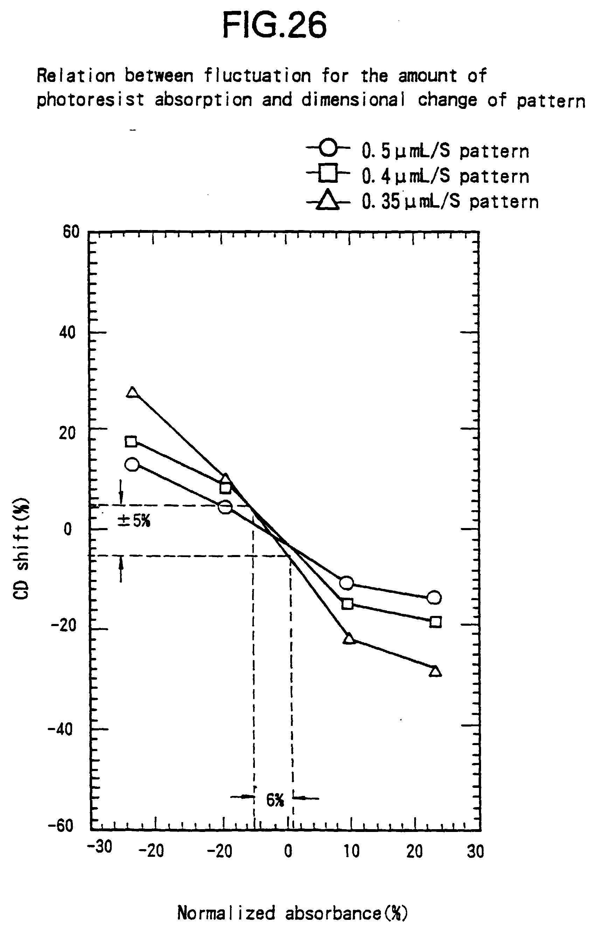

Fig. 26 shows a dimensional variation of the resist pattern relative to the fluctuation (ordinate) for the amount of absorbed light in the resist film (abscissa). As can be seen from Fig. 26, fluctuation for the amount of absorbed light in the resist film has to be within a range of less than 6% in order to manufacture, for example, a rule device of 0.35 um.

For satisfying the above-mentioned requirement, earnest studies have been made on the anti-reflective technique in each of the fields. However, although the material underlying material and the resist to be used are known, it is not always easy to determine as to what are the conditions for the anti-reflective layer that can attain an anti-reflective effect suitable to such a case.

For instance, in the formation of a pattern on a gate structure (for example, on a W-Si film) for which an anti-reflective layer is considered indispensable, it has not yet been determined regarding the condition for the anti-reflective layer that reduces fluctuation for the amount of the absorbed light in the resist film, for example to a range of less than 6%. Naturally, no effective anti-reflective layer material to be used for such W-Si has yet been found.

For the structure using the W-Si material as the gate, a pattern has now been formed at present, for example, by means of a multi-layer resist method or dye-incorporated resist. Accordingly, it is considered essential to establish anti-reflective technique on W-Si as soon as possible.

In such a case, if there is a means capable of determining comprehensive conditions and concrete conditions regarding an anti-reflective layer for forming a stable fine pattern on an optional underlying material (substrate) using an exposure optical source of an optional monochromatic light it can be found for the condition of the anti-reflective layer to be formed, for example, on W-Si. However, no such means has yet been proposed.

The present invention has been achieved in view of the foregoing situations and it is an object thereof to provide a method of determining a condition for an anti-reflective layer capable of determining a condition of the anti-reflective layer used in a case of forming a resist pattern on an optional underlying material (substrate) by using an exposure optical source of an optional monochromatic light, so that a stable resist pattern can be formed satisfactorily even if the resist pattern is fine.

Another object of the present invention is to provide a method of forming an anti-reflective layer by the condition described above.

A further object of the present invention is to provide a method of forming a resist pattern by developing a novel anti-reflective layer and using such an anti-reflective layer.

The foregoing object can be attained in accordance with the first aspect of the present invention by a method according to claim 1. This method comprises determining a condition for an anti-reflective layer upon forming a resist pattern by exposing a photoresist on the anti-reflective layer formed on an underlying material by a monochromatic light, wherein the film thickness and the optical condition of the anti-reflective layer are determined by the following means, which comprises
(I) determining an equi-contour line for the amount of absorbed light to a photoresist of an optionally determined film thickness using the optical condition for the anti-reflective layer as a parameter.
(II) determining equi-contour lines for the amount of absorbed light for a plurality of resist film thicknesses in the same manner as in (I) above,
(III) finding a common region for the amount of the absorbed light for each of the equi-contour lines obtained in (II) above and setting the optical condition defined by the common region as an optical condition for the anti-reflective layer in the condition defined initially in (1) above,
(IV) determining the optical condition for the anti-reflective layer by conducting the same procedures as described above while changing the condition for the anti- reflective layer and
(V) finding the optimum optical condition for the anti-reflective layer in the condition for the anti-reflective layer according to (IV) above.

According to a second aspect, this method comprises forming an anti-reflective layer upon forming a photoresist pattern by exposing a photoresist on the anti-reflective layer formed on an underlying material by a monochromatic light, wherein the anti-reflective layer is formed by using a substance adaptable to the optical condition for the refractive index based on the optimum refractive index condition for the anti-reflective layer determined as optimum optical condition by the means (I) - (V) as defined in the first aspect.

According to a third aspect of the present invention, the method comprises forming a resist pattern which comprises forming an anti-reflective layer with silicon carbide on an underlying refractory metal silicide material and forming a photoresist on the anti-reflective layer.

According to a fourth aspect of the present invention, the method comprises forming a resist pattern by forming an anti-reflective layer on an underlying metalic material and forming a photoresist on the anti-reflective layer thereby forming a resist pattern, where in the anti-reflective layer is formed with an inorganic substance (SiC) under the conditions of the film thickness and the optical condition determined by the following means, which comprises:
(I) determining an equi-contour line for the amount of (absorbed) light and dose to a photoresist of an optionally determined film thickness using the optical condition for the anti-reflective layer as a parameter,
(II) determining equi-contour lines for the amount of photoresist absorption for a plurality of resist film thicknesses in the same manner as in (I) above,
(III) finding a common region for the amount of the photoresist absorption for each of the equi-contour lines obtained in (II) above and setting the optical condition defined by the common region as an optical condition for the anti-reflective layer in the condition defined initially in (I) above.
(IV) determining the optical condition for the anti-reflective layer by conducting the same procedures as described above while changing the condition for the anti- reflective layer and
(V) finding the optimum optical condition for the anti-reflective layer in the condition for the anti-reflective layer according to (IV) above.

According to a fifth aspect of the present invention, the method comprises forming a resist pattern which comprises forming an anti-reflective layer on an underlying metalic material with silicon carbide and forming a photoresist on the anti-reflective layer thereby, forming a resist pattern.

According to a sixth aspect of the present invention, the method comprises forming an anti-reflective layer on an underlying inorganic material (including metal material and silicon material) and forming a resist pattern on the anti-reflective layer thereby forming the resist pattern, wherein the anti-reflective layer is formed with an inorganic substance (SiC) satisfying the film thickness and the optical condition determined by the following means, which comprises:
(I) determining an equi-contour line for the amount of photoresist absorption to a photoresist of an optionally determined film thickness using the optical condition for the anti-reflective layer as a parameter,
(II) determining equi-contour lines for the amount of photoresist absorption for a plurality of resist film thicknesses in the same manner as in (I) above,
(III) finding a common region for the amount of the photoresist absorption for each of the equi-contour lines obtained in (II) above and setting the optical condition defined by the common region as an optical condition for the anti-reflective layer in the condition defined initially in (I) above,
(IV) determining the optical condition for the anti-reflective layer by conducting the same procedures as described above while changing the condition for the anti- reflective layer and
(V) finding the optimum optical condition for the anti-reflective layer in the condition for the anti-reflective layer according to (IV) above.

According to a seventh aspect of the present invention, the method comprises forming a resist pattern which comprises forming an anti-reflective layer with silicon carbide on an underlying silicon material and forming a photoresist on the anti-reflective film, thereby forming a resist pattern.

According to a eighth aspect of the present invention, the method comprises forming a resist pattern as defined by the fourth aspect, wherein an anti-reflective layer is formed on an underlying metal material by using an inorganic substance (SiC) having a value within ±0.6 for the reflection refractive index n and a value within ±0.2 for the absorption refractive index k and forming a photoresist on the anti-reflective layer, thereby forming the resist pattern.

The inventors have also developed a method of forming a resist pattern, wherein an SiO film having reflection refractive index n = 2.4 ± 0.6 and absorption refractive index k = 0.7 ± 0.2 is used as an anti-reflective layer on an underlying metalic material and a method of forming a resist pattern, wherein a SiₓO_{y}N_{z} film or a SiₓN_{y} film having reflection refractive index n = 2.4 ± 0.6 and absorption refractive index k = 0.7 ± 0.2 is used as an anti-reflective layer on the underlying metalic material.

According to a further aspect of the present invention, the method comprises forming a resist pattern as defined by the eighth aspect, wherein the underlying metalic material comprises a refractory metal silicide.

The inventors have also developed a method of forming a resist pattern, in which a SiₓO_{y}N_{z} film is formed as an anti-reflective layer on the underlying metalic material thereby forming a resist pattern.

According to one aspect of this latter method, the metalic material is anyone of aluminum and aluminium alloys.

Furthermore, the inventors have developed a method of forming a resist pattern in which a SiₓO_{y}N_{z} or SiₓN_{y} film as an anti-reflective layer is formed on an underlying silicic material thereby forming a resist pattern.

According to one aspect of this latter method, the silicic material comprises any one of single crystal silicon, polycrystalline silicon, amorphous silicon and doped poly-silicon.

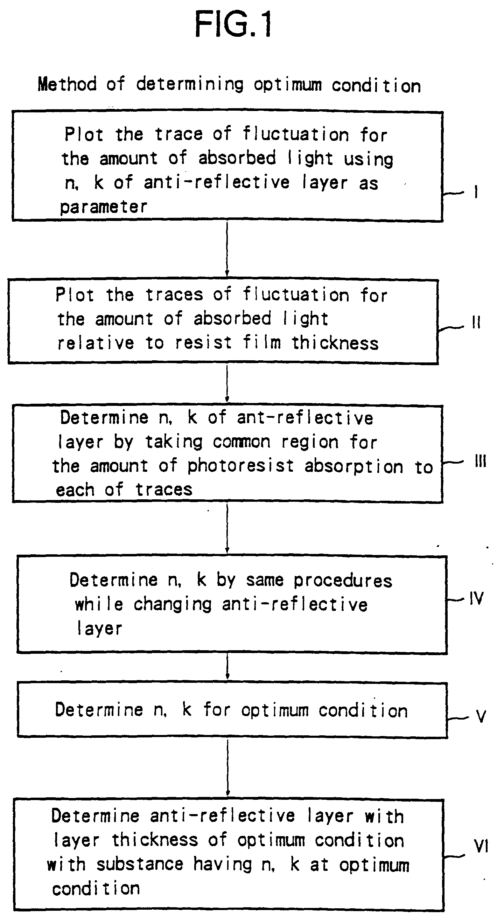

The first aspect of the present invention comprises as shown in Fig. 1,
(I) determining an equi-contour line for the amount of photoresist absorption to a photoresist of an optionally determined film thickness using the optical condition for the anti-reflective layer as a parameter,
(II) determining equi-contour lines for the amount of photoresist absorption for a plurality of resist film thicknesses in the same manner as in (I) above,
(III) finding a common region for the amount of the photoresist absorption for each of the equi-contour lines obtained in (II) above and setting the optical condition defined by the common region as an optical condition for the anti-reflective layer in the condition defined initially in (I) above.
(IV) determining the optical condition for the anti-reflective layer by conducting the same procedures as described above while changing the condition for the anti- reflective layer and
(V) finding the optimum optical condition for the anti-reflective layer in the condition for the anti-reflective layer according to (IV) above.

An optimum condition for the anti-reflective layer is obtained in accordance with the foregoing constitution and a substance adaptable to the condition, that is, capable of satisfying or substantially satisfying such a condition is selected thereby enabling to form an effective anti-reflective layer.

For instance, each of refractive indices n, k at each of specific wavelengths (exposure wavelength) is determined by a means such as a spectroscopic ellipsometer and a substance having such refractive indices n, k is searched from existent substances as the anti-reflective material, or a substance for such a condition can be synthesized to serve for the anti-reflective material.

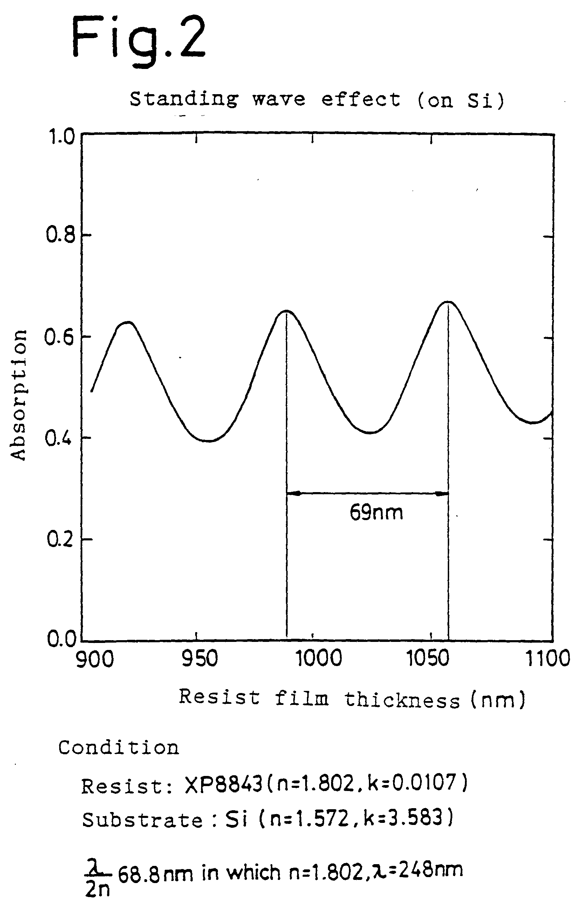

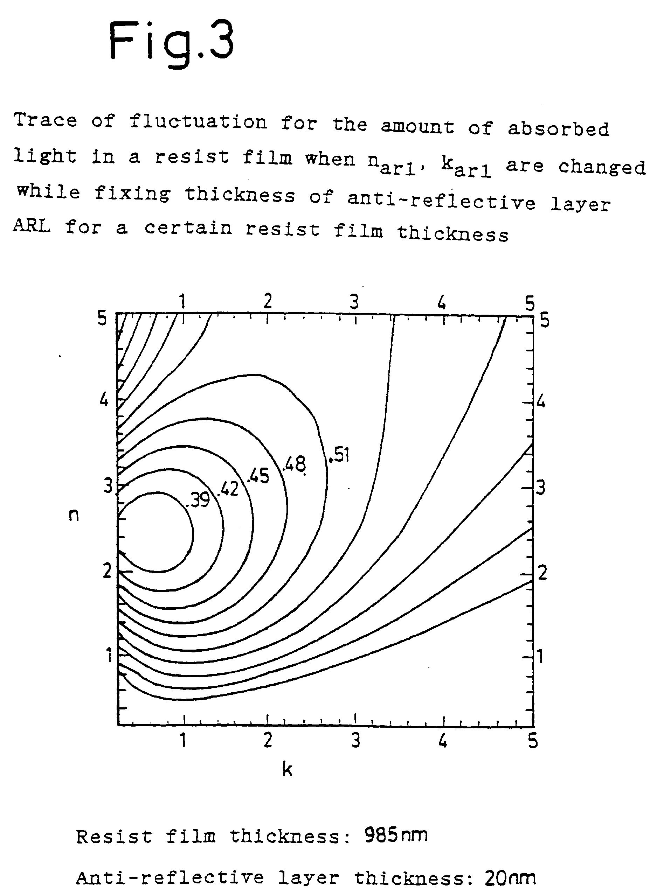

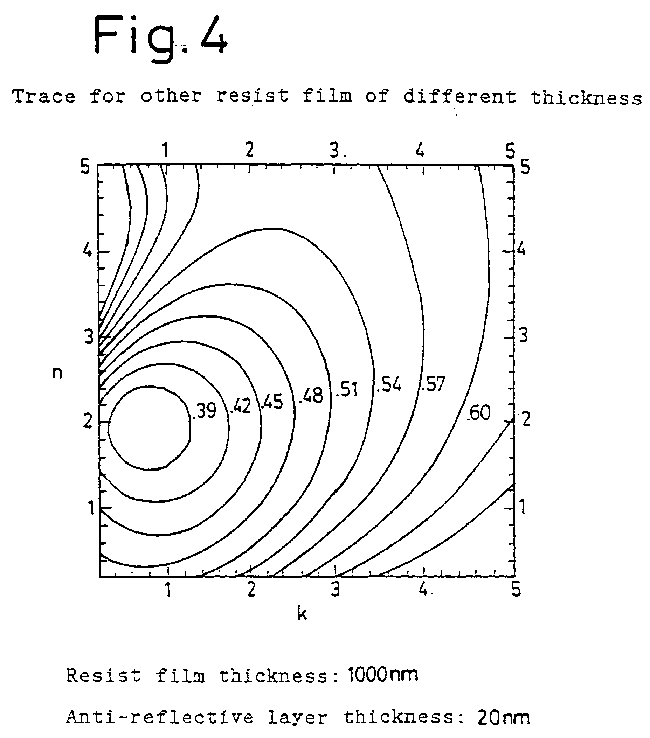

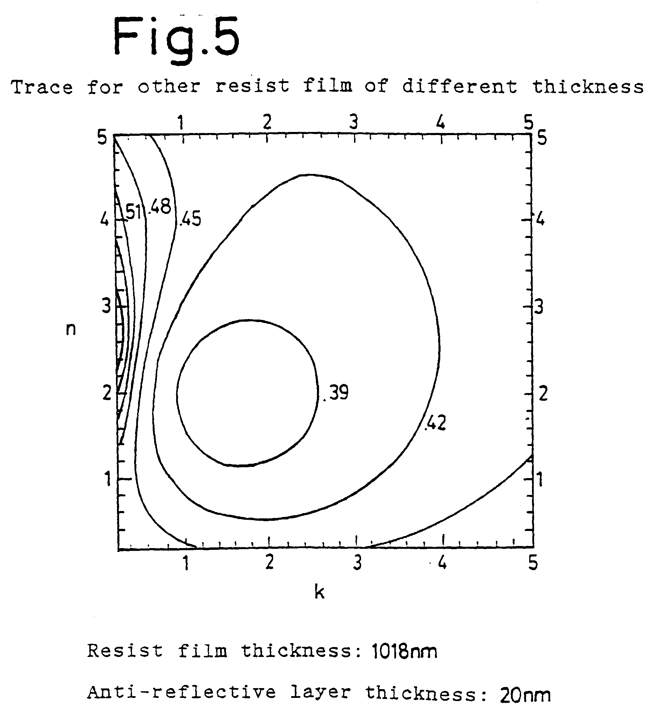

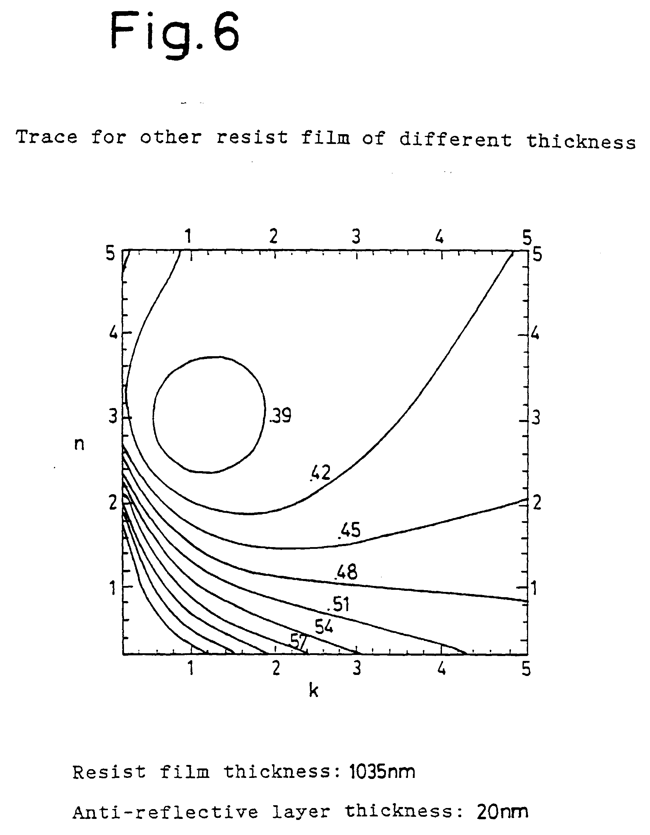

Description will then be made to a methodology of determining a comprehensive condition for an anti-reflective layer by using the present invention with reference to the drawings.
(1) The thickness of the resist film between maximum values or between minimum values of the standing wave effect is given as 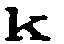 /4n assuming the refractive index of the resist as n_{PR} and the exposure wavelength as 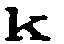 (refer to Fig. 2).
(2) An anti-reflective layer ARL is assumed between the resist and the substrate, with the film thickness as dₐᵣ₁ and optical constant as nₐᵣ₁, kₐᵣ₁.
(3) Taking notice on the film thickness at a certain point in Fig. 2 (for instance, a film thickness for maximizing the standing wave effect), the amount of the photoresist absorption in the resist film fluctuates at that point as nₐᵣ₁, kₐᵣ₁ are changed while the film thickness dₐᵣ₁ of the anti-reflective layer being fixed. The varying trace, that is, the equi-contour lines for the amount of photoresist absorption is determined as shown in Fig. 3. The procedures described above correspond to (I) in accordance with the present invention.
(4) When the procedure (3) is applied repeatingly to four points each at 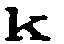 /8n_{PR} interval with reference to other different film thickness dₚᵣ of the resist, at least, film thickness maximizing or minimizing the standing wave effect, Fig. 4 to Fig. 6 corresponding to Fig. 3 are obtained (in Figs. 3 - 6, the thickness of the anti-reflective layer is defined as 20 nm and the thickness of the resist layer is defined as 985 nm, 1000 nm, 1018 nm and 1035 nm, respectively). This corresponds to the means (II).
(5) The common region for each of the graphs in Fig. 3 to Fig. 6 shows a region in which the amount of absorption in the resist film does not fluctuate even if the resist film thickness varies. That is, the common region described above is a region having a highest anti-reflective effect for minimizing the standing wave effect. Accordingly, such a common region is searched. The common region can be found conveniently, for example, by over-lapping each of the graphs to determine the common region (the common region may of course be retrieved by a computer). This corresponds to the means (III).
(6) Procedures (3), (4), (5) are repeated while continuously varying the film thickness d of the anti-reflective layer. For instance, assuming that the procedure was conducted, for example, at d = 20 nm up to (5), then the above-mentioned procedures are repeated while varying d. This can specify the condition for the film thickness dₐᵣ₁ of the anti-reflective layer minimizing the standing wave effect and a condition for the optical constant nₐᵣ₁, kₐᵣ₁. This corresponds to the (IV).

The kind of the film that satisfies the condition to be met by the anti-reflective layer specified in (6) above (film thickness, optical constant) is found by measuring the optical constant of each kind of the films by the exposure light. This corresponds to (V).

This methodology is applicable, in principle, to all of the wavelength and the kind of the underlying material (substrate). Further, an anti-reflective layer of an optimum condition can be formed in accordance with the condition obtained in (7) above and with the substance capable of satisfying the condition (corresponding to Fig. 1(VI)).

By using the method in accordance with the present invention, the anti-reflective layer as an effective means for forming a stable fine pattern on an optional underlying material (substrate) by using a stepper having an optical source of an optional monochromatic light can be designed easily.

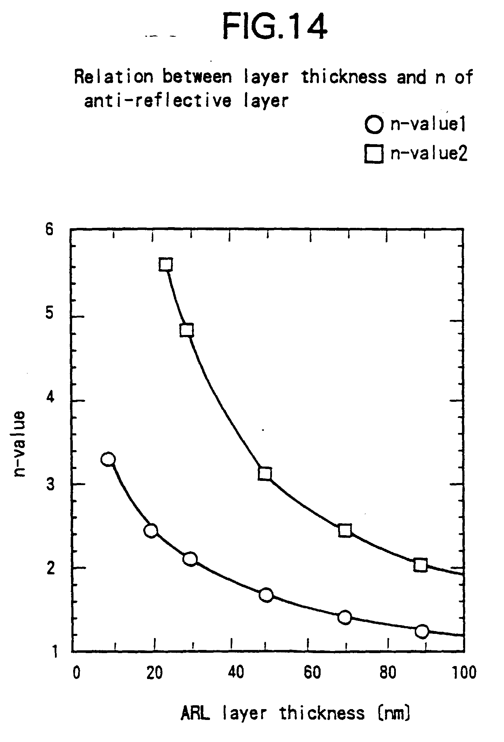

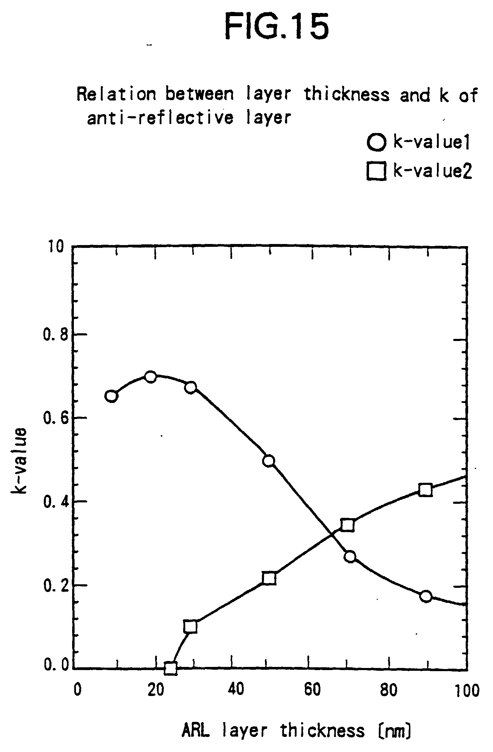

The present invention can be utilized for finding a condition of an organic or inorganic film for forming an anti-reflective layer used for forming a stable resist pattern on a W-Si film by using a KrF excimer laser. In this case, a substance having n, k condition shown in Figs. 14 and 15 to be described later can be used. In this case, it is desirable to use such an organic or inorganic layer having a tolerable range for each of n, k values in Figs. 14, 15, i.e., ±0.2 for n and ±0.05 for k. As for the anti-reflective layer, it is preferred to use SiC having n = 3.16 ± 0.2, k = 0.24 + 0.05 at a film thickness of 50 ± 10 nm. SiC constituting the anti-reflective layer can be formed by sputtering or CVD. SiC can also be etched by RIE using CF₄, CHF₃, C₂F₆, C₃F₈, SF₆ or NF₃ series gas as an etchant and by adding Ar to thereby improve ionic property.

The third through eighth aspects of the present invention can be attained by conducting the operation for finding the substance capable of satisfying the condition as described above by using the above-mentioned method. Referring to the third aspect of the present invention, it can be found that SiC (silicon carbide) is particularly appropriate on refractory metal silicide W-Si, based on which the present invention has been completed.

This invention can suitably be used in a case of forming a stable resist pattern on a W-Si film by using a KrF excimer laser, in which SiC with n = 3.16 ± 0.2 and k = 0.24 ± 0.05 at a film thickness of 50 ± 10 nm is preferably used as the anti-reflective layer. SiC constituting the anti-reflective layer can be formed by sputtering or CVD. SiC can be etched by RIE using CF₄, CHF₃, C₂F₆, C₃F₈, SF₆ or NF₃ gas as an etchant and by adding Ar to improve the ionic property.

Further, in the fourth aspect of the present invention, the concept of the first aspect is applied in a case of using a metalic material such as a refractory metal compound as the underlying material.

Referring to the fifth aspect of the present invention, upon forming a resist pattern by forming a resist on an anti-reflective layer, when an operation of finding out the substance capable of satisfying the condition in accordance with the condition obtained by the above-mentioned method is conducted, it has been found that SiC (silicon carbide) is suitable on a metalic wiring material, particularly, Al and Al-alloys material, for example, Al, Al-Si, Al-Si-Cu or Cu and Cu-alloys material such as Cu, as well as that an organic or inorganic material found by the above-mentioned method is appropriate, based on which the present invention has been attained.

This invention is preferably applied in a case of forming a stable resist pattern on an Al or al-alloys material such as Al, Al-Si or Al-Si-Cu or a Cu or Cu-alloys material such as Cu by using a KrF excimer laser. In this case, it is possible to use SiO with n = 1.83 ± 0.2 and k = 0.75 ± 0.2 at a layer thickness of 30 ± 10 nm as an anti-reflective layer, for example, on the Al or Al-alloys material. Alternatively, according to the invention SiC with n = 2.3 ± 0.2 and k = 0.8 ± 0.2 is preferably used at a layer thickness of 20 ± 10 nm. Alternatively, it is possible to use an organic or inorganic substance having an optimum curve regarding the refractive index and the layer thickness of the anti-reflective layer obtained in (V) above, and within a range of the value on the curve ±0.2 for n and the value on the curve ±0.15 for k. SiO constituting the anti-reflective layer can be formed by CVD or thermal oxidation. SiC can be formed by sputtering or CVD. The anti-reflective layer can be etched by RIE using CF₄, CHF₃, C₂F₆, C₃H₈, SF₆ or NF₃ series gas as an etchant and adding Ar and O₂ to improve the ionic property.

In the sixth aspect of the present invention, the concept of the first aspect is applied in a case of using an inorganic substance such as silicic material as an underlying material.

Referring to the seventh aspect of the present invention, when an operation was conducted in accordance with the condition obtained in the foregoing method and finding a substance capable of satisfying the condition, it has been found that SiC (silicon carbide) is appropriate on a silicic material, particularly, a silicon substrate, based on which the present invention has been attained.

This invention can suitably be applied to a case of forming a stable resist pattern on a silicon substrate by using a KrF excimer layer. In this case, according to the invention, it is preferred to use SiC with n = 2.3 ± 0.2 and k = 0.65 ± 0.2 at a layer thickness of 25 nm ± 10 nm as an anti-reflective layer. Alternatively, it is possible to use SiO with n = 2.1 ± 0.2 and k = 0.7 ± 0.2 at a layer thickness of 30 ± 10 nm. SiO constituting the anti-reflective layer can be formed, for example, by CVD or thermal oxidation. SiC can be formed, for example, by sputtering or CVD. The anti-reflective layer can be etched by RIE using CF₄, CF₃, C₂F₆, C₃H₈, SF₆ or NF₃ series gas as an etchant and adding Ar and O₂ or Ar or O₂ to improve the ionic property.

Referring to other sorts of antireflective films investigated by the inventors, it has been found that a SiOₓ film, SiOₓN_{z} film or SᵢN_{y} film is appropriate on a metal material such as refractory metal silicide in accordance with the condition obtained by the method as described above.

This invention is applicable preferably to a case of forming a stable resist pattern on a W-Si film by using a KrF excimer laser. In this case, as the anti-reflective layer, it is possible to use SiOₓ with n = 2 4 ± 0.6and k = 0.7 ± 0.2 at a layer thickness of 30 ± 10 nm and further, SiOₓ can be formed by various kinds of CVD processes. Further, SiOₓ can be etched by RIE using CHF₃, C₄F₈, CHF₃ or S₂F₂ gas as an etchant and improving the ionic property.

Referring to the method, in which a SiₓO_{y}N_{z} film is used (cf. above) invention, it has been found that a SiOₓN_{y} film is suitable on the underlying metalic material such as Al and Al-alloys material.

Further, it has been found that a SiOₓN_{y} film or SiₓN_{y} film is appropriate on the silicon series underlying material.
Fig. 1 is a flow chart illustrating the constitution for the method of determining an optimum condition;
Fig. 2 is a view illustrating a standing wave effect;
Fig. 3 is a view illustrating a trace of fluctuation for the amount of absorbed dose in a resist film (an equi-contour line for the amount of photoresist absorption) in a case where nₐᵣ₁, kₐᵣ₁ are varied while fixing the thickness of the anti-reflective layer ARL, with respect to a certain resist film thickness;
Fig. 4 is a view illustrating a trace (equi-contour line) for other film thickness of the resist;
Fig. 5 is a view illustrating a trace (equi-contour line) for other film thickness of the resist;
Fig. 6 is a view illustrating a trace (equi-contour line) for other film thickness of the resist;
Fig. 7 is a view illustrating the standing wave effect to be solved;
Fig. 8 shows a trace of fluctuation for the amount of absorbed light in the resist film relative to variation of nₐᵣ₁, kₐᵣ₁, (equi-contour lines of photoresist absorption amount) for the resist film thickness of 985 nm in a case where the thickness of the anti-reflective layer is 30 nm;
Fig. 9 is a view illustrating a trace (equi-contour lines) for the resist film thickness of 1000 nm;
Fig. 10 is a view illustrating the trace (equi-contour lines) for the resist film thickness of 1017.5 nm;
Fig. 11 is a view illustrating the trace (equi-contour lines) for the resist film thickness of 1035 nm;
Fig. 12 is a view illustrating the standing wave effect at the optimum condition (Example 1);
Fig. 13 is a view illustrating the standing wave effect at the optimum condition (Example 1);
Fig. 14 is a view illustrating a relationship between the thickness of the anti-reflective layer and n as the optical condition;
Fig. 15 is a view illustrating a relationship between the thickness of the anti-reflective layer and k as the optical condition;
Fig. 16 is a n, k chart for finding the optimum anti-reflective layer material;
Fig. 17 is a view illustrating the anti-reflective effect of SiC (50 nm film thickness) on W-Si in comparison with the prior art;
Fig. 18 is a view for the explanation of a problem in the prior art, which shows the interference of light in the resist film;
Fig. 19 is a view for the explanation of a problem in the prior art, which shows the standing wave effect;
Fig. 20 is a view for the explanation of a problem in the prior art, which shows the standing wave effect;
Fig. 21 is a view for the explanation of a problem in the prior art, which shows the standing wave effect;
Fig. 22 is a view for the explanation of a problem in the prior art, which shows the effect of a step;
Fig. 23 is a view illustrating the effect of the standing wave effect;
Fig. 24 is a view illustrating the effect of the standing wave effect;
Fig. 25 is a view showing the effect of the standing wave effect;
Fig. 26 is a view illustrating a relationship between the fluctuation for the amount of absorbed light and the dimensional variation of the pattern;
Fig. 27 is a cross sectional view for a portion illustrating the structure of Example 7;
Fig. 28 is a cross sectional view for a portion illustrating the structure of Example 14;
Fig. 29 is a view illustrating the standing wave effect;
Fig. 30 shows a trace of fluctuation for the amount of absorbed light in the resist film relative to variation of nₐᵣ₁, kₐᵣ₁, (equi-contour lines of absorbed light amount) for the resist film thickness of 982 nm in a case where the thickness of the anti-reflective layer is 30 nm;
Fig. 31 is a view illustrating the trace (equi-contour lines) for the resist film thickness of 1000 nm;
Fig. 32 is a view illustrating the trace (equi-contour lines) for the resist film thickness of 1018 nm;
Fig. 33 is a view illustrating the trace (equi-contour lines) for the resist film thickness of 1035 nm;
Fig. 34 is a view illustrating the standing wave effect at the optimum condition;
Fig. 35 is a view illustrating the standing wave effect at the optimum condition;
Fig. 36 is a view illustrating a relationship between the film thickness and k as the optical condition of the anti-reflective film;
Fig. 37 is a view illustrating the dependence of n, k values of the SiC film on the film forming condition;
Fig. 38 is a view illustrating the anti-reflective effect of SiC (20 nm film thickness) on Al, Al-Si, Al-Si-Cu in comparison with a comparative case;
Fig. 39 is a view illustrating the anti-reflective effect of SiO (30 nm film thickness) on Al, Al-Si, Al-Si-Cu in comparison with the comparative case;
Fig. 40 is a cross sectional view for a portion illustrating the structure of Example 34;
Fig. 41 is a view illustrating the standing wave effect;
Fig. 42 is a view illustrating the anti-reflective effect of a SiC film (25 nm) on a silicon substrate in comparison with a comparative case;
Fig. 43 is a view illustrating the anti-reflective effect of a SiO film (30 nm) on a silicon substrate in comparison with a comparative case;
Fig. 44 is a cross sectional view illustrating the structure of Example 43;
Fig. 45 is a view illustrating the behavior of SiO film formation by CVD;
Fig. 46 is a view illustrating the anti-reflective effect of SiO (24 nm) on W-Si;
Fig. 47 is a cross sectional view illustrating the structure of Example 53;
Fig. 48 is a view illustrating the behavior in forming a SiₓO_{y}N_{z} film by CVD;
Fig. 49 is a view illustrating the anti-reflective effect of SiₓO_{y}N_{z} (25 nm) on W-Si;
Fig. 50 is a cross sectional view illustrating the structure of Example 65;
Fig. 51 is a view illustrating the optical constant property of SiₓO_{y}N_{z} or SiₓN_{y};
Fig. 52 is a view illustrating the standing wave effect at the optimum condition in Example 65;
Fig. 53 is a cross sectional view showing the structure of Example 77;
Fig. 54 is a view illustrating the anti-reflective effect of a SiₓO_{y}N_{z} film or SiₓN_{y} film (32 nm) on Si;
Fig. 55 is a view illustrating the anti-reflective effect of a SiₓO_{y}N_{z} film or SiₓN_{y} film (100 nm) on Si;
Fig. 56 is a view illustrating the optical constant property of SiₓO_{y}N_{z} or SiₓN_{y}; and
Fig. 57 is a view illustrating the anti-reflective effect of the SiₓO_{y}N_{z} film or SiₓN_{y} film (33 nm) on the Si series material.
Fig. 58 is a view illustrating Example, which shows relationship between current ratio SiH₄/N₂O and n, k value of the formed film of SiOxNy.
Fig. 59 is a view illustrating Example 90, which shows relationship between current ratio SiH₄/N₂O and element ratio of Si.O.N.H(RBS value) of the formed film of SiOxNy.
Fig. 60 is a view illustrating IR spectrum of film formed in Example 90.
Fig. 61 is a view illustrating ordinarily used current ratio of SiH₄/N₂O for forming SiOxNy film.
Fig. 62 is a view illustrating the anti-reflective effect of the film formed in Example 90.
Fig. 63 is a view illustrating the anti-reflective effect of the film formed in Example 90.
Fig. 64 is a view illustrating the anti-reflective effect of the film formed in Example 90.
Fig. 65 is a view illustrating the anti-reflective effect of the film formed in Example 90.
Fig. 66 is a view illustrating the anti-reflective effect of the film formed in Example 90.
Fig. 67 is a view illustrating the operation of Example 90.
Fig. 68 is a view illustrating the operation of Example 90.

### EXAMPLES

Description will now be made specifically to examples of the present invention and additional illustrative examples. However, the present invention is not limited by the following examples.

### EMBODIMENT 1

### Example 1

In this example, the present invention is applied to determination of conditions to be satisfied by an anti-reflective layer (layer thickness, optical constant) for forming a stable pattern on a W-Si film by using KrF excimer lithography. This example is practiced in accordance with the following steps (1) - (6).

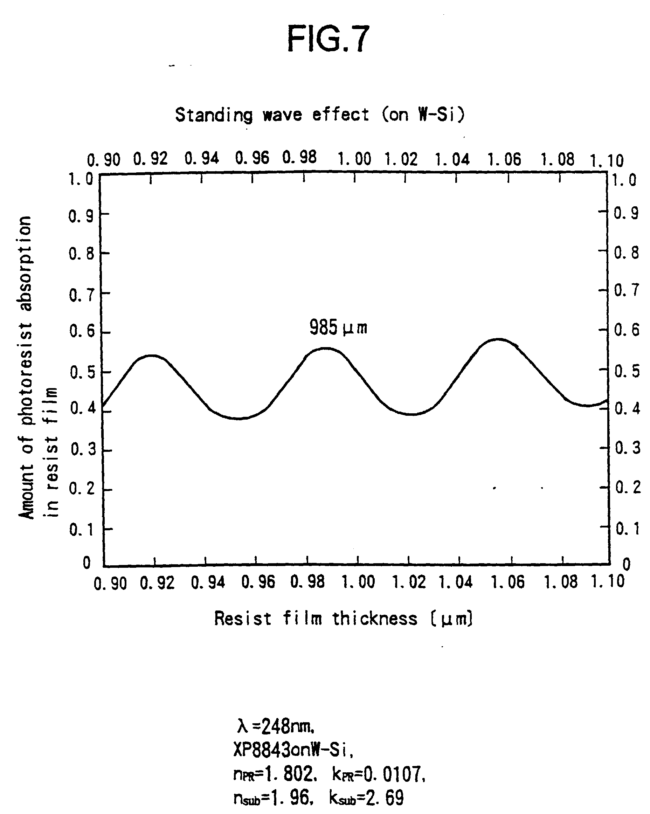

(1) Fig. 7 shows a standing wave effect when XP 8843 resist (Shipley Microelectronics Co.) was coated on a W-Si film without an anti-reflective layer and exposed by an KrF excimer laser beam at a wave length of 248 nm, followed by development. From Fig. 7, the standing wave effect was about ±20%.

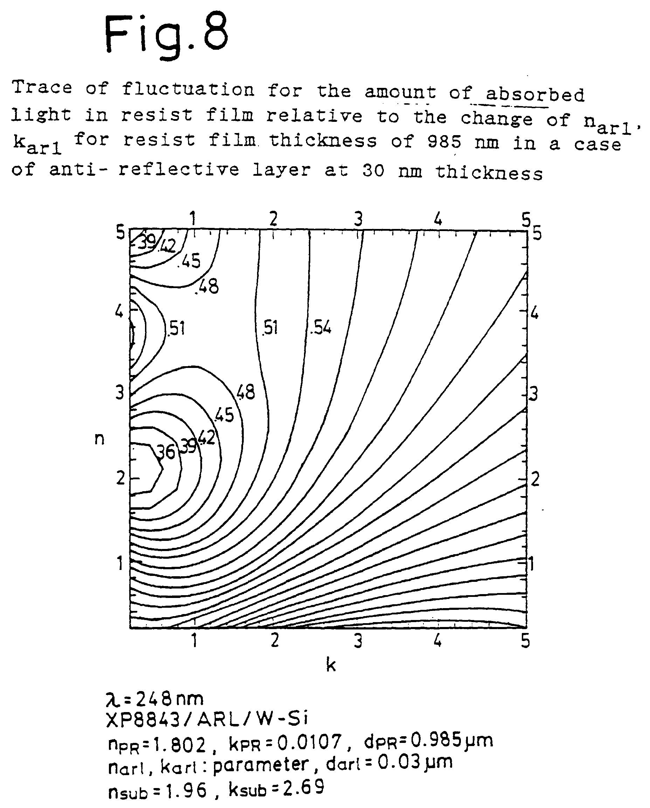

(2) In Fig. 7, the maximum value of the standing wave effect is at a resist film thickness, for example, of 985 nm. Fig. 8 shows the fluctuation for the amount of photoresist absorption in the resist film relative to the change of optical constants nₐᵣ₁ and kₐᵣ₁ of the anti-reflective layer (equi-contour lines for the amount of photoresist absorption), taking notice on the resist film thickness of 985 nm and setting the layer thickness of the anti-reflective layer at 30 nm.

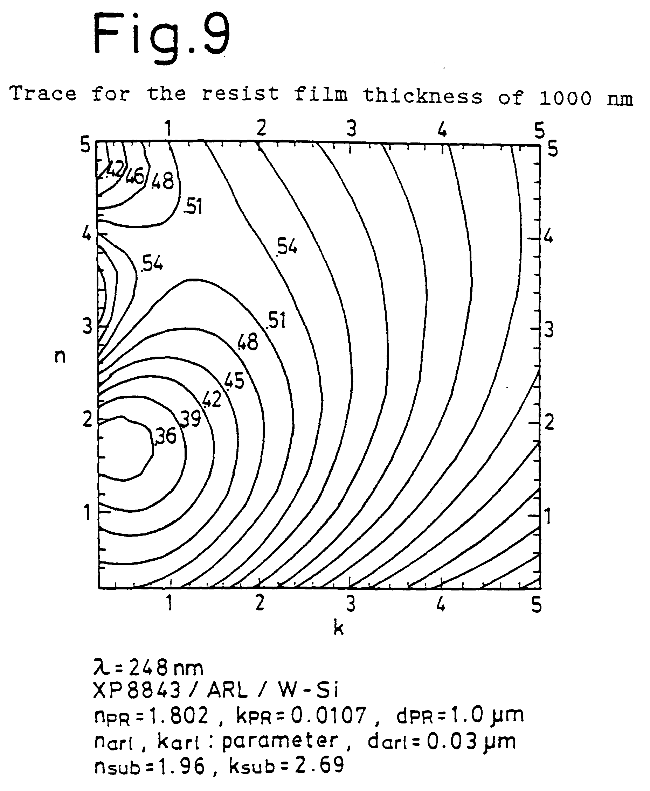

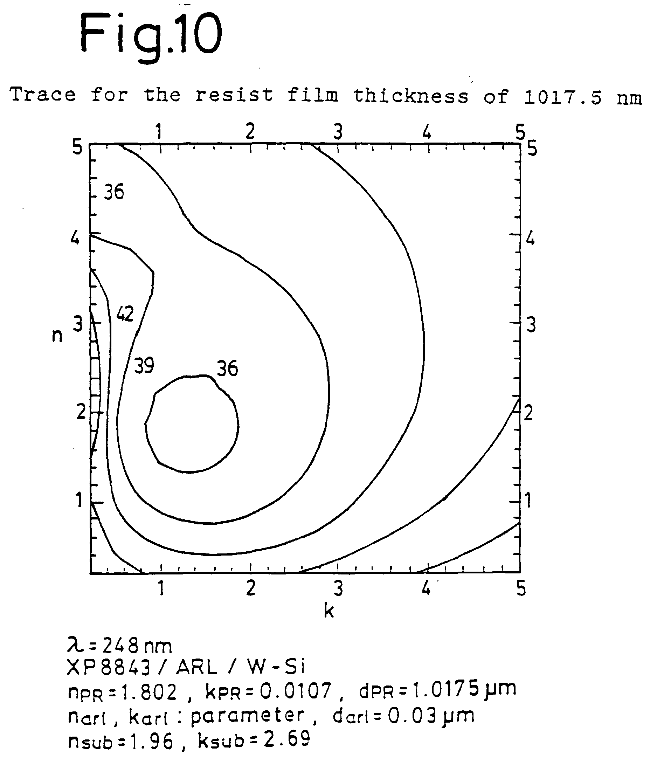

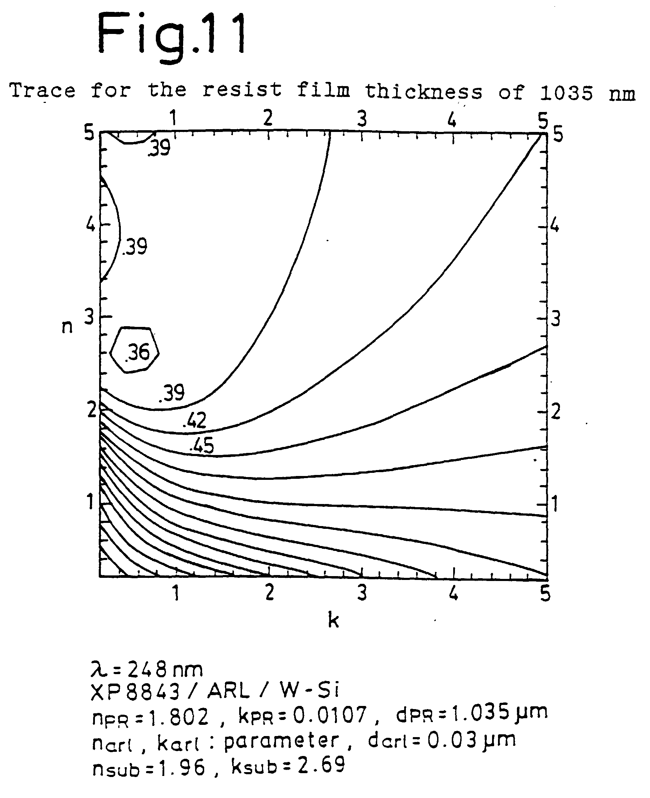

(3) Figs. 9, 10 and 11 show the results of repeating the procedures (2) above to each of the resist film thicknesses of 1,000 nm, 1,017.5 nm and 1,035 nm, respectively. (4) As a result of determining a common region of Figs. 8 - 11,
   nₐᵣ₁ = 4.9, kₐᵣ₁ = 0.1, or
   nₐᵣ₁ = 2.15, kₐᵣ₁ = 0.67
   were obtained.
   That is, the condition to be satisfied by the optimum anti-reflective layer with the thickness of the anti-reflective layer being set as 30 nm is:
   nₐᵣ₁ = 4.9, k = 0.1, or
   nₐᵣ₁ = 2.15, kₐᵣ₁ = 0.67

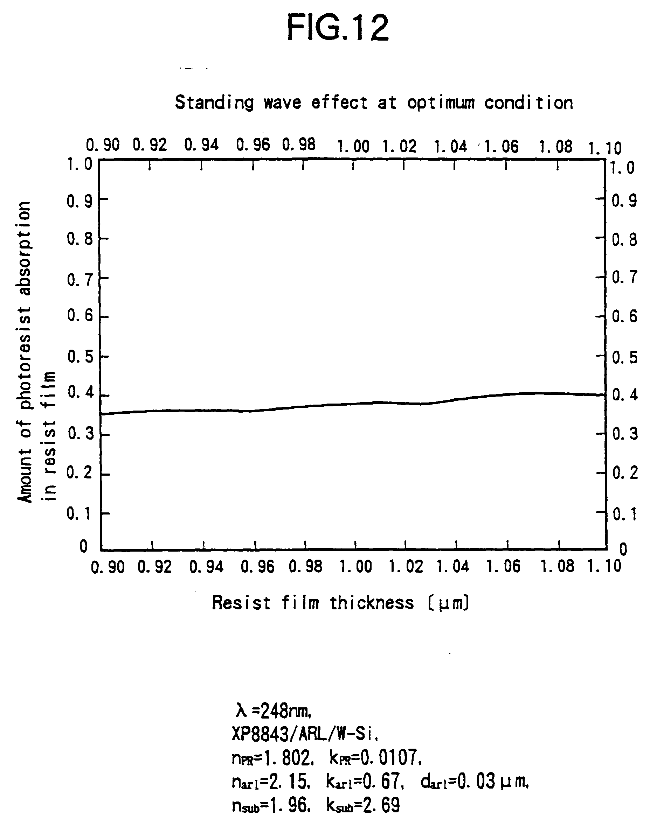

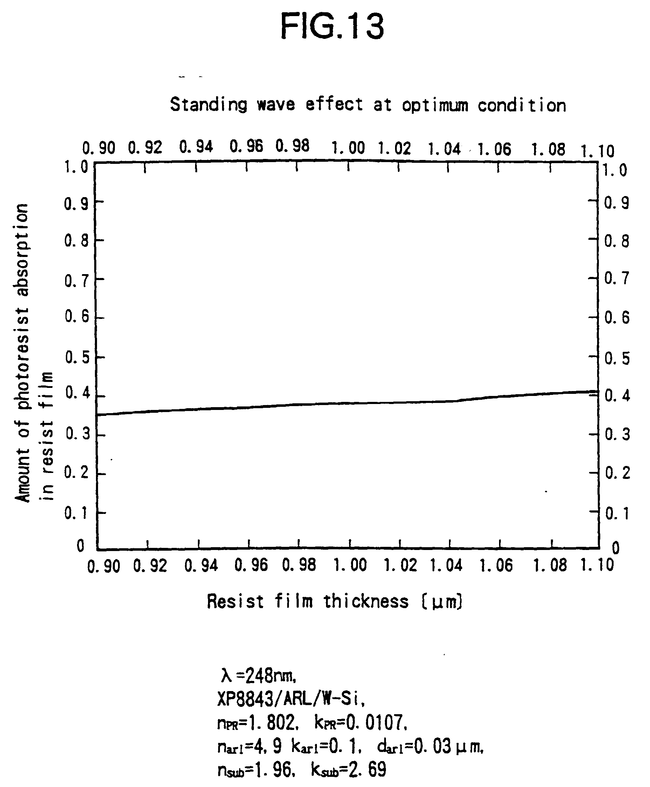

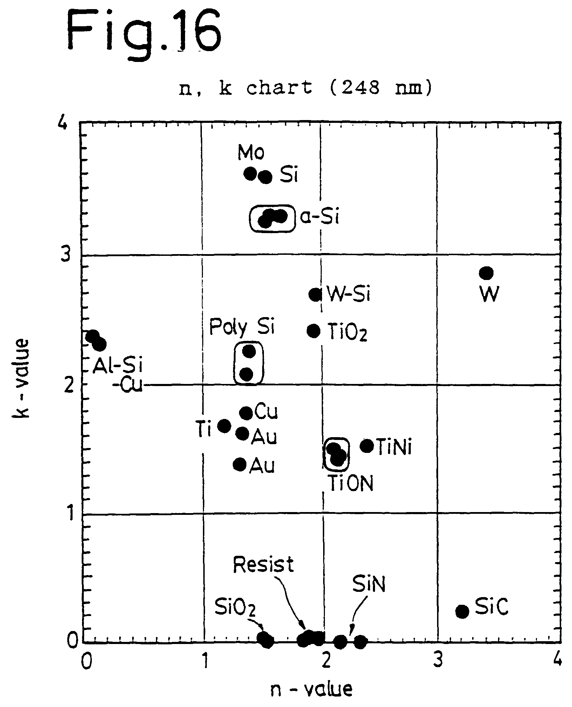

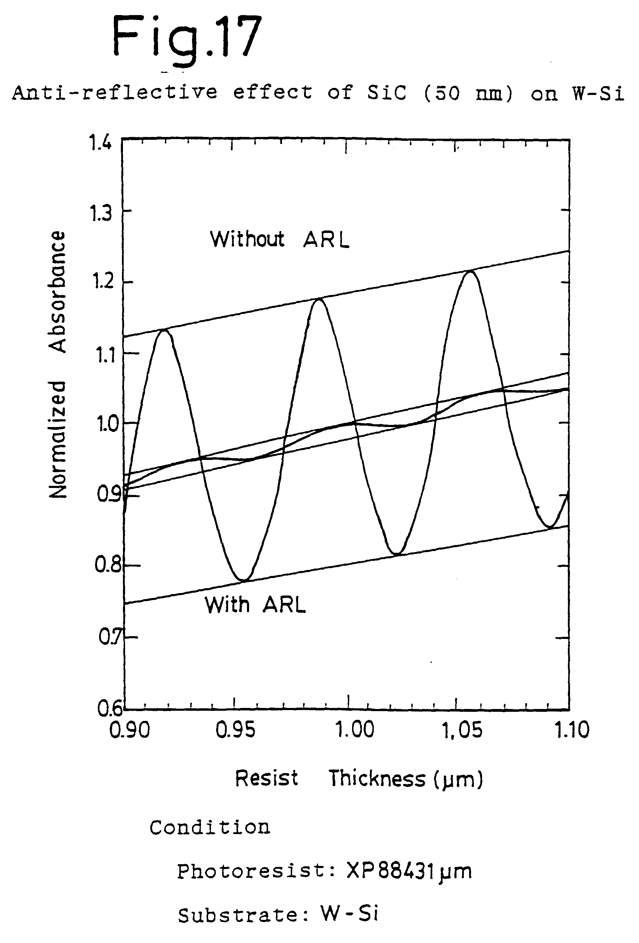

   When the standing wave effect was determined by using the above-mentioned condition, the results shown in Figs. 12 and 13 were obtained. In Figs. 12 and 13, the standing wave effect was extremely small and it was about ±1% in each of the cases. The standing wave effect was reduced to about 1/20 as compared with the case of not using the anti-reflective layer.
(5) The procedures (2) - (4) described above were conducted in a case of setting the thickness of the anti-reflective layer as 30 nm. When the procedures (2) - (4) were repeated also for other different layer thicknesses of anti-reflective layers (ARL thickness), an optimum condition for the anti-reflective layer in accordance with the thickness of the anti-reflective layer can be determined. Figs. 14 and 15 show the obtained results.
(6) It was investigated as to whether the film species capable of satisfying the condition to be met by the anti-reflective layer determined in (5) above is present or not, by using a spectroscopic ellipsometer ("MOSS System" manufactured by SOPRA Co. ) and "Handbook of Optical Constants of Solids" (E.D. Palik, Academy press, 1985). As a result, a n,k chart shown in Fig. 16 was obtained. Substances having corresponding n, k are shown on the chart. From Fig. 16, it has been found that SiC (silicon carbide) at 50 nm can completely satisfy the conditions in Figs. 14 and 15. Fig. 17 shows the standing wave effect in the case of using SiC at 50 nm thickness as an anti-reflective layer on W-Si and in a case of not using the anti-reflective layer. In a case of using SiC at 50 nm as the anti-reflective layer (graph for "with ARL" in the figure), the standing wave effect was ± 1%, which was reduced to about 1/20 as compared with the case of not using the anti-reflective layer (graph for "without ARL" in the figure).

### Example 2

In this example, anti-reflective layer was formed by forming a SiC film with n = 3.16 ± 0.2 and k = 0.24 ± 0.1 shown in Example 1 by the following method.

That is, in this example, a film was formed by utilizing a thermal CVD process at a temperature of 100°C to 1500° and under a pressure of 0.01 to 10,000 Pa by using the following gas as the starting material gas:
SiCl₄ + C₃H₈ + H₂,
SiHCl₃ + C₃H₈ + H₂,
SiH₄ + C₃H₈ + H₂,
SiH₄ + C₂H₄ + H₂,
SiH₄ + C₃H₈ + H₂,
SiCl₃ + CH₃ + H₂,
SiH₄ + C₃H₈ + H₂ or
SiH₄ + C₃H₈ + H₂.
Thus, SiC film having an aimed anti-reflective effect could be obtained.

### Example 3

In this Example, a SiC film was formed as below to obtain an anti-reflective layer.

That is in this example, a film was formed by utilizing a plasma CVD process and using a photochemical reaction from a gas mixture comprising: Si₂H₆ + Si(CH₃) H₃+ C₂H₂.

### Example 4

In this example, a SiC film was formed as below to obtain an anti-reflective layer.

A film was formed by utilizing an ECR plasma process and using a microwave (2.45 GHz) from a gas mixture comprising: SiH₄ + CH₄ + H₂.

### Example 5

In this example, a SiC film was formed as below to obtain an anti-reflective layer. That is, a film was formed by utilizing a sputtering method using SiC as a target.

### Example 6

In this example, an anti-reflective layer was formed by patterning a SiC film by etching.

In this case, the SiC film was etched by a reactive ion etching process using a CF₄, CHF₃, C₂F₆, C₃F₈, SF₆ or NF₃ series gas as an etchant and adding Ar to improve the ionic property, thereby obtaining an anti-reflective layer of a desired pattern.

### EMBODIMENT 2

### Example 7

In this example, the present invention was applied by using SiC as an anti-reflective layer for forming a stable pattern on a W-Si film using KrF excimer lithography.

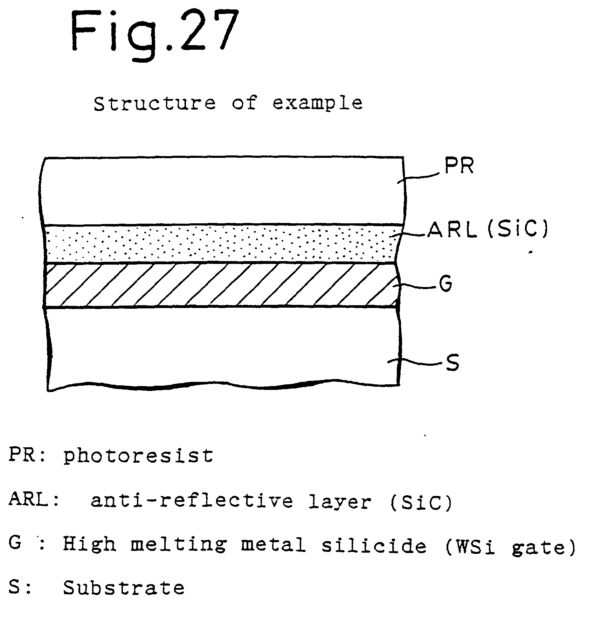

In the method of forming a resist pattern in this example, as shown in Fig. 27, an anti-reflective layer ARL was formed with silicon carbide on a W-Si underlying material which was a refractory metal silicide and a photoresist PR was formed on the anti-reflective layer ARL, thereby forming a resist pattern.

In this example, the present invention is applied by using SiC as the anti-reflective layer ARC, particularly, in a case of forming a material layer with W-Si as a gate, on a substrate 1 such as a Si semiconductor substrate and patterning the same by a photolithographic step using a photoresist PR and an etching step, thereby obtaining a gate structure.

At first, description will be made to procedures for selecting SiC as the anti-reflective layer to be used on W-Si and a method of determining a condition to be satisfied by SiC. The following procedures (1) - (6) were conducted.
(1) XP 8843 resist (Shipley Microelectronics Co.) was coated on a W-Si film without an anti-reflective layer, which was exposed by an KrF excimer laser beam at a wave length of 248 nm, followed by development. Fig. 7 shows a standing wave effect in this case. From Fig. 7, the standing wave effect was about ±20%.
(2) In Fig. 7, the maximum value of the standing wave effect is at a resist film thickness, for example, of 985 nm. Fig. 8 shows fluctuation for the amount of photoresist absorption in the resist film relative to the change of optical constants nₐᵣ₁ and kₐᵣ₁ of the anti-reflective layer, taking notice on the resist film thickness of 985 nm and setting the layer thickness of the anti-reflective layer to 30 nm.
(3) Figs. 9, 10 and 11 show the results of repeating the procedures (2) above to each of the resist film thicknesses of 1,000 nm, 1,017.5 nm and 1,035 nm, respectively. (4) As a result of determining a common region in Figs. 8 - 11,
   nₐᵣ₁ = 4.9, kₐᵣ₁ = 0.1, or
   nₐᵣ₁ = 2.15, kₐᵣ₁ = 0.67
   were obtained.
   That is, the condition to be satisfied by the optimum anti-reflective layer with the thickness of the anti-reflective layer being set as 30 nm is:
   nₐᵣ₁ = 4.9, kₐᵣ₁ = 0.1, or
   nₐᵣ₁ = 2.15, kₐᵣ₁ = 0.67.

   When the standing wave effect was determined by using the above-mentioned condition, the results shown in Figs. 12 and 13 were obtained. In Figs. 12 and 13, the standing wave effect was extremely small and it was about ±1% in each of the cases. The standing wave effect was reduced to about 1/20 as compared with the case of not using the anti-reflective layer.
(5) The procedures (2) - (4) described above were conducted in a case of setting the thickness of the anti-reflective layer as 30 nm. When the procedures (2) - (4) were repeated also for other different layer thicknesses of anti-reflective layer (ARL thickness), an optimum condition for the anti-reflective layer in accordance with the thickness of the anti-reflective layer could be determined. Figs. 14 and 15 show the obtained results.
(6) It was investigated as to whether the film species capable of satisfying the condition to be met by the anti-reflective layer determined in (5) above is present or not by using a spectroscopic ellipsometer ("MOSS System" manufactured by SOPRA Co.) and "Handbook of Optical Constants of Solids" (E.D. Palik, Academy press, 1985). As a result, a n,k chart shown in Fig. 16 was obtained. Substances having corresponding n, k are shown on the chart. From Fig. 16, it has been found that SiC (silicon carbide) at 50 nm can completely satisfy the conditions in Figs. 14 and 15. Fig. 17 shows the standing wave effect in a case of using SiC at 50 nm thickness as the anti-reflective layer on W-Si and in a case of not using the anti-reflective layer. In a case of using SiC at 50 nm as the anti-reflective layer (graph for "with ARL" in the figure), the standing wave effect was ±1%, which was reduced to about 1/20 as compared with the case of not using the anti-reflective layer (graph for "without ARL" in the figure).

### Example 8

In this example, an anti-reflective layer was formed by forming a SiC film with n = 3.16 ± 0.2 and k = 0.24 ± 0.1 shown in Example 1 by the following methods.

That is, in this example, a film was formed by utilizing a thermal CVD process at a temperature of 100°C to 1500° and under a pressure of 0.01 to 10,000 Pa by using the following gas as the starting material.
SiCl₄ + C₃H₈ + H₂,
SiHCl₃ + C₃H₈ + H₂,
SiH₄ + C₃H₈ + H₂,
SiH₄ + C₂H₄ + H₂,
SiH₄ + C₃H₈ + H₂,
SiCl₃ + CH₃ + H₂,
SiH₄ + C₃H₈ + H₂ or
SiH₄ + C₃H₈ + H₂.
Thus, a SiC films having aimed anti-reflective effect could be obtained.

### Example 9

In this Example, a SiC film was formed as below to obtain an anti-reflective layer.

That is, in this example, a film was formed by utilizing a plasma CVD process and using a photochemical reaction for a gas mixture comprising: Si₂H₆ + Si(CH₃) H₃+ C₂H₂.

### Example 10

In this example, a SiC film was formed as blow to obtain an anti-reflective layer.

A film was formed by utilizing an ECR plasma process and using a microwave (2.45 GHz) from a gas mixture comprising: SiH₄ + CH₄ + H₂.

### Example 11

In this example, a film was formed by utilizing an ECR plasma CVD process from SiH₄ + C₂H₄ gas by a plasma process using a microwave at 2.45 GHz.

### Example 12

A SiC film was formed as below to obtain an anti-reflective layer.

A film was formed by a sputtering method using SiC as a target.

### Example 13

In this Example, an anti-reflective layer was formed by patterning a SiC film by etching.

In this case, the SiC film was etched by a reactive ion etching process using CF₄, CHF₃, C₂F₆, C₃F₈, SF₆ or NF₃ series gas (or a mixed gas system) as an etchant and adding Ar to improve the ionic property, thereby obtaining an anti-reflective layer of a desired pattern.

### EMBODIMENT 3

### Example 14

In this example, the present invention was applied by using SiC as the anti-reflective layer for forming a stable pattern on an Al, Al-Si or Al-Si-Cu film as the Al series material using KrF excimer lithography.

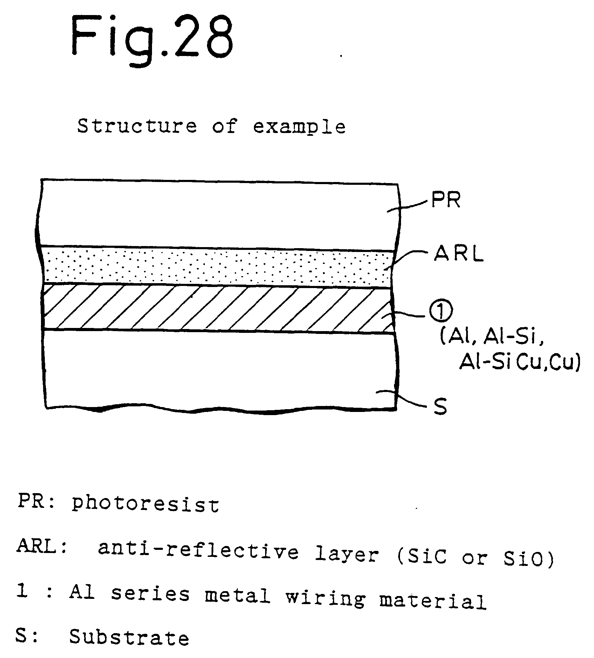

As shown in Fig. 28, in the method of forming the resist pattern in this example, an anti-reflective layer ARL was formed with silicon carbide on Al, Al-Si or Al-Si-Cu as an Al or Al-alloys metalic wiring material (1) and forming a photoresist PR on the anti-reflective layer ARL thereby forming a resist pattern.

In this example, the present invention was applied, particularly, in a case of obtaining a wiring structure by forming a material layer as wiring with Al, Al-Si or Al-Si-Cu on a substrate S such as a Si semiconductor substrate, and patterning the same by a photolithographic step using the photoresist PR and an etching step, in which SiC was used as the anti-reflective layer ARC. As Al-Si, there can be preferably used, in addition to a generally used Al-Si alloy containing 1 wt% Si generally used, an alloy with lower or higher Si content. This example is preferably applicable to Al-Si-Cu in which Si is about 1 wt% and Cu is about 0.1 to 2 wt%, with no particular restriction only thereto. Typically, Al-Si-Cu alloy of 1 wt% Si, 0.5 wt% Cu is used.

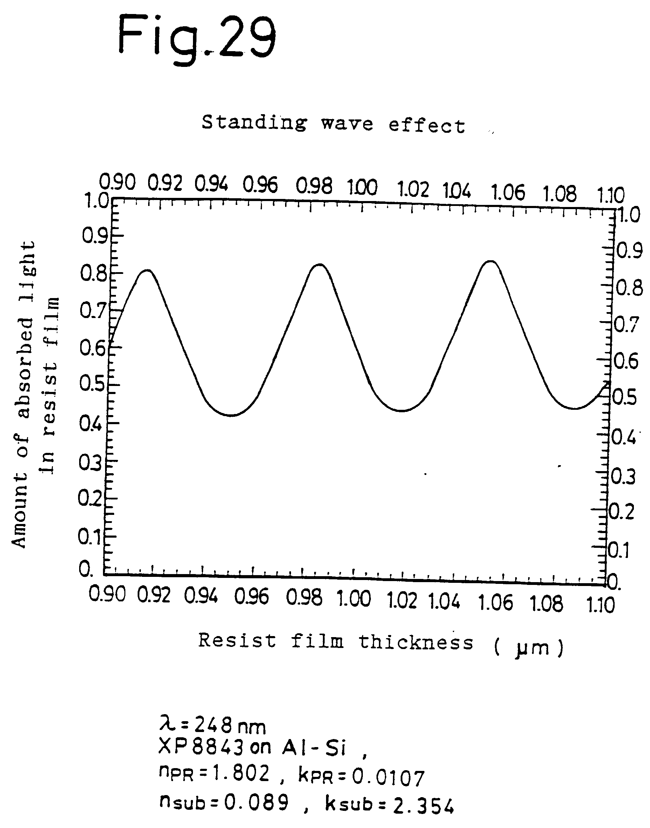

At first, description will be made to procedures for selecting SiC as an anti-reflective layer used on Al, Al-Si or Al-Si-Cu as the Al or Al-alloys, as well as a method of determining the condition to be satisfied by SiC. The following procedures (1) - (6) were conducted.
(1) XP 8843 resist (manufactured by Shipley Microelectronics Co.) was coated on an Al, Al-Si or Al-Si-Cu film without an anti-reflective layer and exposed by a KrF excimer laser beam at a wave length of 248 nm, followed by development. Fig. 29 shows the standing wave effect in this case. As shown in Fig. 29, the standing wave effect was about ± 29.6%.

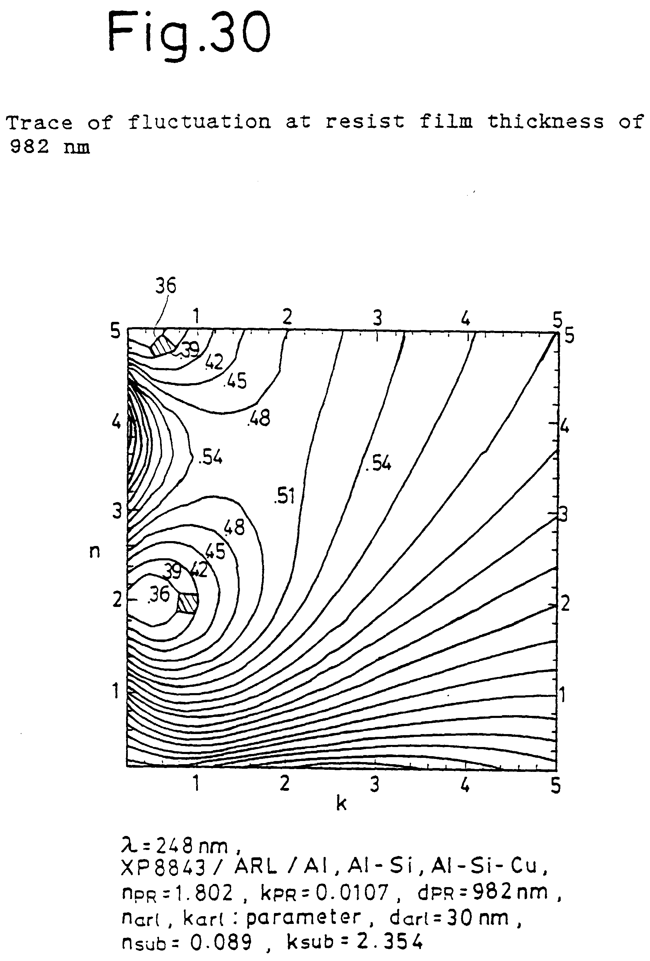

(2) In Fig. 29, the maximum value of the standing wave effect situates, for example, at 982 nm of the resist film thickness. Fig. 30 shows fluctuation for the amount of photoresist absorption in the resist film relative to the change of optical constants nₐᵣ₁, kₐᵣ₁ of the anti-reflective layer, (equi-contour lines for the amount of absorbed light) 30, taking notice on the resist film at a thickness of 982 nm, and setting the thickness of the anti-reflective layer to 30 nm.

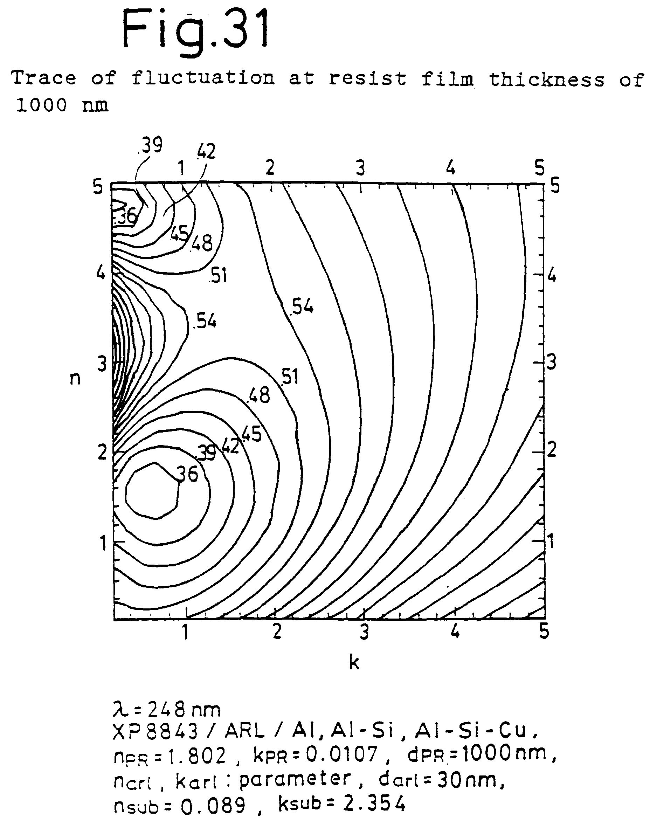

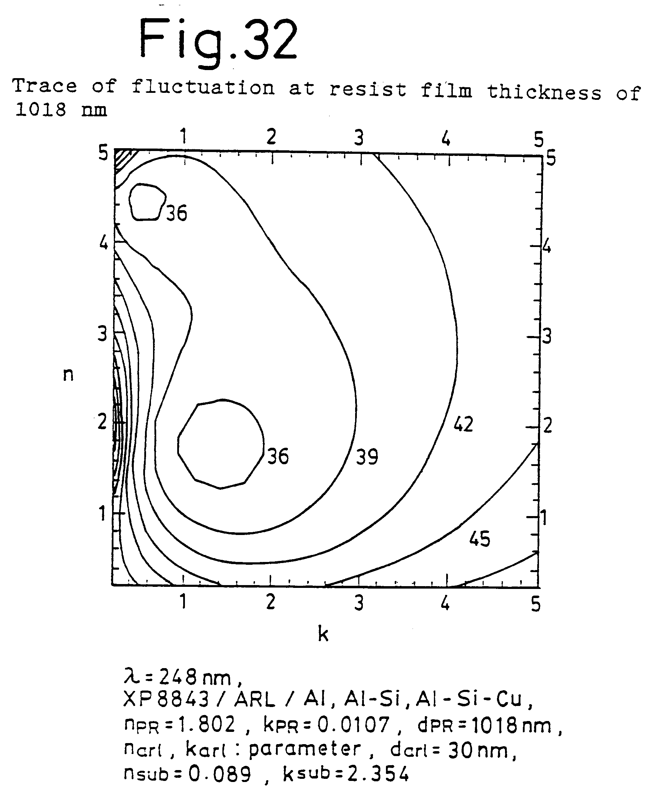

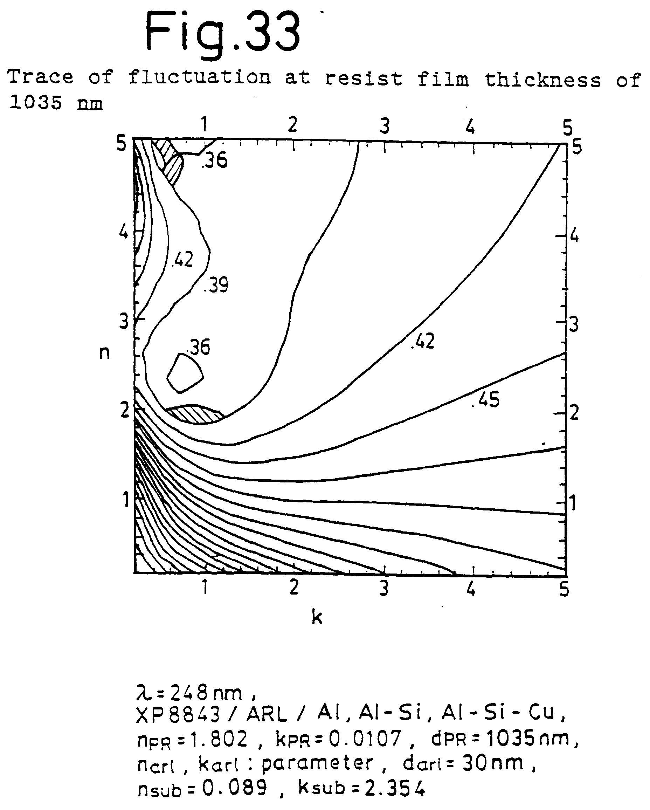

(3) Figs. 31, 32 and 33 show results of repeating the procedure (2) described above to the resist film thicknesses of 1,000 nm, 1,018 nm and 1,035 nm, respectively.
(4) As a result of determining a common region in Fig. 30 to Fig. 33,
   nₐᵣ₁ = 4.8, kₐᵣ₁ = 0.45 or
   nₐᵣ₁ = 2.0, kₐᵣ₁ = 0.8
   was obtained.
   That is, the condition to be satisfied by the optimum anti-reflective layer upon setting the thickness of the anti-reflective layer as 30 nm was:
   nₐᵣ₁ = 4.8, kₐᵣ₁ = 0.45 or
   nₐᵣ₁ = 2.0, kₐᵣ₁ = 0.8.

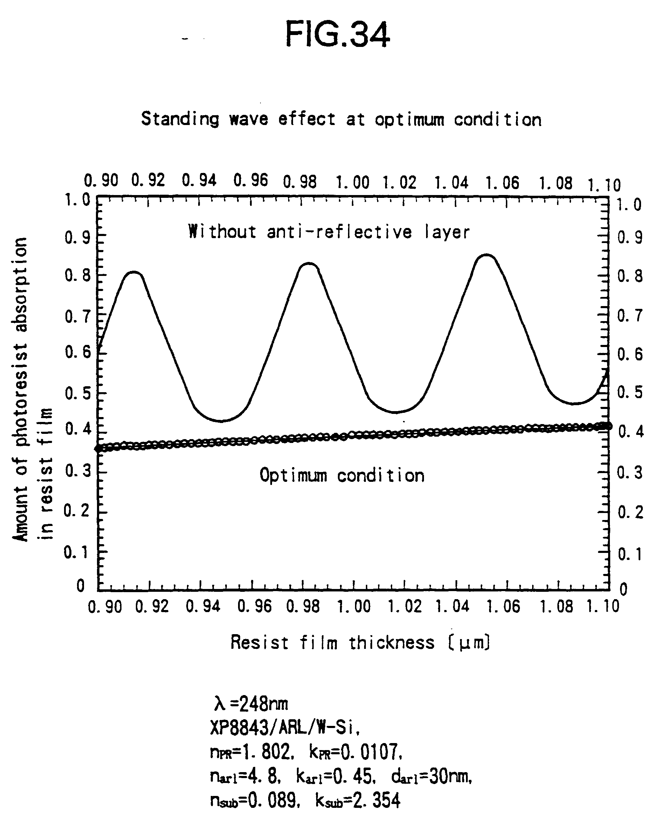

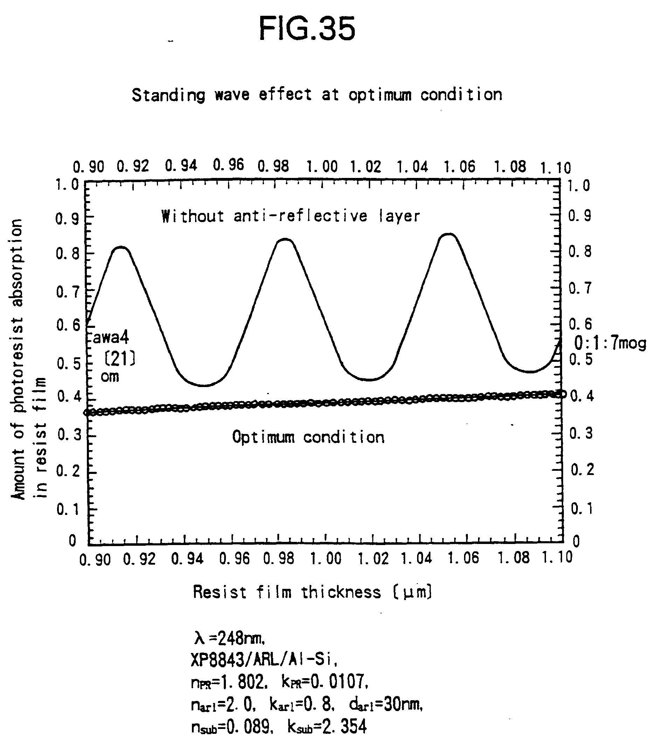

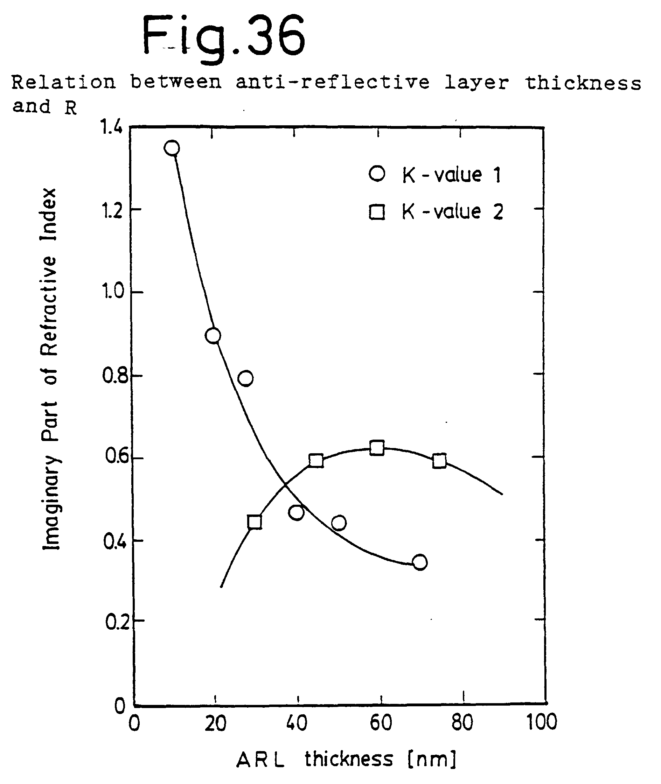

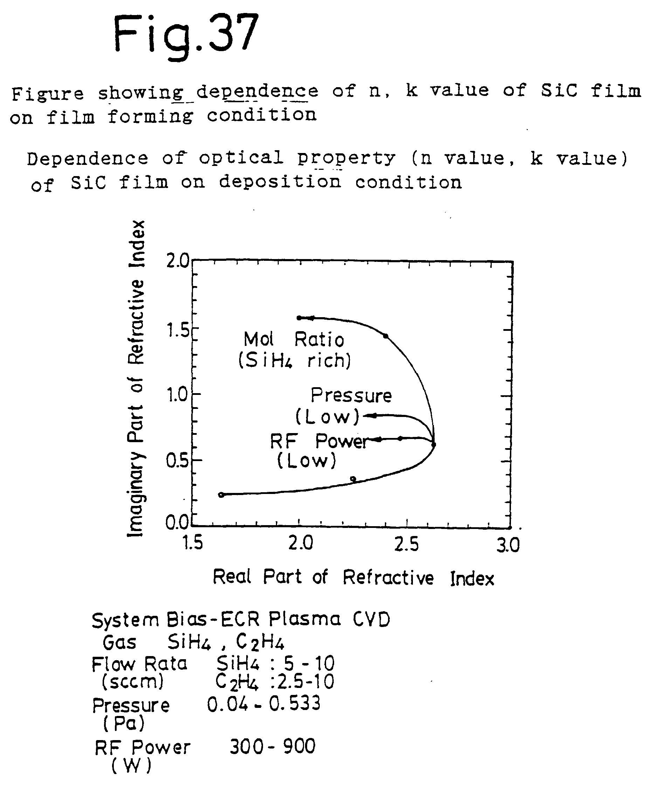

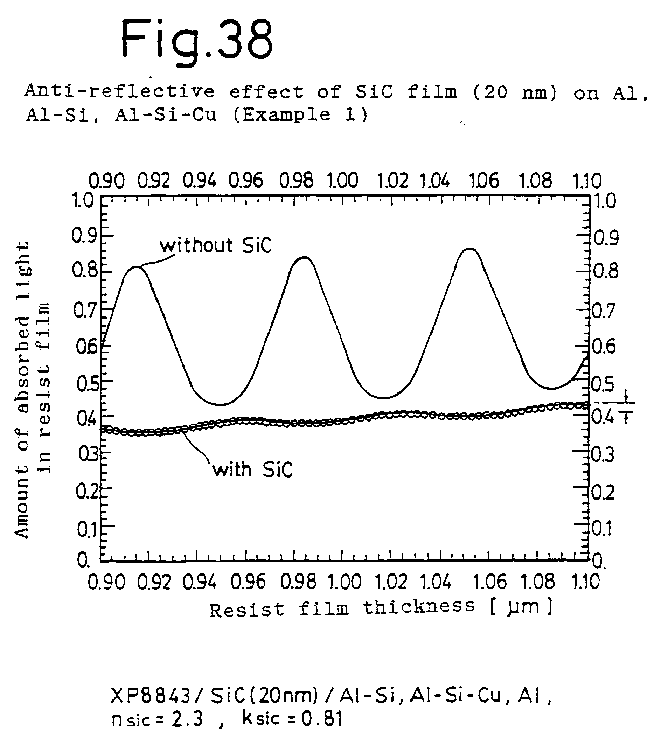

   When the standing wave effect was determined by using this condition, results shown by "optimum condition" in Fig. 34 and Fig. 35 were obtained. As apparent from the comparison with "without anti-reflective layer" in Figs. 34 and 35, the standing wave effect was extremely small, which was about less than ±1% in each of the cases. As compared with the case without anti-reflective layer, the standing wave effect was reduced to about 1/30.
(5) The procedures (2) - (4) above are for the case of setting the thickness of the anti-reflective layer to 30 nm. When the procedures (2) - (4) were repeated also to the anti-reflective layers of different thicknesses (ARL thickness), the optimum condition for the anti-reflective layer depending on the thickness of the anti-reflective layer was determined. Figs. 14 and 36 show the thus obtained results are shown.
(6) It was investigated as to whether the film species capable of satisfying the condition to be met by the anti-reflective layer obtained in (5) described above are present or not, by using a spectroscopic ellipsometer ("Moss System", manufactured by SOPRA Co.) and "Handbook of Optical Contacts of Solids" (E.D. Palik, Academy press, 1985). As a result, a n, k chart was obtained as shown in Fig. 16. Substances having corresponding n, k are shown on the chart. From Fig. 16, it has been found that SiC (silicon carbide) at 20 nm can completely satisfy the conditions in Fig. 14 and 36. Fig. 38 shows the standing wave effect in a case of using or not using SiC at 20 nm as an anti-reflective layer on Al, Al-Si or Al-Si-Cu. The standing wave effect in a case of using SiC at 20 nm as the anti-reflective layer (graph for "with ARL" in Fig. 38) was ±2.2 (1.4%) and the standing wave effect was reduced to about 1/15 compared with the case of not using the anti-reflective layer (graph for "without ARL" in the figure). Fig. 37 shows the dependence of n, k values of the SiC film on the film forming condition.

### Example 15

In this example, an anti-reflective layer as shown in Fig. 28 was formed by forming a SiC film with n = 2.3 ± 0.2 and k = 0.8 ± 0.2 shown in Example 1 by the following method.

That is, in this example, a film was formed by utilizing a thermal CVD process at a temperature of 100°C to 1500° and usually under a pressure, preferably, 0.01 to 10.000 Pa, more preferably, 100 to 10,000 Pa by using the following gas as the starting material gas:
SiCl₄ + C₃H₈ + H₂,
SiHCl₃ + C₃H₈ + H₂,
SiH₄ + C₃H₈ + H₂,
SiH₄ + C₂H₄ + H₂,
SiH₄ + C₃H₈ + H₂,
SiCl₃ + CH₃ + H₂,
SiH₄ + C₃H₈ + H₂ or
SiH₄ + C₃H₈ + H₂.
Thus, a SiC film having an aimed anti-reflective effect could be obtained.

### Example 16

In this Example, a SiC film was formed as below to obtain an anti-reflective layer. That is, in this example, a film was formed by utilizing a plasma CVD process and using a photochemical reaction in a gas mixture comprising: Si₂H₆ + Si(CH₃) H₃ + C₂H₂.

### Example 17

In this example, a SiC film was formed as below to obtain an anti-reflective layer.

A film was formed by an ECR plasma process by utilizing an ECR plasma CVD process using a microwave (at 2.45 GHz) from a gas mixture comprising: SiH₄ + CH₄ + H₂, SiH₄ + C₂H₄ + H₂ or SiH₄ + CH₄ + H₂.

### Example 18

In this example, an SiC film was formed as below to obtain an anti-reflective layer, That is, a film was formed by utilizing a sputtering method using SiC as a target.

### Example 19

In this example, an anti-reflective layer was formed by patterning a SiC film by etching.

In this case, the SiC film was etched by a reactive ion etching process using a CF₄, CHF₃, C₂F₆, C₃F₈, SF₆ or NF₃ gas as an etchant and adding Ar to improve the ionic property, thereby obtaining an anti-reflective layer of a desired pattern.

### EMBODIMENT 4 (for illustrative purposes)

### Example 20

In this example, the present invention was applied by using SiO as an anti-reflective layer for forming a stable pattern on an Al, Al-Si or Al-Si-Cu film using KrF excimer lithography.

In the method of forming a resist pattern in this example, as shown in Fig. 28, an anti-reflective layer ARL was formed with silicon oxide SiO on an Al, Al-Si or Al-Si-Cu as the Al or Al-alloys metal wiring material and a photoresist PR was formed on the anti-reflective layer ARL, thereby forming the resist pattern.

In this example, the present invention was applied by using SiO as the anti-reflective layer ARL, particularly, in a case of forming a material layer as wiring with Al, Al-Si or Al-Si-Cu on a substrate S such as a Si semiconductor substrate and patterning the same by a photolithographic step using a photoresist PR and an etching step, thereby obtaining a gate structure.

At first, description will be made to procedures for selecting SiO as the anti-reflective layer to be used on Al, Al-Si or Al-Si-Cu as the Al or Al-alloys material and a method of determining a condition to be satisfied by SiO. The following procedures (1) - (6) were conducted in the same manner as in Example 14.
(1) XP 8843 resist (Shipley Microelectronics Co.) was coated on an Al, Al-Si or Al-Si-Cu film without an anti-reflective layer and exposed by an KrF excimer laser beam at a wave length of 248 nm, followed by development. Fig. 29 shows a standing wave effect in this case. From Fig. 29, the standing wave effect was about ±29.6%.
(2) In Fig. 29, the maximum value of the standing wave effect is at a resist film thickness, for example, of 982 nm. Fig. 30 shows fluctuation for the amount of absorbed dose in the resist film relative to the change of optical constants nₐᵣ₁ and kₐᵣ₁ of the anti-reflective layer, taking notice on the resist film thickness of 982 nm and setting the layer thickness of the anti-reflective layer to 30 nm.
(3) Figs. 31, 32 and 33 show the results of repeating the procedures (2) above to each of the resist film thicknesses of 1,000 nm, 1,018 nm and 1,035 nm, respectively.
(4) As a result of determining a common region in Figs. 30 to 33,
   nₐᵣ₁ = 4.8, kₐᵣ₁ = 0.45, or
   nₐᵣ₁ = 2.0, kₐᵣ₁ = 0.8
   were obtained.
   That is, the condition to be satisfied by the optimum anti-reflective layer with the thickness of the anti-reflective layer being set as 30 nm is:
   nₐᵣ₁ = 4.8, kₐᵣ₁ = 0.45, or
   nₐᵣ₁ = 2.0, kₐᵣ₁ = 0.8.

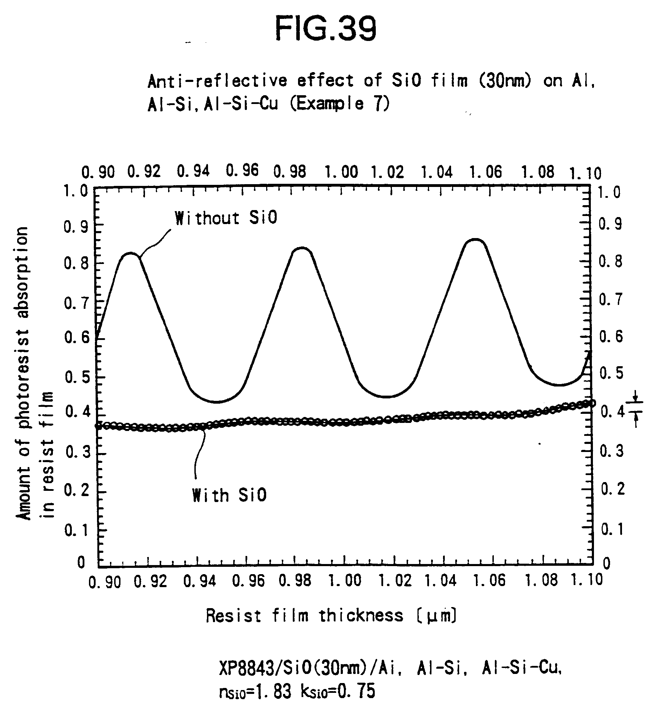

   When the standing wave effect was determined by using the above-mentioned condition, the results shown in Fig. 34 and Fig. 35 as described in Example 14 were obtained. In Fig. 34 and Fig. 35, the standing wave effect was extremely small and it was about less than ±1% in each of the cases. The standing wave effect was reduced to about 1/30 as compared with the case of not using the anti-reflective layer.
(5) The procedures (2) - (4) described above were conducted in a case of setting the thickness of the anti-reflective layer as 30 nm. When the procedures (2) - (4) were repeated also for anti-reflective layer (ARL thickness) of other different layer thicknesses, an optimum condition for the anti-reflective layer in accordance with the thickness of the anti-reflective layer could be determined. Fig. 14 and Fig. 36 show the obtained results.
(6) It was investigated as to whether the film species capable of satisfying the condition to be met by the anti-reflective layer determined in (5) above are present or not by using a spectroscopic ellipsometer ("MOSS System" manufactured by SOPRA Co.) and "Handbook of Optical Constants of Solids" (E.D. Palik, Academy press, 1985). As a result, a n,k chart shown in Fig. 16 was obtained. Substances having corresponding n, k are shown on the chart. From Fig. 16, it has been found that SiO (silicon oxide) at 30 nm can completely satisfy the conditions in Fig. 14 and Fig. 36. Fig. 39 shows the standing wave effect in a case of using SiO at 30 nm thickness as the anti-reflective layer on Al, Al-Si or Al-Si-cu and in a case of not using the anti-reflective layer. In a case of using SiO at 30 nm as the anti-reflective layer (graph for "with SiO" in the figure), the standing wave effect was ±2.2% (1.4%), which was reduced to about 1/20 as compared with the case of not using the anti-reflective layer (graph for "without SiO" in the figure).

### Example 21

In this example, an anti-reflective layer was formed by forming a SiO film with n = 1.83 ± 0.2 and k = 0.75 ± 0.2 shown in Example 20 by the following method.

That is, in this example, a film was formed at a temperature from normal temperature to 500° and under a pressure of 0.01 to 10 Pa by using a gas mixture of SiH₄ + O₂ + N₂. Thus, a SiO film having an aimed anti-reflective effect could be obtained.

### Example 22

In this Example, an anti-reflective layer was formed by patterning a SiO film by etching.

In this case, the SiO film was etched by a reactive ion etching process using CF₄, CHF₃, C₂F₆, C₃F₈, SF₆ or NF₃ series gas (or a mixed gas system) as an etchant and adding Ar to improve the ionic property, thereby obtaining an anti-reflective layer of a desired pattern.

### Example 23

In this example, an organic or inorganic substance suitable for forming a stable pattern on an Al, Al-Si or Al-Si-Cu film was obtained and using it as an anti-reflective layer by using KrF excimer lithography.

As shown in Fig. 28, in the method of forming the resist pattern in this example, an anti-reflective layer ARL was formed on Al, Al-Si or Al-Si-Cu as an Al or Al-alloys wiring material (1) and forming a photoresist PR on the anti-reflective layer ARL, thereby forming a resist pattern, in which an appropriate material was selected to form the anti-reflective layer.

In this example, the anti-reflective layer was designed, particularly, in a case of obtaining a wiring structure by forming a material layer as wiring with Al, Al-Si or Al-Si-Cu on a substrate S such as a Si semiconductor substrate, and patterning the same by a photolithographic step using the photoresist PR and an etching step.
(1) XP 8843 resist (manufactured by Shipley Microelectronics Co.) was coated on an Al, Al-Si or Al-Si-Cu film without an anti-reflective layer and exposed by a KrF excimer laser beam at a wave length of 248 nm, followed by development. Fig. 29 shows the standing wave effect in this case. As shown in Fig. 29, the standing wave effect was about ± 29.6%.
(2) In Fig. 29, the maximum value of the standing wave effect situates, for example, at 982 nm of the resist film thickness. Fig. 30 shows fluctuation for the amount of photoresist absorption in the resist film relative to the change of optical constants nₐᵣ₁, kₐᵣ₁ of the anti-reflective layer, taking notice on the resist film at a thickness of 982 nm, and setting the thickness of the anti-reflective layer to 30 nm.
(3) Figs. 31, 32 and 33 shows the results of repeating the procedure (2) described above to each of resist film thicknesses of 1,000 nm, 1,018 nm and 1,035 nm, respectively.
(4) As a result of determining a common region in Fig. 30 to Fig. 33,
   nₐᵣ₁ = 4.8, kₐᵣ₁ = 0.45 or
   nₐᵣ₁ = 2.0, kₐᵣ₁ = 0.8
   was obtained.
   That is, the condition to be satisfied by the optimum anti-reflective layer upon setting the thickness of the anti-reflective layer as 30 nm was:
   nₐᵣ₁ = 4.8, kₐᵣ₁ = 0.45 or
   nₐᵣ₁ = 2.0, kₐᵣ₁ = 0.8.

   When the standing wave effect was determined by using this condition, results shown in Fig. 34 and Fig. 35 were obtained. The standing wave effect shown by "optimum condition" in Figs. 34 and 35 was extremely small, which was about less than ±1% in each of the cases. As compared with the case without anti-reflective layer, the standing wave effect was reduced to about 1/30.
(5) The procedures (2) - (4) above are for the case of setting the thickness of the anti-reflective layer to 30 nm. When the procedures (2) - (4) were repeated also to the anti-reflective layers of different thicknesses (ARL thickness), the optimum condition for the anti-reflective layer depending on the thickness of the anti-reflective layer was determined. Figs. 14 and 36 show the thus obtained results.

The standing wave effect was reduced to less than ±3% by using an organic or inorganic substance capable of satisfying the optical property on the curve in Figs. 14 and 36, or within a range of a value on the curve ±0.2 for n and a value on the curve ±0.15 for k. Accordingly, such an organic or inorganic substance was determined to form an anti-reflective layer. As compared with the case of not using the anti-reflective layer, the standing wave effect was reduced to about 1/10.

### EMBODIMENT 5 (according to the invention) and EMBODIMENT 6 (illustrative)

### Examples 24 - 33

In these examples, Cu wiring was formed by using Cu as the Cu or Cu-alloys material instead of the Al or Al-alloys metal material such as Al, Al-Si or Al-Si-Cu as the under-lying material in Examples 14 - 23 Embodiments 3 and 4, and an anti-reflective layer was formed thereon in the same manner as in each of the examples (SiC, SiO or an anti-reflective layer comprising an organic or inorganic substance determined by the same method as in Example 23 in a case where Cu was used as the under-lying material), thereby performing the resist patterning.

As a result, the standing wave effect was reduced and satisfactory patterning was conducted in the same manner as in each of the previous examples.

### EMBODIMENT 7

### Example 34

In this example, the present invention was applied by using SiC as an anti-reflective layer for forming a stable pattern on a Si substrate using KrF excimer lithography.

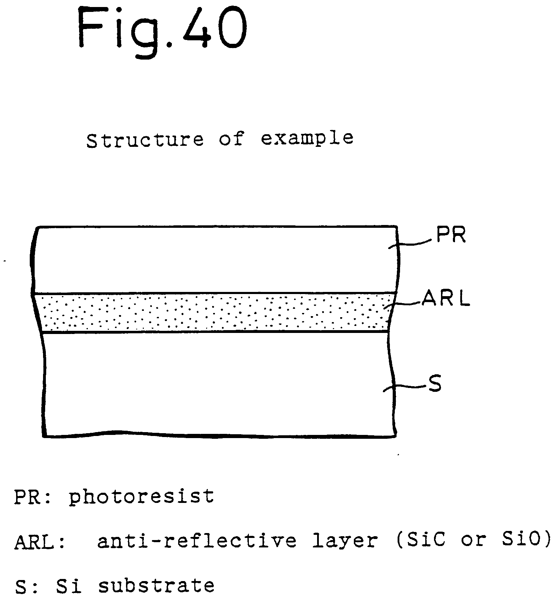

In the method of forming a resist pattern in this example, as shown in Fig. 40, an anti-reflective layer ARL was formed with silicon carbide on a silicon substrate as the silicic underlying material and a photoresist PR was formed on the anti-reflective layer ARL, thereby forming the resist pattern.

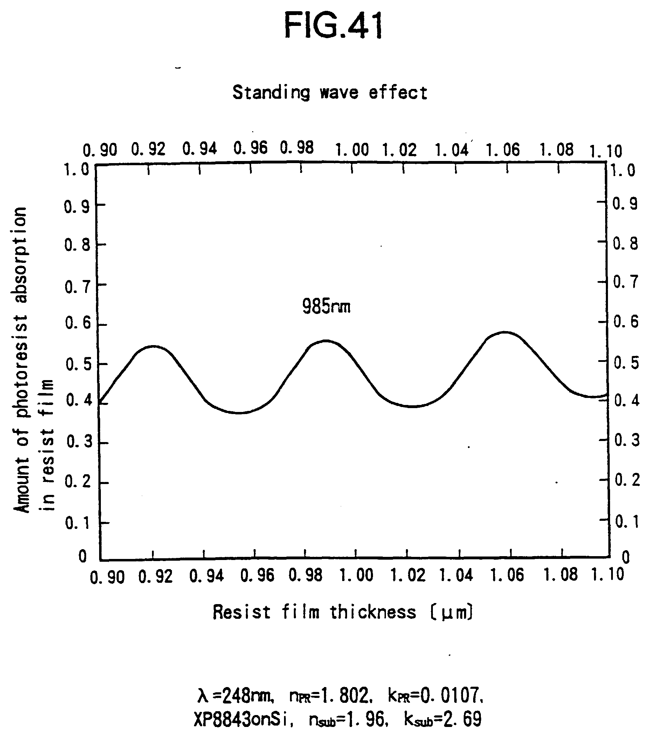

At first, description will be made to the procedures for selecting SiC as the anti-reflective layer and the method of determining the condition to be satisfied by SiC. The following procedures were conducted.
(1) XP 8843 resist (manufactured by Shipley Microelectronics Co.) was coated on a Si substrate without an anti-reflective layer, which was exposed by a KrF excimer laser beam at a wave length of 248 nm, followed by development. Fig. 41 shows the standing wave effect in this case. As shown in Fig. 41, the standing wave effect was about ± 20%.
(2) In Fig. 41, the maximum value of the standing wave effect situates, for example, at 985 nm of the resist film thickness. Fluctuation for the amount of photoresist absorption in the resist film was determined relative to the change of optical constants nₐᵣ₁, kₐᵣ₁ of the anti-reflective layer, while taking notice on the resist film thickness of 985 nm, and setting the thickness of the anti-reflective layer to 30 nm.
(3) The procedure (2) was repeated for each of a plurality of other resist film thicknesses.
(4) The results are shown in the figures and a common region in them was determined. Such a procedure was determined for each of the film thicknesses of the anti-reflective layers, by which an optimum value (n value, k value) for the optical property of a certain film thickness was determined.

The optimum condition for the anti-reflective layer was determined. Based on the result, SiC having n = 2.3 and k = 0.65 was used at a layer thickness of 25 nm as the anti-reflective layer, to greatly reduce the standing wave effect.

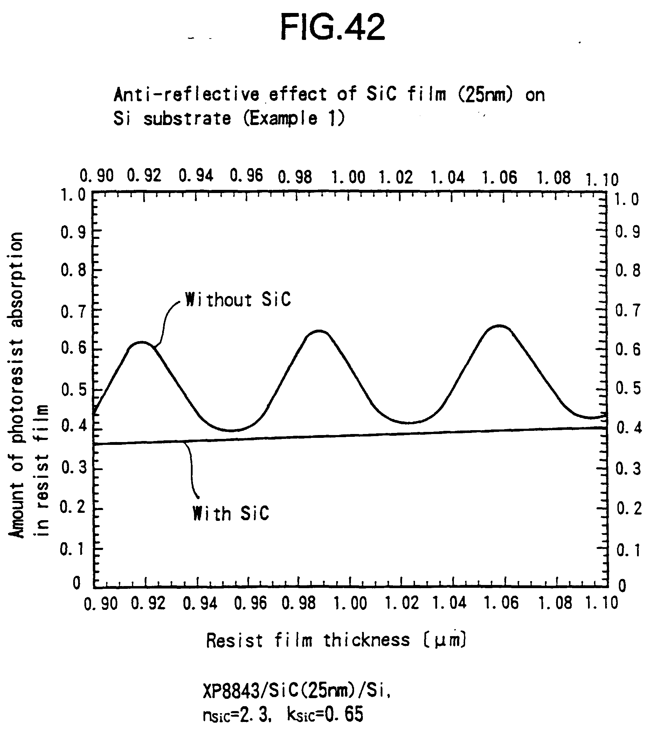

Fig. 42 shows a comparison between a case of using SiC at 25 nm as the anti-reflective layer (graph for "with SiC") and a case of not using the anti-reflective layer (graph for "without SiC"). In the case of using SiC at 25 nm, the standing wave effect was reduced to less than ±1%. The standing wave effect in the case of not using SiC was ±23%. Accordingly, the standing wave effect was reduced to less than 1/23 by using SiC as the anti-reflective layer on Si.

### Example 35

Also in this example, silicon oxide (SiO) having an optimal condition as the anti-reflective layer was determined by using the same method as in the previous example. That is, in this example, SiO having n = 2.1, k = 0.7 was used at a film thickness of 30 nm as the anti-reflective layer to greatly reduce the standing wave effect.

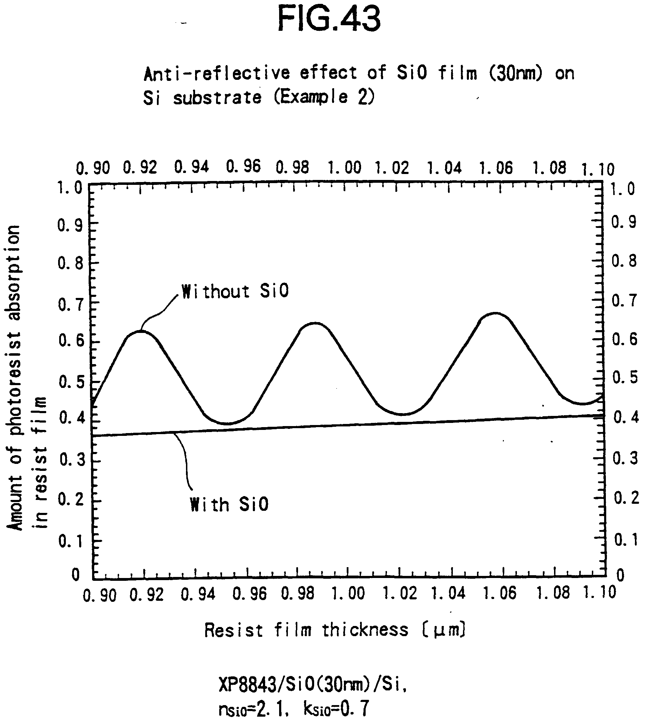

Fig. 43 shows a comparison between a case of using SiO at 30 nm as the anti-reflective layer (graph for "with SiO") and a case of not using the anti-reflective layer (graph for "without SiO"). In the case of using SiO at 30 nm, the standing wave effect was about ±1%. The standing wave effect in the case of not using SiO was ±23%. Accordingly, the standing wave effect was reduced to less than about 1/23 by using SiC as the anti-reflective layer on Si.

### Example 36

In this example, an anti-reflective layer as shown in Fig. 40 was formed by forming a SiC film with n = 2.3 ± 0.2 and k = 0.65 ± 0.2 shown in Example 34 by the following method.

That is, in this example, a film was formed by utilizing a thermal CVD process at a temperature of 100°C to 1500° and usually under a pressure, preferably, from 0.01 to 10,000 Pa, more preferably, 100 to 10,000 Pa by using the following gas as the starting material gas:
SiCl₄ + C₃H₈ + H₂,
SiHCl₃ + C₃H₈ + H₂,
SiH₄ + C₃H₈ + H₂,
SiH₄ + C₂H₄ + H₂,
SiH₄ + C₃H₈ + H₂,
SiCl₃ + CH₃ + H₂,
SiH₄ + C₃H₈ + H₂ or
SiH₄ + C₃H₈ + H₂.
Thus, a SiC film having an aimed anti-reflective effect could be obtained.

### Example 37

In this Example, an SiC film was formed as below to obtain an anti-reflective layer. That is, in this example, a film was formed by utilizing a plasma CVD process and using a photochemical reaction in a gas mixture comprising: Si₂H₆ + Si(CH₃) H₃ + C₂H₂.

### Example 38

In this example, a SiC film was formed as below to obtain an anti-reflective layer.

A film was formed by an ECR plasma process by utilizing an ECR plasma CVD process using microwave (at 2.45 GHz) from a gas mixture comprising: SiH₄ + C₂H₄ + H₂, SiH₄ + C₂H₄ + H₂ or SiH₄ + CH₄ + H₂.

### Example 39

In this example, a SiC film was formed as below to obtain an anti-reflective layer. That is, a film was formed by utilizing a sputtering method using SiC as a target.

### Example 40

In this example, an anti-reflective layer was formed by patterning a SiC film by etching.

In this case, the SiC film was etched by a reactive ion etching process using CF₄, CHF₃, C₂F₆, C₃F₈, SF₆ or NF₃ gas as an etchant and adding Ar to improve the ionic property, thereby obtaining an anti-reflective layer of a desired pattern.

### Example 41

In this example, a SiO film having n = 2.1 ± 0.2 and k = 0.7 ± 0.2 shown in Example 35 was formed by the following method to form an anti-reflective layer shown in Fig. 40 and described for the function in Fig. 43.

That is, a film was formed by using a gas mixture of SiH₄ + O₂ + N₂ at a temperature from normal temperature to 500°C under a pressure of 0.01 Pa - 10 Pa. Thus, an SiO layer having a desired anti-reflective effect was obtained.

### Example 42

The SiC layer and the SiO layer in each of the examples described above were formed on the underlying single crystal silicon, underlying polycrystalline silicon and underlying amorphous silicon, respectively, to form anti-reflective layers. As a result, a desired anti-reflective effect could be obtained to attain a satisfactory pattern formation.

### EMBODIMENT 8 (illustrative)

### Example 43

In this example, the present invention was applied by using SiOₓ as an anti-reflective layer for forming a stable pattern on a W-Si film using KrF excimer lithography.

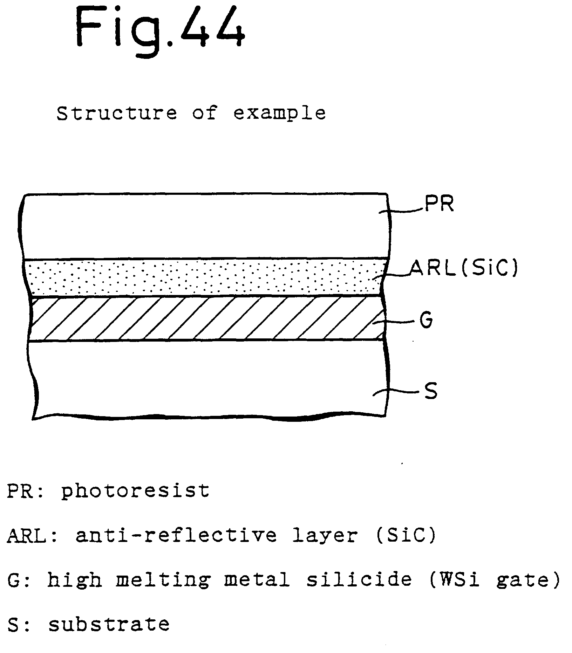

In the method of forming a resist pattern in this example, as shown in Fig. 44, an anti-reflective layer ARL was formed with SiOₓ on an underlying W-Si material as refractory metal silicide and a photoresist PR was formed on the anti-reflective layer ARL, thereby forming the resist pattern.

In this example, the present invention is applied by using SiOₓ as the anti-reflective layer ARL, particularly, in a case of forming a material layer as a gate with W-Si on a substrate 1 such as a Si semiconductor substrate and patterning the same by a photolithographic step using a photoresist PR and an etching step, thereby obtaining a gate structure.

At first, description will be made to the procedures for selecting SiOₓ as the anti-reflective layer to be used on W-Si and the method of determining the condition to be satisfied by SiOₓ. The following procedures (1) - (6) were conducted.
(1) XP 8843 resist (manufactured by Shipley Microelectronics Co.) was coated on W-Si under without an anti-reflective layer and exposed by a KrF excimer laser beam at a wave length of 248 nm, followed by development. Fig. 7 shows the standing wave effect in this case. As shown in Fig. 7, the standing wave effect was about ± 20%.
(2) In Fig. 7, the maximum value of the standing wave effect situates, for example, at 985 nm of the resist film thickness. Fig. 8 shows the equi-contour lines for the amount of absorbed light in the resist film relative to the change of optical constants nₐᵣ₁, kₐᵣ₁ of the anti-reflective layer, taking notice on the resist film thickness of 985 nm, and setting the thickness of the anti-reflective layer to 30 nm.
(3) Figs. 9, 10 and 11 show the results of repeating the procedures (2) above to each of the resist film thicknesses of 1,000 nm, 1,017.5 nm and 1.035 nm, respectively.
(4) As a result of determining a common region in Fig. 8 to Fig. 11,
   nₐᵣ₁ = 4.9, kₐᵣ₁ = 0.1, or
   nₐᵣ₁ = 2.15, kₐᵣ₁ = 0.67
   were obtained.
   That is, the condition to be satisfied by the optimum anti-reflective layer with the thickness of the anti-reflective layer being set as 30 nm is:
   nₐᵣ₁ = 4.9, kₐᵣ₁ = 0.1, or
   nₐᵣ₁ = 2.15, kₐᵣ₁ = 0.67.

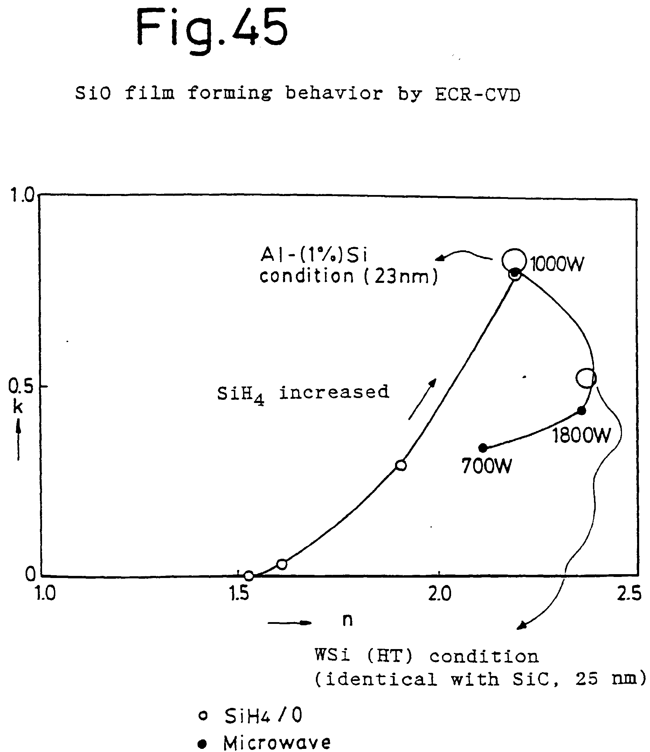

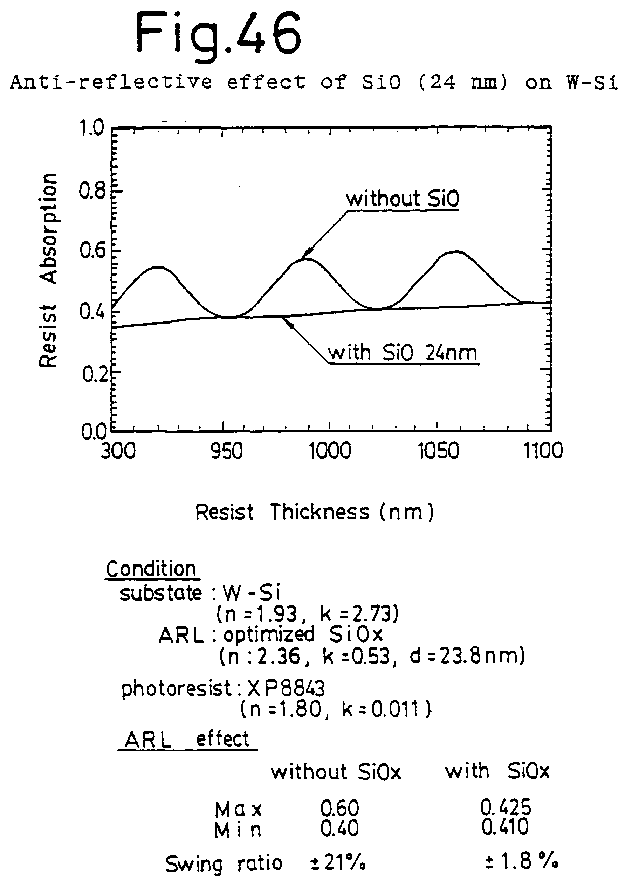

   When the standing wave effect was determined by using the above-mentioned condition, the results shown in Fig. 12 and Fig. 13 were obtained. In each of the cases, the standing wave effect was extremely small and it was about less than 1%. The standing wave effect was reduced to about 1/20 as compared with the case of not using the anti-reflective layer.
(5) The procedures (2) - (4) described above were conducted in a case of setting the thickness of the anti-reflective layer as 30 nm. When the procedures (2) - (4) were repeated also for anti-reflective layer (ARL thickness) of other different layer thicknesses, an optimum condition for the anti-reflective layer in accordance with the thickness of the anti-reflective layer could be determined. Fig. 14 and Fig. 15 show the obtained results.
(6) It was investigated as to whether the film species capable of satisfying the condition to be met by the anti-reflective layer determined in (5) above are present or not by using a spectroscopic ellipsometer (SOPRA Co.). As a result, it has been found that the optical constant shows changes in Fig. 45 corresponding to the film forming conditions upon forming the SiOₓ film by using the CVD process. In Fig. 45, regions shown by open circles satisfy the conditions in Figs. 14 and 15. That is, Fig. 46 shows the standing wave effect in a case of using the SiOₓ film at 25 nm thickness as an anti-reflective layer and in a case of not using the anti-reflective layer. In the case of using a SiOₓ film at 25 nm, the standing wave effect was about ±1.8% and the standing wave effect was reduced to less than about 1/12 as compared with the case of not using the anti-reflective layer.

### Example 44

In this example, a SiOₓ film having n = 2.4 ± 0.6 and k = 0.7 ± 0.2 shown in Example 43 was formed by the following method to form an anti-reflective layer as shown in Fig. 46.

That is, in this example, a film was formed by utilizing a parallel plate plasma CVD process and using a microwave (2.45 GHz) from a gas mixture of SiH₄ + O₂.

### Example 45

In this example, a SiOₓ film having n = 2.4 ± 0.6 and k = 0.7 ± 0.2 shown in Example 43 was formed by the following method to form an anti-reflective layer having an anti-reflective function as shown in Fig. 46.

That is, in this example, a film was formed by utilizing a parallel plate type plasma CVD process and using a microwave (2.45 GHz) from a gas mixture of SiH₄ + O₂ and using Ar as a buffer gas.

### Example 46

In this example, a SiOₓ film having n = 2.4 ± 0.6 and k = 0.7 ± 0.2 shown in Example 43 was formed by the following method to form an anti-reflective layer having an anti-reflective function as shown in Fig. 46.

That is, in this example, a film was formed by utilizing an ECR type plasma CVD process and using a microwave (2.45 GHz) from a gas mixture of SiH₄ + O₂.

### Example 47

In this example, a SiOₓ film having n = 2.4 ± 0.6 and k = 0.7 ± 0.2 shown in Example 43 was formed by the following method to form an anti-reflective layer having an anti-reflective function as shown in Fig. 46.

That is, in this example, a film was formed by utilizing a ECR type plasma CVD process and using a microwave (2.45 GHz) from a gas mixture of SiH₄ + O₂ and using Ar as a buffer gas.

### Example 48

In this example, a SiOₓ film having n = 2.4 ± 0.6 and k = 0.7 ± 0.2 shown in Example 43 was formed by the following method to form an anti-reflective layer having an anti-reflective function as shown in Fig. 46.

That is, in this example, a film was formed by utilizing a bias ECR plasma CVD process and using a microwave (2.45 GHz) from a gas mixture of SiH₄ + O₂.

### Example 49

In this example, a SiOₓ film having n = 2.4 ± 0.6 and k = 0.7 ± 0.2 shown in Example 43 was formed by the following method to form an anti-reflective layer having an anti-reflective function as shown in Fig. 46.

That is, in this example, a film was formed by utilizing a bias ECR type plasma CVD process and using a microwave (2.45 GHz) from a gas mixture of SiH₄ + O₂ and using Ar as a buffer gas.

### Example 50

In this example, the SiOₓ film having n = 2.4 ± 0.6 and k = 0.7 ± 0.2 shown in Example 43 was etched for the underlying material using a resist pattern as a mask by the following method.

That is, the SiOₓ film was etched by a reactive etching process using a gas system of CHF₃ (50 - 100 SCCM) + O₂ (3 - 20 SCCM) under a pressure of about 2 Pa and with a power of about 100 to 1000 W, to obtain a desired pattern by etching.

### Example 51

In this example, the SiOₓ film having n = 2.4 ± 0.6 and k = 0.7 ± 0.2 shown in Example 43 was etched for the underlying material using a resist pattern as a mask by the following method.

That is, the SiOₓ film was etched by a reactive etching process using a gas system of C₄F₈ (30 - 70 SCCM) + CHF₃ (10 - 30 SCCM) under a pressure of about 2 Pa and with a power of about 100 to 1000 W, to obtain a desired pattern by etching.

### Example 52

In this example, the SiOₓ film having n = 2.4 ± 0.6 and k = 0.7 ± 0.2 shown in Example 43 was etched for the underlying material using a resist pattern as a mask by the following method.

That is, the SiOₓ film was etched by a reactive etching process using a gas system of S₂F₂ (5 - 30 SCCM) under a pressure of about 2 Pa and with a power of about 100 to 1000 W, to obtain a desired pattern by etching.

### EMBODIMENT 9 (illustrative)

### Example 53

In this example, the present invention was applied by using a SiₓO_{y}N_{z} or SiₓN_{y} film as an anti-reflective layer for forming a stable pattern on a W-Si film by using KrF excimer lithography.

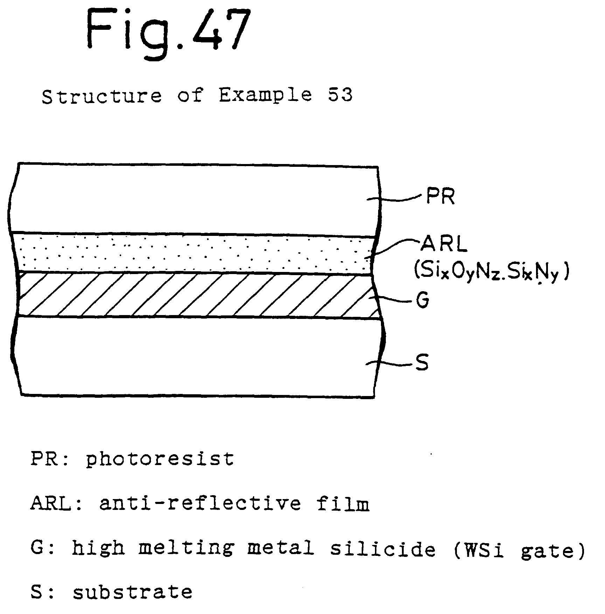

In the method of forming a resist pattern in this example, as shown in Fig. 47, an anti-reflective layer ARL was formed with SiₓO_{y}N_{z} or SiₓN_{y} on the underlying W-Si as a refractory metal silicide and a photoresist PR was formed on the anti-reflective layer ARL, thereby forming the resist pattern.

In this example, the present invention is applied by using SiₓO_{y}N_{z} or SiₓN_{y} as the anti-reflective layer ARL, particularly, in a case of forming a material layer with W-Si as a gate on a substrate 1 such as a Si semiconductor substrate and patterning the same by a photolithographic step using a photoresist PR and an etching step, thereby obtaining a gate structure.

At first, description will be made to the procedures for selecting SiₓO_{y}N_{z} or SiₓN_{y} as the anti-reflective layer to be used on W-Si and the method of determining the condition to be satisfied by SiₓO_{y}N_{z} or SiₓN_{y}. The following procedures (1) - (6) were conducted.
(1) XP 8843 resist (manufactured by Shipley Microelectronics Co.) was coated on W-Si without an anti-reflective layer and exposed by a KrF excimer laser beam at a wave length of 248 nm, followed by development. Fig. 7 shows the standing wave effect in this case. As shown in Fig. 7, the standing wave effect was about ± 20%.
(2) In Fig. 7, the maximum value of the standing wave effect situates, for example, at 985 nm of the resist film thickness. Fig. 8 shows equi-contour lines for the amount of absorbed light in the resist film relative to the change of optical constants nₐᵣ₁, kₐᵣ₁ of the anti-reflective layer, taking notice on the resist film thickness of 985 nm, and setting the thickness of the anti-reflective layer to 30 nm.
(3) Figs. 9, 10 and 11 show the results of repeating the procedures (2) above to each of the resist film thicknesses of 1,000 nm, 1,017.5 nm and 1,035 nm, respectively.
(4) As a result of determining a common region in Fig. 8 to Fig. 11,
   nₐᵣ₁ = 4.9, kₐᵣ₁ = 0.1, or
   nₐᵣ₁ = 2.15, kₐᵣ₁ = 0.67
   were obtained.
   That is, the condition to be satisfied by the optimal anti-reflective layer with the thickness of the anti-reflective layer being set as 30 nm is:
   nₐᵣ₁ = 4.9, kₐᵣ₁ = 0.1, or
   nₐᵣ₁ = 2.15, kₐᵣ₁ = 0.67.

   When the standing wave effect was determined by using the above-mentioned condition, the results shown in Fig. 12 and Fig. 13 were obtained. In Fig. 12 and Fig. 13, the standing wave effect was extremely small and it was about less than ±1% in each of the cases. The standing wave effect was reduced to about 1/20 as compared with the case of not using the anti-reflective layer.
(5) The procedures (2) - (4) described above were conducted in a case of setting the thickness of the anti-reflective layer as 30 nm. When the procedures (2) - (4) were repeated also for anti-reflective layer (ARL thickness) of other different layer thicknesses, an optimal condition for the anti-reflective layer in accordance with the thickness of the anti-reflective layer could be determined. Fig. 14 and Fig. 15 show the obtained results.
(6) It was investigated as to whether the film species capable of satisfying the condition to be met by the anti-reflective layer determined in (5) above are present or not by using a spectroscopic ellipsometer (SOPRA Co.).

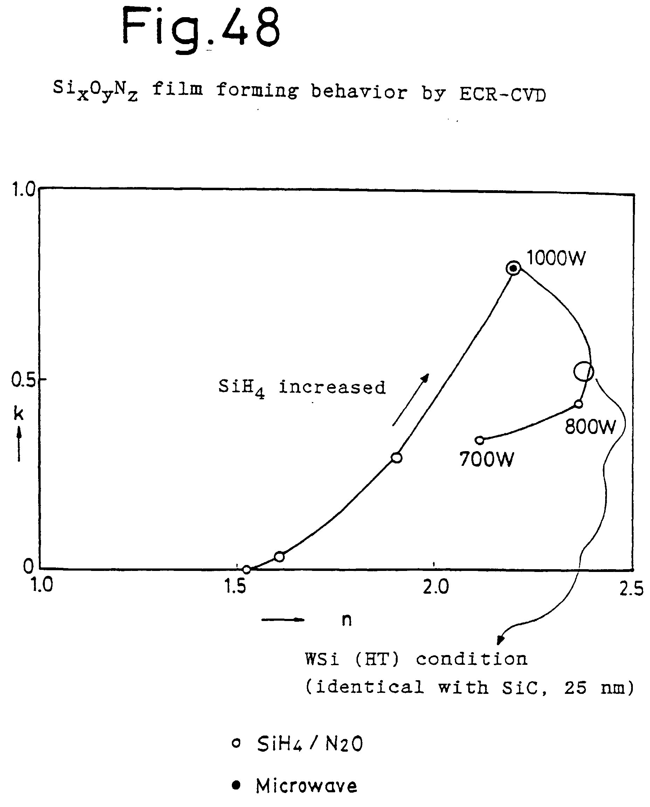

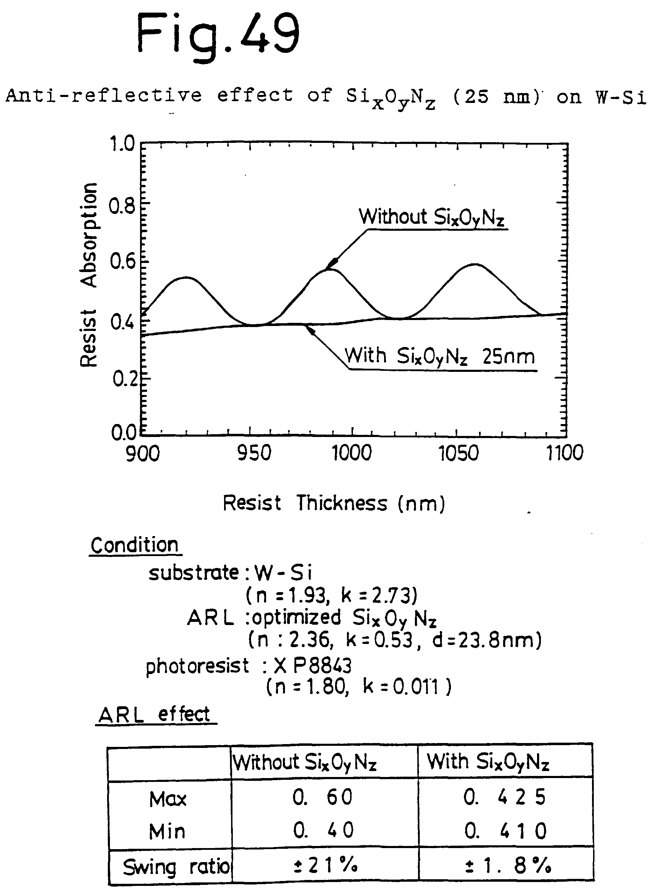

As a result, it has been found that the optical constant shows changes in Fig. 48 corresponding to the film forming conditions upon forming the SiₓO_{y}N_{z} or SiₓN_{y} film by using the CVD process. In Fig. 48, regions shown by open circles satisfy the conditions in Figs. 14 and 15. That is, Fig. 49 shows the standing wave effect in a case of using the SiₓO_{y}N_{z} or SiₓN_{y}film at 25 nm thickness as an anti-reflective layer and in a case of not using the anti-reflective layer. In the case of using the SiₓO_{y}N_{z} or SiₓN_{y} film at 25 nm, the standing wave effect was about ±1.8% and the standing wave effect was reduced to less than about 1/12 as compared with the case of not using the anti-reflective layer.

### Example 54

In this example, a SiₓO_{y}N_{z} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, by using a microwave (2.45 GHz), from a gas mixture of SiH₄ + O₂ + N₂ or a gas mixture of SiH₄ + N₂O.

### Example 55

In this example, a SiₓO_{y}N_{z} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, by using a microwave (2.45 GHz), from a gas mixture of SiH₄ + O₂ + N₂ or a gas mixture of SiH₄ + N₂O and using Ar as a buffer gas.

### Example 56

In this example, a SiₓO_{y}N_{z} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, from a gas mixture of SiH₄ + O₂ + N₂ or a gas mixture of SiH₄ + N₂O.

### Example 57

In this example, a SiₓO_{y}N_{z} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, from a gas mixture of SiH₄ + O₂ + N₂ or a gas mixture of SiH₄ + N₂O and using Ar as a buffer gas.

### Example 58

In this example, a SiₓN_{y} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, by using a microwave (2.45 GHz), from a gas mixture of SiH₄ + NH₃ or a gas mixture of SiH₂Cl₂ + NH₃.

### Example 59

In this example, an SiₓN_{y} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, from a gas mixture of SiH₄ + O₂ or a gas mixture of SiH₂Cl₂ + NH₃ and using Ar as a buffer gas.

### Example 60

In this example, an SiₓN_{y} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, by using a microwave (2.45 GHz), from a gas mixture of SiH₄ + NH₃ or a gas mixture of SiH₂CL₂ + NH₃.

### Example 61

In this example, an SiₓN_{y} film having n = 2.4 ± 0.6 and k = 0.7 ± 0.2 shown in Example 53 was formed by the following method to form an anti-reflective layer as shown in Fig. 47.

That is, in this example, a film was formed by utilizing a parallel plate plasma CVD process, ECR plasma CVD process or bias ECR plasma CVD process, from a gas mixture of SiH₄ + O₂ or a gas mixture of SiH₂Cl₂ + NH₃ by using Ar as a buffer gas.

### Example 62

In this example, a SiₓO_{y}N_{z} or SiₓN_{y} film having n = 2.4 ± 0.6 and k = 0.7 ± 0.2 shown in Example 53 was etched by the following method using a resist pattern as a mask.

That is, the SiₓO_{y}N_{z} or SiₓN_{y} film was etched by using a gas system of CHF₃ (50 - 100 SCCM) + O₂ (3 - 20 SCCM), under a pressure of about 2 Pa and with a power of about 100 - 1000 V by using a reactive etching process with improved ionic property, thereby etching a desired pattern.

### Example 63

In this example, an SiₓO_{y}N_{z} or SiₓN_{y} film having n = 2.4 ± 0.6 and k = 0.7 ± 0.2 shown in Example 53 was etched by the following method using a resist pattern as a mask.

That is, the SiₓO_{y}N_{z} or SiₓN_{y} film was etched by using a gas system of C₄F₈ (30 - 70 SCCM) + CHF₃ (10 - 30 SCCM), under a pressure of about 2 Pa and with a power of about 100 - 1000 V by using a reactive etching process with improved ionic property, thereby etching a desired pattern.

### Example 64

In this example, a SiₓN_{y} film having n = 2.4 ± 0.6 and k = 0.7 ± 0.2 shown in Example 53 was etched by the following method using a resist pattern as a mask.

That is, the SiₓO_{y}N_{z} or SiₓN_{y} film was etched by using a gas system of S₂F₂ (5 - 30 SCCM), under a pressure of about 2 Pa and with a power of about 100 - 1000 V by using a reactive etching process with improved ionic property, thereby etching a desired pattern.

### EMBODIMENT 10 (illustrative)

### Example 65

In this example, the present invention was applied by using a SiₓO_{y}N_{z} or SiₓN_{y} film as an anti-reflective layer for forming a stable resist pattern on an underlying Al, Al-Si or Al-Si-Cu material or on a silicon oxide film such as SiO₂ on the underlying material by using KrF excimer lithography.

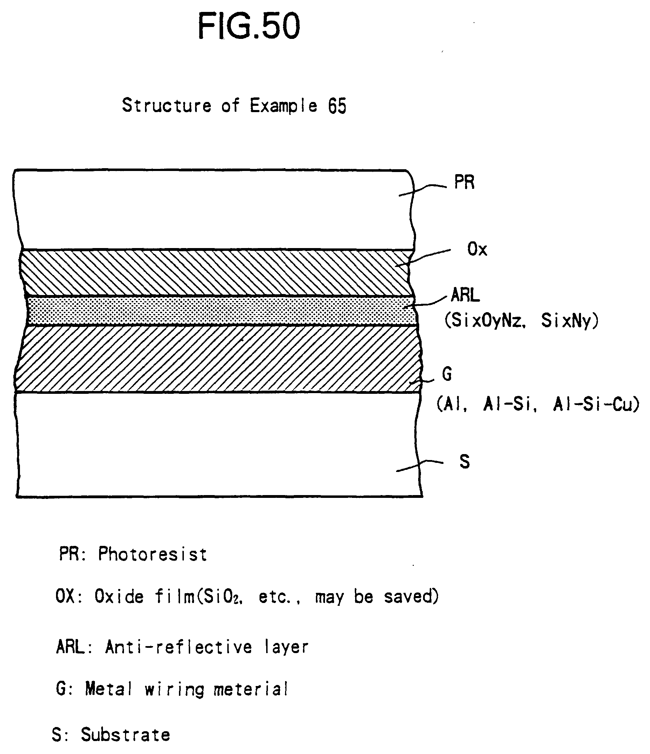

In the method of forming the resist pattern in this pattern, as shown in Fig. 50, an anti-reflective layer ARL is formed with SiₓO_{y}N_{z} or SiₓN_{y} on the underlying Al, Al-Si or Al-Si-Cu material as a metal wiring material, a photoresist PR was formed on the anti-reflective layer ARL or the photoresist PR was formed on the anti-reflective layer after forming a silicon oxide film such as SiO₂ on the anti-reflective layer to form a resist pattern. In this example, the present invention was applied by using SiₓO_{y}N_{z} or SiₓN_{y} as the anti-reflective layer ARL, particularly, in a case of obtaining a wiring structure by forming a material layer as wiring with Al, Al-Si or Al-Si-Cu on a substrate such as a Si semiconductor substrate or forming a silicon oxide film such as SiO₂ on the material layer, which was then patterned by a photolithographic step using the photoresist PR and an etching step.

At first, description will be made to the procedures for selecting SiₓO_{y}N_{z} or SiₓN_{y} as the anti-reflective layer to be used on the underlying Al, Al-Si or Al-Si-Cu material and the method of determining the condition to be satisfied by SiₓO_{y}N_{z} or SiₓN_{y}. The following procedures (1) - (6) were conducted.
(1) XP 8843 resist (manufactured by Shipley Microelectronics Co.) was coated on an Al, Al-Si or Al-Si-Cu substrate without an anti-reflective layer and exposed by a KrF excimer laser beam at a wave length of 248 nm, followed by development. Fig. 20 shows the standing wade effect in this case. As shown in Fig. 20, the standing wave effect was about ± 29.6%.
(2) In Fig. 20, the maximum value of the standing wave effect situates, for example, at 982 nm of the resist film thickness. Fig. 30 shows equi-contour lines for the amount of absorbed light in the resist film relative to the change of optical constants nₐᵣ₁, kₐᵣ₁ of the anti-reflective layer, taking notice on the resist film thickness of 982 nm, and setting the thickness of the anti-reflective layer to 30 nm.
(3) Figs. 31, 32 and 33 show the results of repeating the procedures (2) above to each of the resist film thicknesses of 1,000 nm, 1,018 nm and 1,035 nm, respectively.
(4) As a result of determining a common region in Fig. 30 to Fig. 33,
   nₐᵣ₁ = 4.8, kₐᵣ₁ = 0.45, or
   nₐᵣ₁ = 2.0, kₐᵣ₁ = 0.8
   were obtained.
   That is, the condition to be satisfied by the optimal anti-reflective layer with the thickness of the anti-reflective layer being set as 30 nm is:
   nₐᵣ₁ = 4.8, kₐᵣ₁ = 0.45, or
   nₐᵣ₁ = 2.0, kₐᵣ₁ = 0.8.

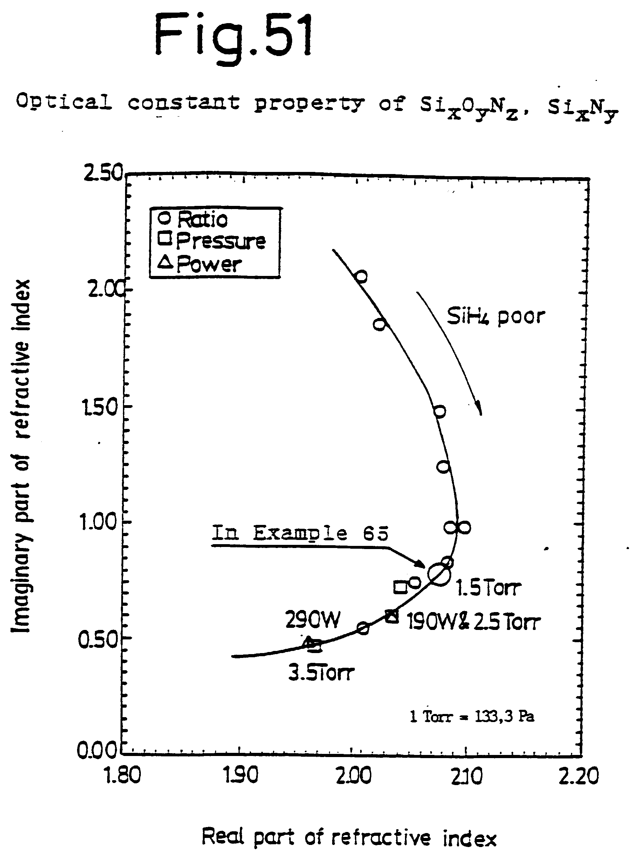

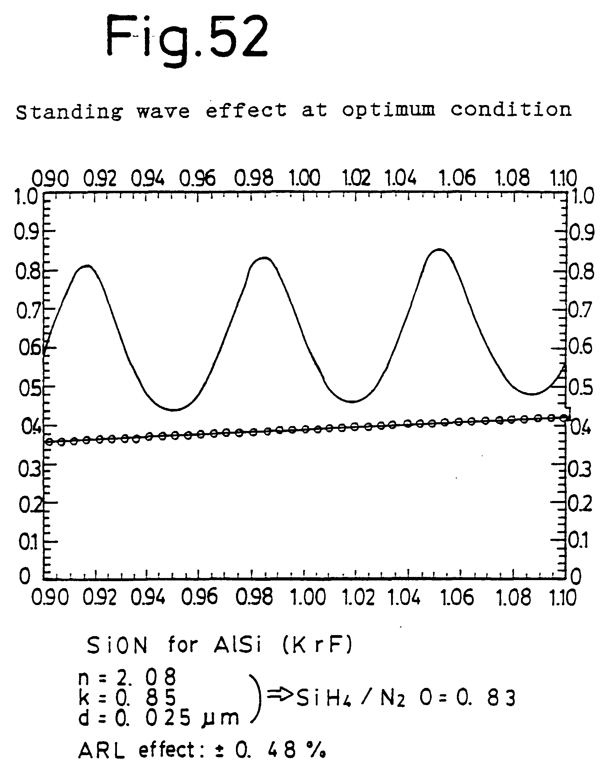

   When the standing wave effect was determined by using the above-mentioned condition, the results shown in Fig. 34 and Fig. 35 were obtained. In Fig. 34 and Fig. 35, the standing wave effect was extremely small and it was about less than ±1% in each of the cases. The standing wave effect was reduced to about 1/60 as compared with the case of not using the anti-reflective layer.
(5) The procedures (2) - (4) described above were conducted in a case of setting the thickness of the anti-reflective layer as 30 nm. When the procedures (2) - (4) were repeated also for anti-reflective layer (ARL thickness) of other different layer thicknesses, an optimal condition for the anti-reflective layer in accordance with the thickness of the anti-reflective layer could be determined. Fig. 14 and Fig. 36 show the obtained results.
(6) It was investigated as to whether the film species capable of satisfying the condition to be met by the anti-reflective layer determined in (5) above were present or not by using a spectroscopic ellipsometer (SOPRA Co.). As a result, it has been found that the optical constants show the change in Fig. 51 corresponding to the condition upon forming the SiₓO_{y}N_{z} or SiₓN_{y} film by using the CVD process. The region shown by open circles in Fig. 51 satisfy the conditions in Fig. 14 and Fig. 36. That is, Fig. 52 shows the standing wave effect in a case of using the SiₓO_{y}N_{z} or SiₓN_{y} film at a 25 nm thickness as an anti-reflective layer on the underlying Al, Al-Si, Al-Si-Cu material and in a case of not using the anti-reflective layer. In the case of using the SiₓO_{y}N_{z} or SiₓN_{y} film at 25 nm, the standing wave effect was about ±0.5%, and the standing wave effect was reduced to about 1/60 as compared with the case of not using the anti-reflective layer.

### Example 66

In this example, an SiₓO_{y}N_{z} film within a range of values on the curve in the graph showing the relation between the thickness of the anti-reflective layer and the optical property to be satisfied by the optimum anti-reflective layer (Fig. 14, Fig. 36) or values on the curve ±0.3 for n and values on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, using a microwave (2.45 GHz) from a gas mixture of SiH₄ + O₂ + N₂ or a gas mixture of SiH₄ + N₂O.

### Example 67

In this example, an SiₓO_{y}N_{z} film within a range of values on the curve in the graph showing the relation between the thickness of the anti-reflective layer and the optical property to be satisfied by the optimum anti-reflective layer (Fig. 14, Fig. 36) or values on the curve ±0.3 for n and values on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, using a microwave (2.45 GHz) from a gas mixture of SiH₄ + NO₂ + N₂ or a gas mixture of SiH₄ + N₂O and using Ar as a buffer gas.

### Example 68

In this example, an SiₓO_{y}N_{z} film within a range of values on the curve in the graph showing the relation between the thickness of the anti-reflective layer and the optical property to be satisfied by the optimum anti-reflective layer (Fig. 14, Fig. 36) or values on the curve ±0.3 for n and values on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, from a gas mixture of SiH₄ + O₂ + N₂ or a gas mixture of SiH₄ + N₂O.

### Example 69

In this example, an SiₓO_{y}N_{z} film within a range of values on the curve in the graph showing the relation between the thickness of the anti-reflective layer and the optical property to be satisfied by the optimum anti-reflective layer (Fig. 14, Fig. 36) or values on the curve ±0.3 for n and value on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, from a gas mixture of SiH₄ + O₂ + N₂ or a gas mixture of SiH₄ + N₂O, using Ar as a buffer gas.

### Example 70

In this example, an SiₓO_{y}N_{z} film within a range of values on the curve in the graph showing the relation between the thickness of the anti-reflective layer and the optical property to be satisfied by the optimum anti-reflective layer (Fig. 14, Fig. 36) or values on the curve ±0.3 for n and values on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, using a microwave (2.45 GHz) from a gas mixture of SiH₄ + NH₃ or a gas mixture of SiH₂Cl₂ + NH₃

### Example 71

In this example, an SiₓN_{y} film within a range of values on the curve in the graph showing the relation between the thickness of the anti-reflective layer and the optical property to be satisfied by the optimum anti-reflective layer (Fig. 14, Fig. 36) or values on the curve ±0.3 for n and values on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, using a microwave (2.45 GHz) from a gas mixture of SiH₄ + O₂ or a gas mixture of SiH₂Cl₂ + NH₃ using Ar as a buffer gas.

### Example 72

In this example, an SiₓO_{y}N_{z} film within a range of values on the curve in the graph showing the relation between the thickness of the anti-reflective layer and the optical property to be satisfied by the optimum anti-reflective layer (Fig. 14, Fig. 36) or values on the curve ±0.3 for n and values on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, from a gas mixture of SiH₄ + NH₃ or a gas mixture of SiH₂Cl₂ + NH₃.

### Example 73

In this example, an SiₓN_{y} film within a range of values on the curve in the graph showing the relation between the thickness of the anti-reflective layer and the optical property to be satisfied by the optimum anti-reflective layer (Fig. 14, Fig. 36) or values on the curve ±0.3 for n and values on the curve ±0.3 for k shown in Example 65 was formed by the method described below to form an anti-reflective layer shown in Fig. 50.

That is, in this example, a film was formed by utilizing a parallel plate plasma CVD process, ECR plasma CVD process or bias ECR plasma CVD process, from a gas mixture of SiH₄ + O₂ or a gas mixture of SiH₂Cl₂ + NH₃ using Ar as a buffer gas.

### Example 74

In this example, a SiₓO_{y}N_{z} or SiₓN_{y} film within a range of values on the curve in the figure (Fig. 14, Fig. 36) showing a relationship between the thickness of the anti-reflective layer and the optical property to be satisfied by the optimum anti-reflective layer or values on the curve ±0.3 for n and values on the curve +_0.3 for k was etched by the following method using the resist pattern as a mask for the underlying material.

That is, the SiₓO_{y}N_{z} or SiₓN_{y} film was etched by a reactive etching process using a gas system of CHF₃ (50 - 100 SCCM) + O₂ (3 - 20 SCCM) under a pressure of about 2 Pa and with a power of about 100 to 1000 W and improved with the ionic property to etch a desired pattern.

### Example 75

In this example, a SiₓO_{y}N_{z} or SiₓN_{y} film within a range of values on the curve in the figure (Fig. 14, Fig. 36) showing a relationship between the thickness of the anti-reflective layer and the optical property to be satisfied by the optimum anti-reflective layer or values on the curve ±0.3 for n and values on the curve +_0.3 for k was etched by the following method using the resist pattern as a mask for the underlying material.

That is, the SiₓO_{y}N_{z} or SiₓN_{y} film was etched by a reactive etching process using a gas system of C₄F₈ (30 - 70 SCCM) + CHF₃ (10 - 30 SCCM) under a pressure of about 2 Pa and with a power of about 100 to 1000 W and improved with the ionic property to etch a desired pattern.

### Example 76

In this example, a SiₓO_{y}N_{z} or SiₓN_{y} film within a range of values on the curve in the figure (Fig. 14, Fig. 36) showing a relationship between the thickness of the anti-reflective layer and the optical property to be satisfied by the optimum anti-reflective layer or values on the curve ±0.3 for n and values on the curve +_0.3 for k was etched by the following method using the resist pattern as a mask for the underlying material.

That is, the SiₓO_{y}N_{z} or SiₓN_{y} film was etched by a reactive etching process using a gas system of S₂F₂ (5 - 30 SCCM) under a pressure of about 2 Pa and with a power of about 100 to 1000 W and improved with the ionic property to etch a desired pattern.

### EMBODIMENT 11 (illustrative)

### Example 77

In this example, in a case of forming a stable resist pattern on a silicon substrate such as of single crystal silicon, polycrystalline silicon, amorphous silicon or doped polysilicon and, on a silicon oxide film such as SiO₂ on the underlying material by using a KrF excimer laser, it has been found according to the present invention that use of an organic or inorganic film having n = 1.8 - 2.6 and k = 0.1 - 0.8, particularly, a SiₓO_{y}N_{z} or SiₓN_{y} film at a film thickness of 20 - 150 nm as the anti-reflective layer was desirable.

In a case of using the SiₓO_{y}N_{z} or SiₓN_{y} film as the anti-reflective layer, the film could be formed by various types of CVD processes. Further, SiₓO_{y}N_{z} or SiₓN_{y} could be etched by RIE using CHF₃, C₄F₈, CHF₃, S₂F₂ series gas as an etchant and improved with the ionic property.

That is, in this example, the present invention was applied in a case of using the Siₓo_{y}Nₓ or SiₓN_{y} film as the anti-reflective layer for forming a stable resist pattern on a silicon series substrate such as single crystal silicon and, on a silicon oxide film such as SiO₂, on the above-mentioned substrate by using KrF excimer lithography.

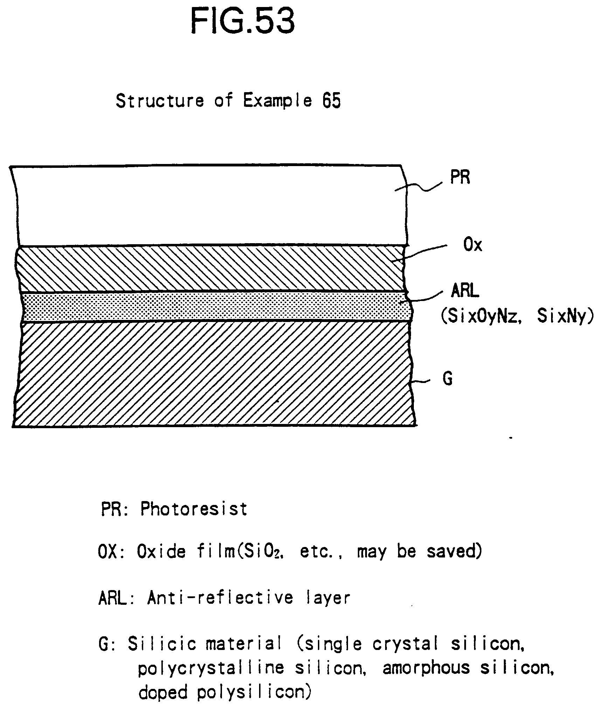

As shown in Fig. 53, in the method of forming a resist pattern in this example, an anti-reflective layer ARL was formed with SiₓO_{y}N_{z} or SiₓN_{y} on a silic substrate such as single crystal silicon, a photoresist PR was formed on the anti-reflective layer ARL, or the photoresist PR was formed after forming the silicon oxide film such as SiO₂ on the anti-reflective layer, thereby forming a resist pattern.

In this example, the present invention was applied, particularly, in a case of forming a silicon oxide film such as SiO₂ on a silicon series substrate such as of single crystal silicon or on the material layer, which was patterned by a photolithographic step using the photoresist PR and a etching step, in which SiₓO_{y}N_{z} or SiₓN_{y} was used as the anti-reflective layer ARL.

At first, description will be made to procedures for selecting an organic or inorganic film, particularly, a SiₓO_{y}N_{z} or Siₓ N_{y} film having n = 1.8 - 2.6 and k = 0.1 - 0.8 at a film thickness = 20 - 150 nm as an anti-reflective layer on the silicon series substrate such as of single crystal silicon or on the underlying material, as well as a method of determining the condition to be satisfied therewith. The following procedures (1) - (6) were conducted.
(1) XP 8843 resist (manufactured by Shipley Microelectronics Co.) was coated on a Si series substrate without an anti-reflective layer and exposed by a KrF excimer laser beam at a wave length of 248 nm, followed by development. Fig. 41 shows the standing wave effect in this case. As shown in Fig. 41, the standing wave effect was about ±20%.
(2) In Fig. 2, the maximum value of the standing wave effect situates, for example, at 985 nm of the resist film thickness. Fluctuation for the amount of absorbed light in the resist film was determined relative to the change of optical constants nₐᵣ₁, kₐᵣ₁ of the anti-reflective layer, taking notice on the resist film thickness of 985 nm, and setting the thickness of the anti-reflective layer to 30 nm.
(3) The procedure (2) was repeated for each of a plurality of resist films of different thicknesses.
(4) The results are shown in the figures and a common region in them was determined. Such a procedure was determined for each kind of the film thicknesses of the anti-reflective layers, by which an optimum value (n value, k value) for the optical property of a certain film thickness was determined. For instance, the optimum condition to be satisfied by the optimum anti-reflective layer in a case of setting the thickness of the anti-reflective layer as 32 nm was:
   nₐᵣ₁ = 2.0 kₐᵣ₁ = 0.55.

   Further, the optical condition to be satisfied by the optimum anti-reflective layer upon setting the thickness of the anti-reflective layer as 100 nm was:
   nₐᵣ₁ = 1.9 kₐᵣ₁ = 0.35.

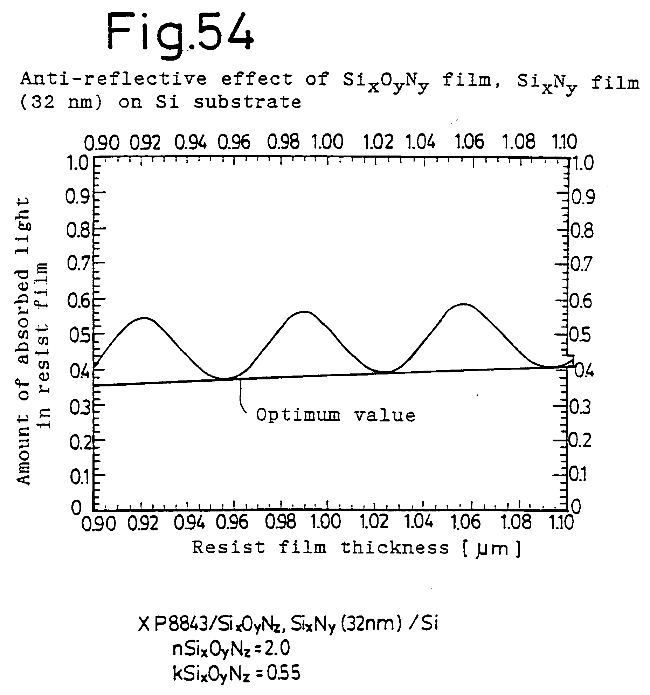

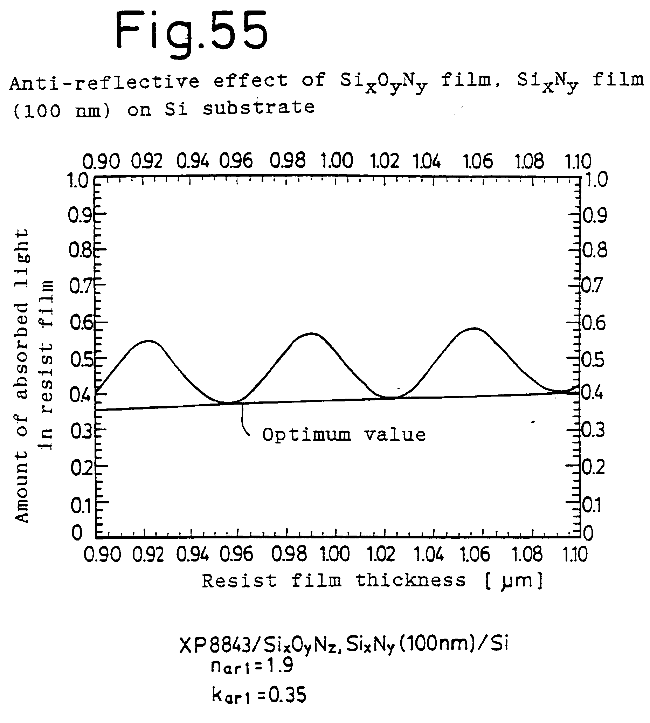

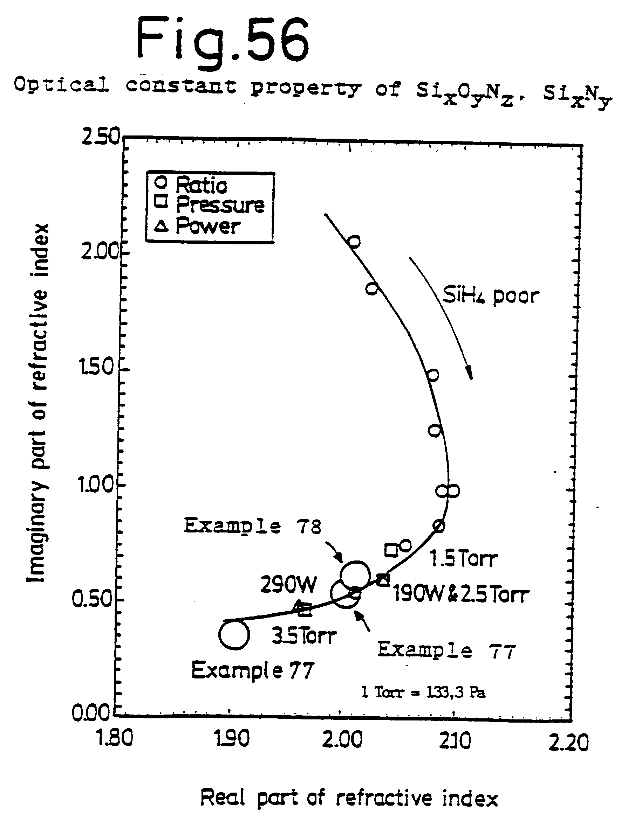

   When the standing wave effect was determined by using the above-mentioned two conditions, results as shown in Figs. 54 and 55 were obtained. In Figs. 54 and 55, the standing wave effect shown at the optimum value was extremely small and it was less than about ±1% in each of the cases. The standing wave effect was reduced to less than about 1/20 as compared with the case of not using the anti-reflective layer.
(5) The procedures (2) - (4) described above were applied to a case of setting the thickness of the anti-reflective layer as 32 nm and 100 nm. When the procedures (2) - (4) were repeated also to other different thicknesses of the anti-reflective layer (ARL layer thickness), an optimum condition for the anti-reflective layer depending on the thickness of the anti-reflective layer could be determined.
(6) It was investigated as to whether film species capable of satisfying the condition to be met by the anti-reflective layer determined in (5) above were present or not by using a spectroscopic ellipsometer (SOPRA Co.). As a result, it has been found that the optical constants show the change in Fig. 56 corresponding to the condition upon forming the SiₓO_{y}N_{z} or SiₓN_{y} film by using the CVD process. The regions shown by open circles in Fig. 56 satisfy the conditions for (4) described above. Figs. 54 and 55 show the results determining the standing wave effect under the condition shown by the open circles in Fig. 56. In each of the cases, the standing wave effect was less than about ±1.0% by using the SiₓO_{y}N_{z} or SiₓN_{y} film as the anti-reflective layer and the standing wave effect was reduced to about 1/20 as compared with the case of not using the anti-reflective layer.

### Example 78

In this example, SiₓO_{y}N_{z} or SiₓN_{y} was used as the anti-reflective layer ARL, particularly, in a case of patterning a silicic substrate such as of polycrystalline silicon, amorphous silicon or doped polysilicon, or a silicon oxide film such as SiO₂ on the silicic layer by a photo-lithographic step using a photoresist PR and an etching step by using the method shown in Example 77.

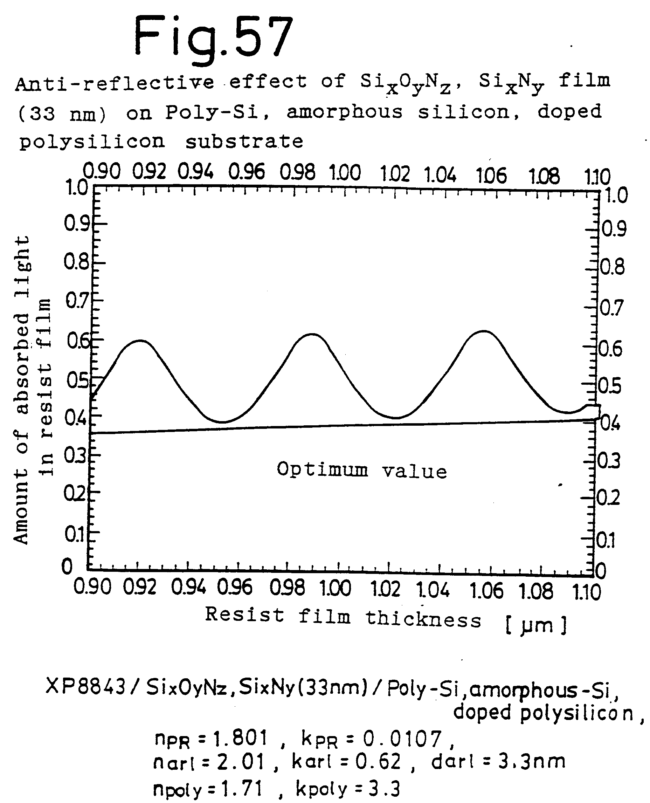

At first, description will be made to the procedures for selecting an organic or inorganic film having n = 1.8 - 2.6 and k = 0.1 - 0.8 at a film thickness of 20 - 150 nm, in particular, a SiₓO_{y}N_{z} or SiₓN_{y} film as an anti-reflective layer on a silicon series substrate such as of polycrystalline silicon, amorphous silicon or doped polysilicon by using the same method as in Example 77, as well as a method of determining the condition to be satisfied therewith.
(1) The optical condition to be satisfied by the optimum anti-reflective layer with a thickness of the anti-reflective layer, for example, of 33 nm by using the same method as in Example 77 was nₐᵣ₁ = 2.01, kₐᵣ₁ = 0.62. When the standing wave effect was determined by using this condition, the result as shown in Fig. 57 was obtained. The standing effect in Fig. 57 was extremely small and it was about less than ±1% in each of the cases. The standing wave effect was reduced to about 1/20 as compared with the case of not using the anti-reflective layer.
(2) The foregoing procedures were applied to the case of setting the thickness of the anti-reflective layer to 33 nm. When the above-mentioned procedures were repeated also for other anti-reflective layers of different thicknesses (ARL layer thickness), an optimum condition for the anti-reflective layer in accordance with the thickness of the anti-reflective layer was obtained.
(3) The condition to be satisfied by the anti-reflective layer determined above corresponds to the region shown by open circles in the change of the optical constants corresponding to the condition upon forming the SiₓO_{y}N_{z} or SiₓN_{y} film by using the CVD process (refer to Fig. 56). Fig. 57 shows the standing wave effect in the case of using the SiₓO_{y} N_{z} or SiₓN_{y} film at a thickness of 33 nm as the anti-reflective layer on the silicon series substrate such as of polycrystalline silicon, amorphous silicon and doped polysilicon and in a case of not using the anti-reflective layer. The standing wave effect in a case of setting the thickness of the SiₓO_{y}N_{z} or SiₓN_{y} film to 33 nm was less than about ±1.0% and the standing wave effect was reduced to less than about 1/20 as compared with the case of not using the anti-reflective layer.

### Example 79

In this example, the SiₓO_{y}N_{z} film shown in Examples 77 and 78 was formed by the following method to form an anti-reflective layer as shown in Example 53.

That is, in this example, a film was formed by utilizing a parallel plate plasma CVD process, ECR plasma CVD process or bias ECR plasma CVD process using a microwave (2.45 GHz) for a gas mixture of SiH₄ + O₂ + N₂ or a gas mixture of SiH₄ + N₂O.

### Example 80

In this example, the SiₓO_{y}N_{z} film shown in Examples 77 and 78 was formed by the following method to form the anti-reflective layer as shown in Fig. 53.

That is, in this example, the film was formed by utilizing a parallel plate plasma CVD process, ECR plasma CVD process or bias ECR plasma CVD process at a microwave (2.45 GHz) from a gas mixture of SiH₄ + O₂ + N₂ or a gas mixture of SiH₄ + N₂O using Ar as a buffer gas.

### Example 81

In this example, the SiₓO_{y}N_{z} film shown in Examples 77 and 78 was formed by the following method to form the anti-reflective layer as shown in Fig. 53.

That is, in this example, a film was formed by utilizing a parallel plate plasma CVD process, ECR plasma CVD process or a bias ECR plasma CVD process from a gas mixture of SiH₄ + O₂ + N₂ or a gas mixture of SiH₄ + N₂O.

### Example 82

In this example, the SiₓO_{y}N_{z} film shown in Examples 77 and 78 was formed by the following method to form the anti-reflective layer as shown in Fig. 53.

That is, in this example, a film was formed by utilizing a parallel plate plasma CVD process, ECR plasma CVD process or a bias ECR plasma CVD process from a gas mixture of SiH₄ + O₂ + N₂ or a gas mixture of SiH₄ + N₂O and using Ar as a buffer gas.

### Example 83

In this example, the SiₓN_{y} film shown in Examples 77 and 78 was formed by the following method to form the anti-reflective layer as shown in Fig. 53.

That is, in this example, a film was formed by utilizing a parallel plate plasma CVD process, ECR plasma CVD process or a bias ECR plasma CVD process using a microwave (2.45 GHz) from a gas mixture of SiH₄ + NH₃ or a gas mixture of SiH₂Cl₂ + NH₃.

### Example 84

In this example, the SiₓN_{y} film shown in Examples 77 and 78 was formed by the following method to form the anti-reflective layer as shown in Fig. 53.

That is, in this example, a film was formed by utilizing a parallel plate plasma CVD process, ECR plasma CVD process or a bias ECR plasma CVD process using a microwave (2.45 GHz) from a gas mixture of SiH₄ + O₂ or a gas mixture of SiH₂Cl₂ + NH₃ using Ar as a buffer gas.

### Example 85

In this example, the SiₓN_{y} film shown in Examples 77 and 78 was formed by the following method to form the anti-reflective layer as shown in Fig. 53.

That is, in this example, a film was formed by utilizing a parallel plate plasma CVD process, ECR plasma CVD process or a bias ECR plasma CVD process from a gas mixture of SiH₄ + NH₃ or a gas mixture of SiH₂Cl₂ + NH₃.

### Example 86

In this example, the SiₓN_{y} film shown in Examples 77 and 78 was formed by the following method to form the anti-reflective layer as shown in Fig. 53.

That is, in this example, a film was formed by utilizing a parallel plate plasma CVD process, ECR plasma CVD process or a bias ECR plasma CVD process from a gas mixture of SiH₄ + O₂ or a gas mixture of SiH₂Cl₂ + NH₃ using Ar as a buffer gas.

### Example 87

In this example, the SiₓO_{y}N_{z} or SiₓN_{y} film shown in Examples 77 and 78 was etched as the underlying material using the resist pattern as a mask by the following method.

That is, the Siₓo_{y}N_{z} or SiₓN_{y} film was etched by a reactive etching process using a gas system of CHF₃ (50 - 100 SCCM) + O₂ (3 - 20 SCCM), under a pressure of about 2 Pa, with a power of about 100 - 1000 W and with the improved ionic property, to obtain a desired pattern by etching.

### Example 88

In this example, the SiₓO_{y}N_{z} or SiₓN_{y} film shown in Examples 77 and 78 was etched as the underlying material using the resist pattern as a mask by the following method.

That is, the Siₓo_{y}N_{z} or SiₓN_{y} film was etched by a reactive etching process using a gas system of C₄F₈ (30 - 70 SCCM) + CHF₃ (10 - 30 SCCM), under a pressure of about 2 Pa, with a power of about 100 - 1000 W and with the improved ionic property, to obtain a desired pattern by etching.

### Example 89

In this example, the SiₓO_{y}N_{z} or SiₓN_{y} film shown in Examples 77 and 78 was etched as the underlying material using the resist pattern as a mask by the following method.

That is, the Siₓo_{y}N_{z} or SiₓN_{y} film was etched by a reactive etching process using a gas system of S₂F₂ (5 - 30 SCCM), under a pressure of about 2 Pa, with a power of about 100 - 1000 W and with the improved ionic property, to obtain a desired pattern by etching.

As has been described above, according to the present invention, in a case of forming a resist pattern on an optional underlying material (substrate) by using an optional monochromatic light as an exposure optical source, the condition for an anti-reflective layer used therein can be determined such that a stable resist pattern can be formed satisfactorily even if the resist pattern is fine. Further, according to the present invention, an anti-reflective layer with such a condition can be formed. Furthermore, according to the present invention, a novel anti-reflective layer can be developed to provide a method of forming a resist pattern using such an anti-reflective layer.

### EMBODIMENT 12 (illustrative)

### Example 90

In this example, a SiOxNy film is formed by using SiH₄ and N₂O mix gas as raw gas. It is recognized that the formed film contains hydrogen.

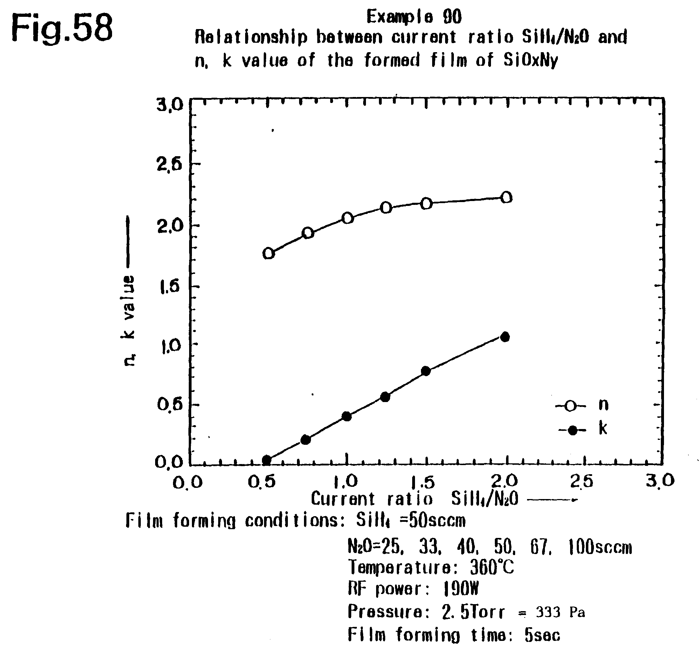

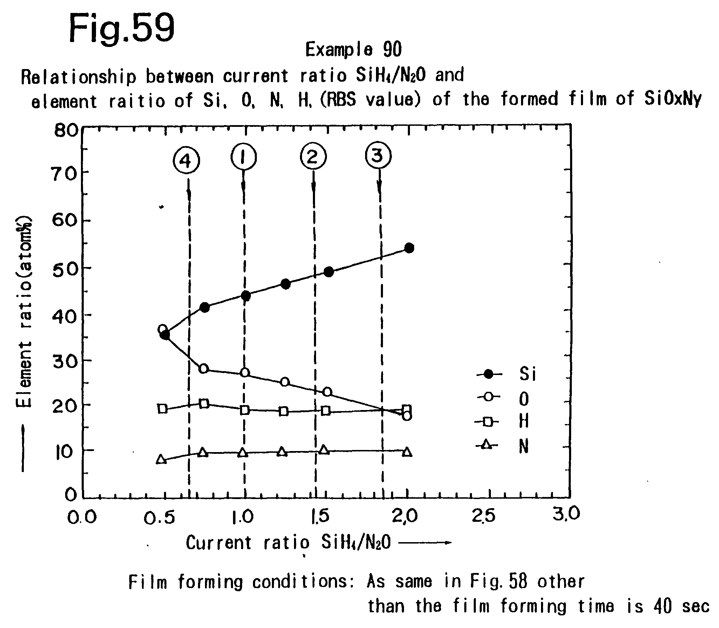

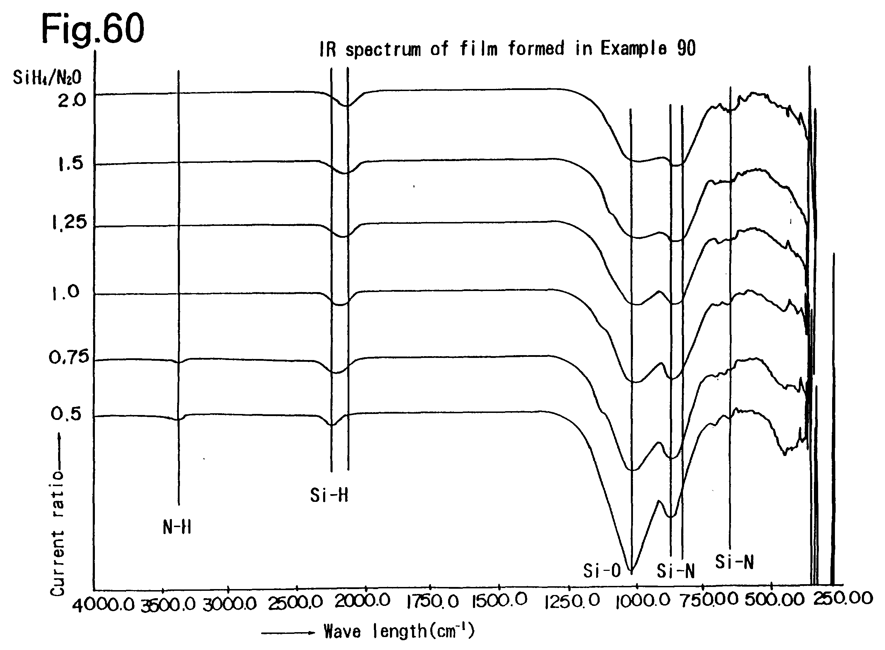

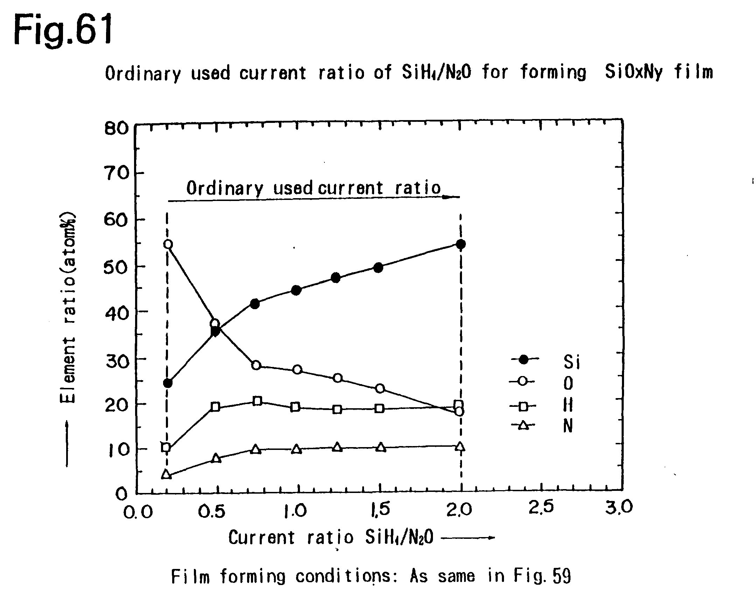

Referring to Fig.58 and Fig.59, Fig.58 shows relationship between current ratio SiH₄/N₂O and n,k value of the formed film in this example. Fig.59 shows relationship between current ratio SiH₄/N₂O and atomic ratio of Si,O,N,H(atom %) of the formed film in this example. As is understood through Fig.59, the formed SiOxNy film contains H, though the contain ratio changes according to current ratio SiH₄/N₂O. It shows the fact that SiOxNyHz film is formed.

Qualitavely speaking, as appeared in IR spectrum of Fig.60, in any case of various current ratio, there exists not only peaks showing Si-O, or Si-N bond but exists peaks showing N-H, Si-H bond.

It is considered that the existence of such hydrogen makes a contribution to the anti-reflect effect to a certain extent. It is considered that there exists hydrogen in any shape in obtained film, when hydrogen-containing raw gas is used. Especially, in film forming method using plasuama, the existence of such hydrogen is remarkable.

In this example, varioius x.y.z values of SioxNyHz film investigated from the current ratio SiH₄/N₂O based on Fig.58 which gives most suitable k and n value for i-line and excimer laser are shown in following table 1. In this experimet, WSi as refractry metal silicide, WSi with SiO₂, and Al-1wt%Si as metal material are used as underlying material. And on the above mentioned underlying materials, various thickness of anti-reflective layers are formed on said underlying material using said SiH₄/N₂O mixed gas.

**TABLE 1**

| x.y.z values of SioxNyHz | | | | | | | |
|---|---|---|---|---|---|---|---|
| No | under-lying material | light | thickness of anti-reflective layer(nm) | x | y | z | current ratio of SiH₄/N₂O |
| 1 | WSi | i-line | 27 | 0.614 | 0.227 | 0.432 | 1.0 |
| 2 | WSi(with SiO₂ | excimer | 30 | 0.479 | 0.208 | 0.375 | 1.43 |
| 3 | Al-Si | excimer | 24 | 0.358 | 0.189 | 0.358 | 1.85 |
| 4 | Al-Si | excimer | 70 | 0.842 | 0.263 | 0.526 | 0.66 |

Points of current ratio corresponding to the above 1 to 4, there are drawn the lines showing them, in Fig.59.

According to the present invention, the followings are understood. In case that SiOxNy;Hz is used as an anti-reflective layer for WSi for wavelength 150 to 450 nm, it is preferred that x is 0.03 to 0.80, and y is 0.10 to 0.30, z can be sero, but when hydrogen is contained, it is preferred that z is 0.20 to 0.60.
According to the present invention, the followings are also understood. In case that SioxNy:Hz is used as an anti-reflective layer for AI-Si for wavelength 150 to 450 nm, it is preferred that x is 0.03 to 0.70, and y is 0.05 to 0.30. z can be sero, but when hydrogen is contained, it is preferred that z is 0.1 to 0.5.

As shown in Fig.61, ordinarily used current ratio of SiH₄/N₂O for forming SiOxNy film is 0.2 to 2.0.

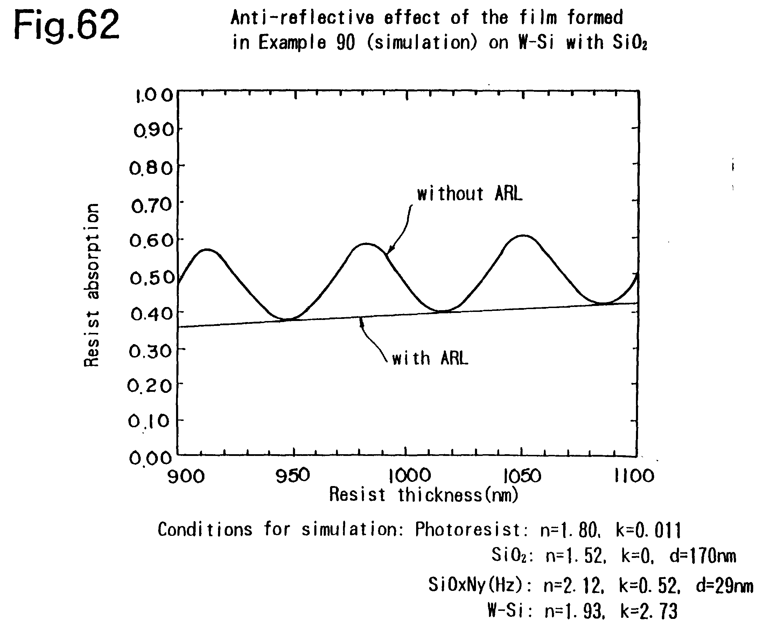

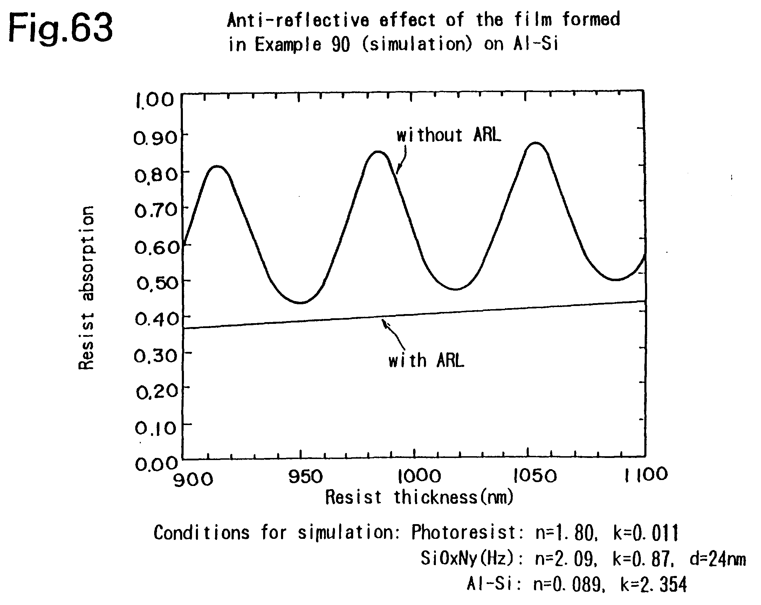

Figs.62 and 63 show simulated anti-reflect effect ( effect for decreasing standing wave) when anti-reflective layers obtained in this example are used. Fig.62 shows the case that WSi with SiO₂ is used as underlying material. Fig.63 shows the case that AI-Si is used as underlying material. By referring Figs.62 and 63, it is understood that in the case having anti-reflective layers (with ARL) there diminished most of standing effect, compared with the case having no anti-reflective layers (without ARL).

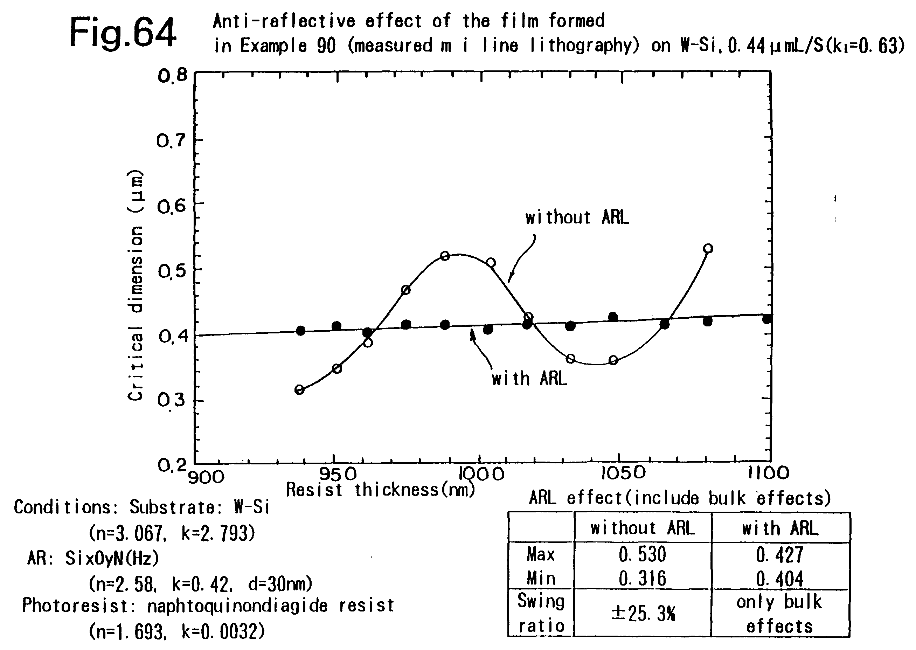

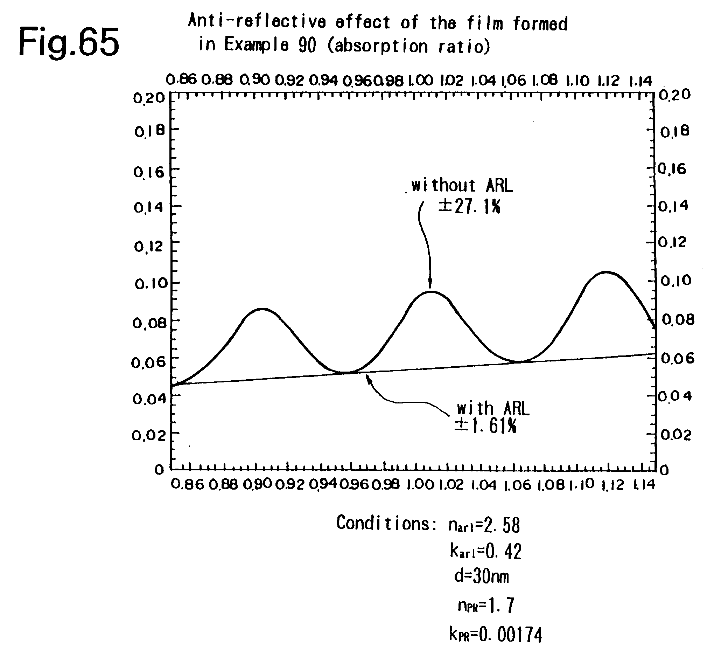

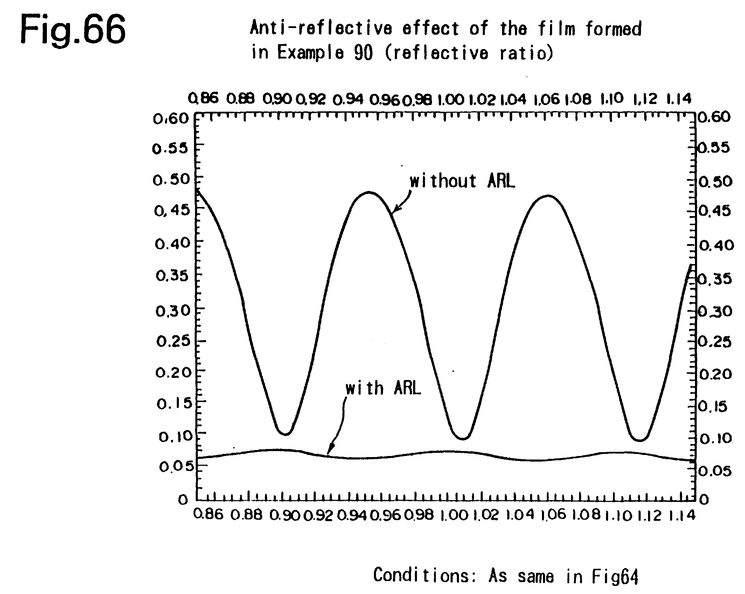

Fig.64 shows the measured anti-reflect effect on 0.44 m line and space pattern in real i-line lithography process. By referring Fig.64, anti-reflect effect in this example is also understood.

Figs.65 and 66 show simulated anti-reflect effect. Fig.65 shows the case that WSi is used as underlying material (i-line, absorption ratio). Fig.66 shows also the case that WSi is used as underlying material (i-line, reflective ratio). An anti-reflective layer of 30 nm with n, k, value described in the Figures is formed, and deta are measured by using photoresist with n, k, value described in the Figures. Superior anti-reflective effect is obtained in both case of absorption ratio and reflective ratio.

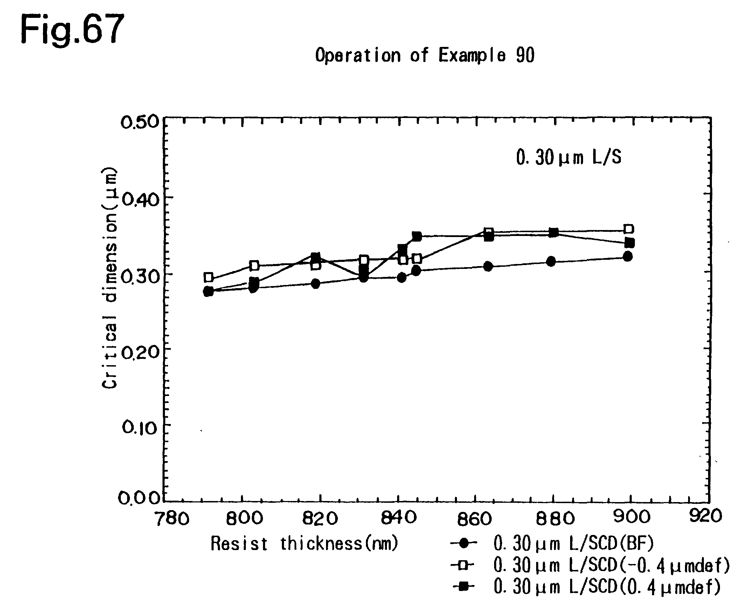

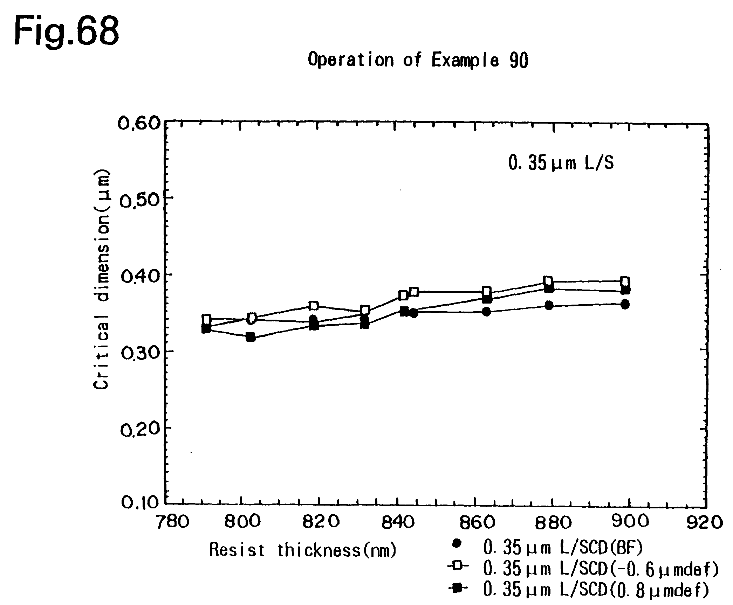

Figs.67 and 68 show the relationship between thickness of photoresist and critical dimension. The experiment is operated using WSi as underlying material, and KrF excimer laser. Fig.67 shows the case that data are measured concerning 0.30 m line and space pattern. Fig.68 shows the case that data are measured concerning 0.35 m line and space pattern. In both cases, chemical amplifying posi resist is used.

### Example 91

As aforementioned, the material n value of which is about 2.4 and k value of which is about 0.7 is suitable as an anti-reflective layer for excimer laser on, for example, refractory metal silicide. And also as aforementioned, SiOx, SINx, or SiOxNy is effective such an anti-reflecive layer as described above. It is considered that SiOx, SiNx, or SiOxNy with the n value and k value as described above which is effective for anti-reflectivity can be formed by controlling the n value and k value by controlling the element ratio x and y. It is , however, difficult to obtain a film with desired n value and k value by controlling the ratio by suitable means.

In this example, in order to obtain a film with desired n value and k value, the anti-reflective layer is formed by using as raw gas containing at least silicon element and oxide element. For example, in order to control the element ratio x of SiOx, by using gas current ratio as parameter, it is possible to make x smaller through using higher ratio of raw gas containing silicon element. As a result, the atomic ratio can be controlled, and the optical constant (n,k) can be controlled.

In this example, SiH₄, is used as raw gas containing at least silicon element, and N₂O is used as raw gas containing at least oxide element. The film with desired anti-reflective effect can be formed by controlling the optical constant through using current ratio of SiH₄ and N₂O as parameter. Fig.58 shows the change of the optical constant of the formed film when the current ratio of SiH₄ and N₂O in parallel electrodetype plasuma CVD camber is changed. The suitable example of film forming conditions for excimer lithography are as follows.
SiH₄ = 50sccm
N₂O = 50sccm
RF power = 190W
pressure = 332.5Pa(2.5torr)
temperature of the substrate = 400 C
distance between electrodes = 1cm

In the above mentioned means, current ratio of raw gas is mainly used as to control optical
constant, however, pressure of film forming atmospere, RF power, or temperature of the substrate can be used to control optical constant as parameter.

### Example 92

In this example, an anti-reflective layer is formed by using at least one kind of organic compounds containing at least silicon element as raw material. As a result of using an organic compound, coverage of an anti-reflective layer on step improves. Namely, a difference between thickness of an anti-reflective layer on even portion and that of perpendicular portion of step in this example is small, and uniformity of anti-reflective effect in semiconductor device tip improves.

In this example, as an organic compound which has improved step covarage is used, this example can be said it is especally effective for device with severe unevenness. As an organic compound, for example, TEOS, OMCTS(Si₄O(CH₃)₈;Si/O ratio=1), HMDS(Si₂O(CH₃)₈;Si/O ratio =2) and so on can be used. In this example, used conditions for forming film in parallel electrode plasuma CVD chamber are as follows.
OMCTS = 50sccm
RF power = 190W
pressure = 332.5Pa(2.5torr)
temperature of the substrate = 400° C
distance between electrodes = 1 cm

### Example 93

When Si content of desired film is larger than the above example 92, SiH₄, which is Si source gas without containing O, N, can be added. In this case, the example of conditions for forming film in parallel electrode plasuma CVD chamber are as follows.
OMCTS = 50sccm
SiH₄ = 5sccm
RF power = 190W
pressure = 332.50Pa(2.5torr)
temperature of the substrate = 400°C

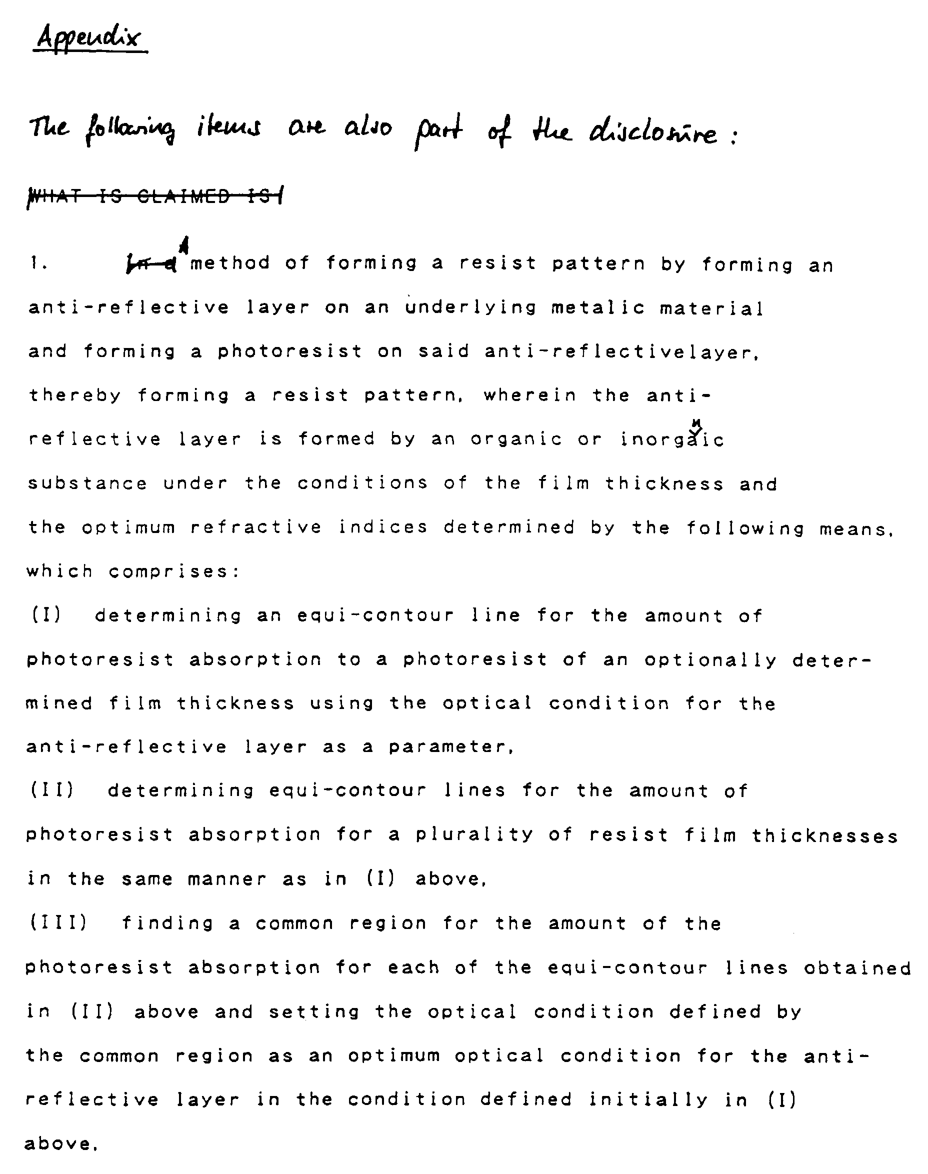

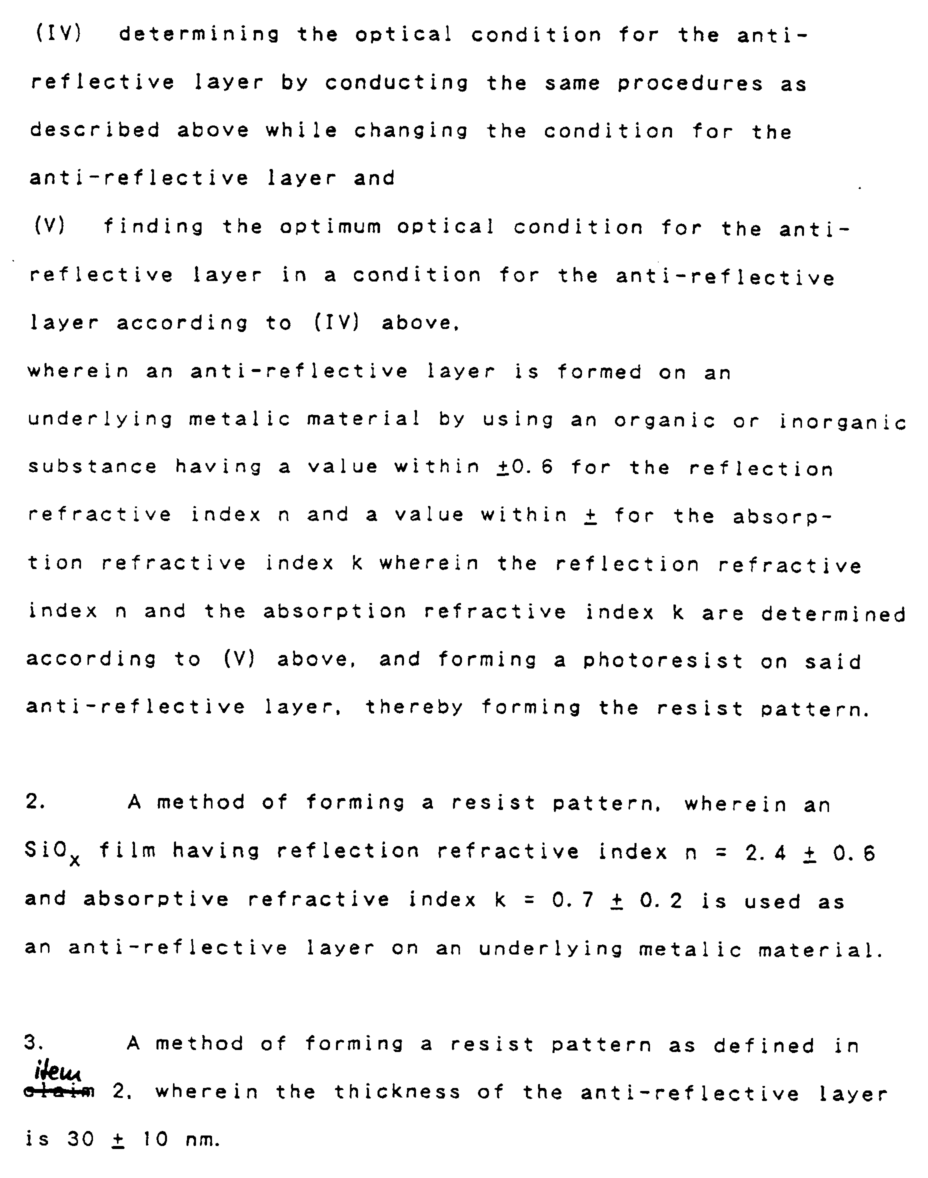

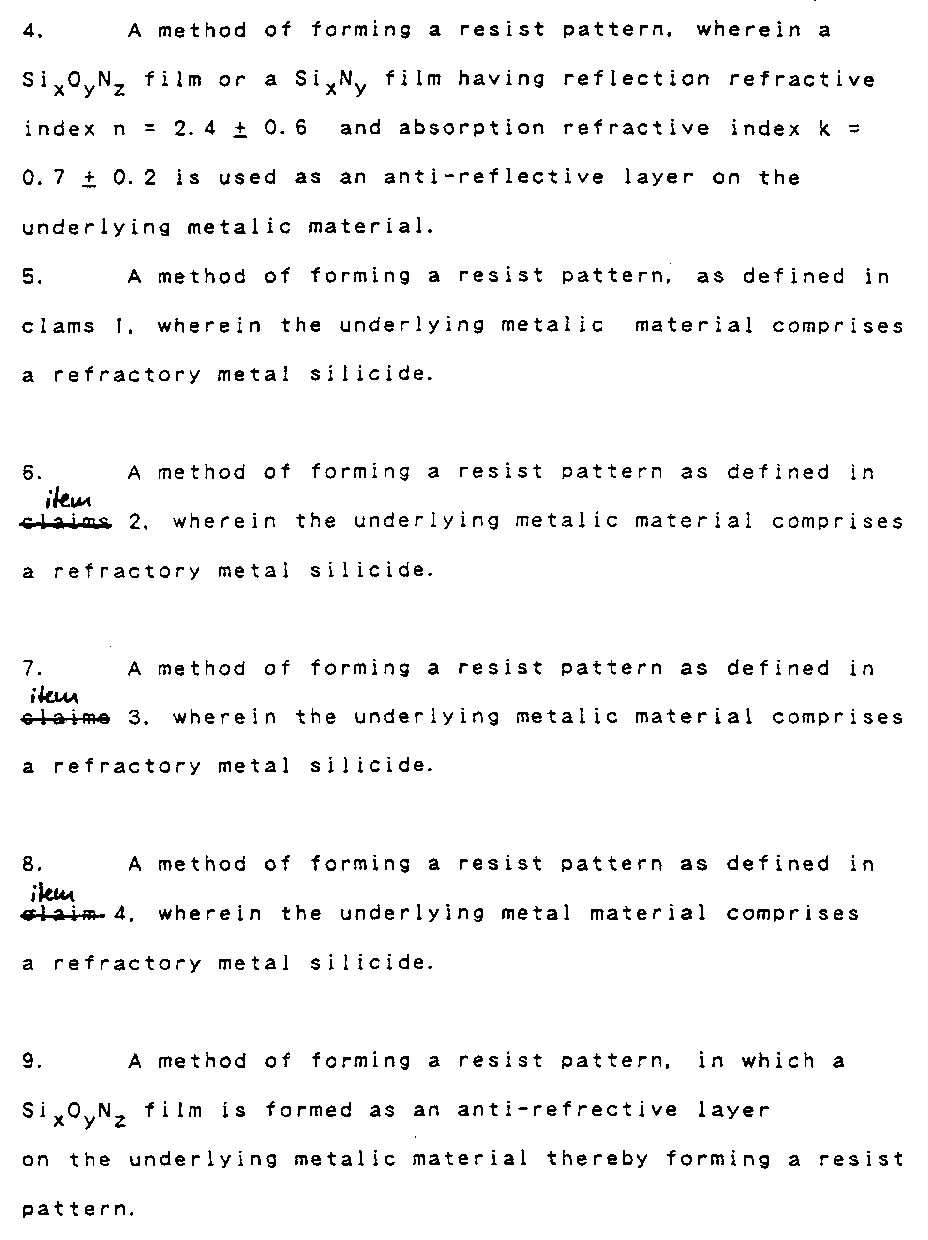

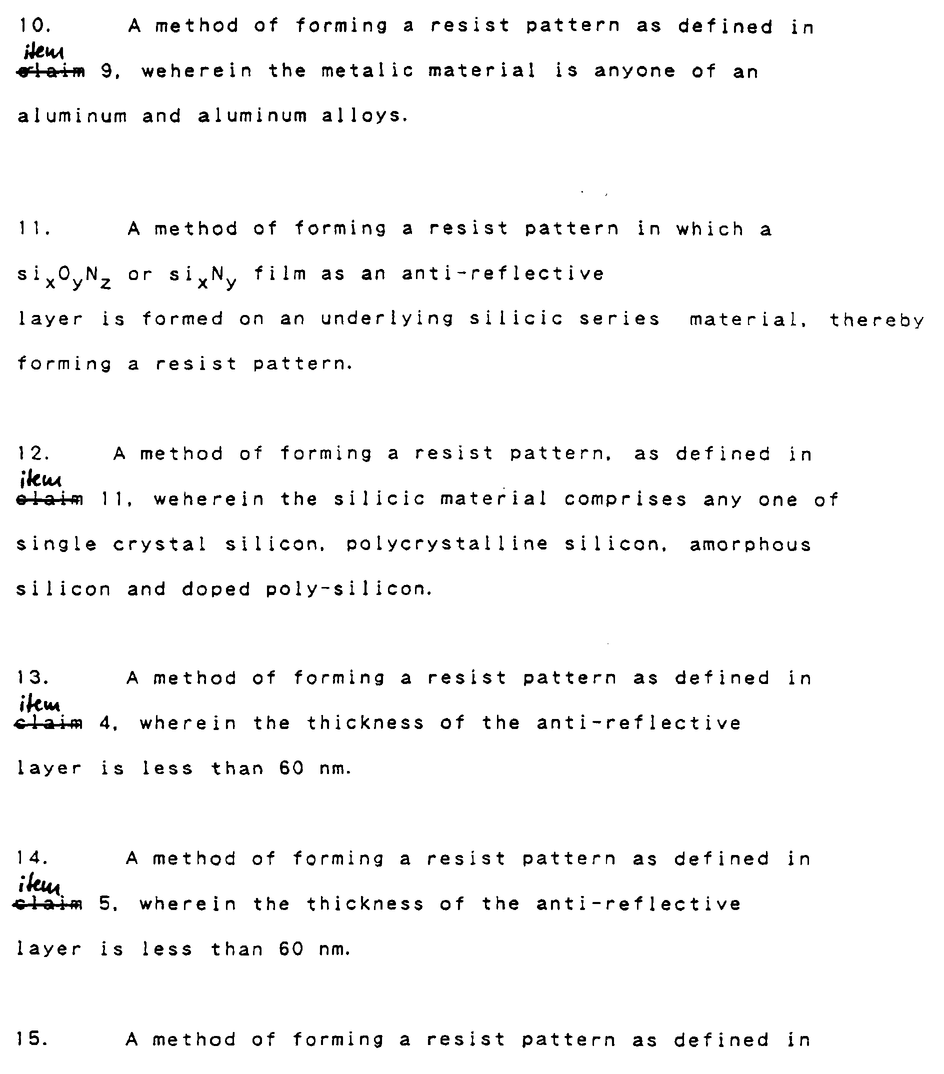

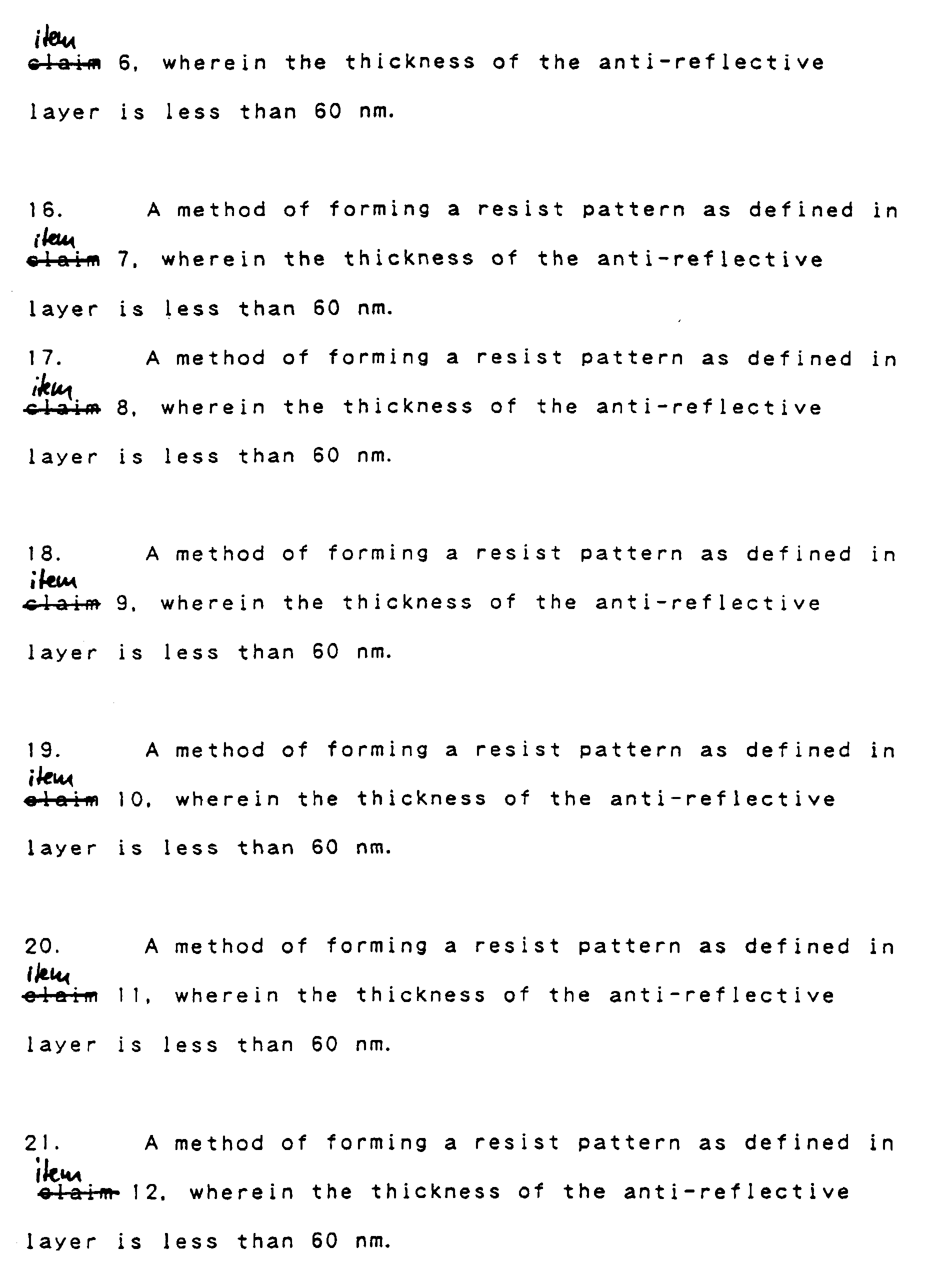

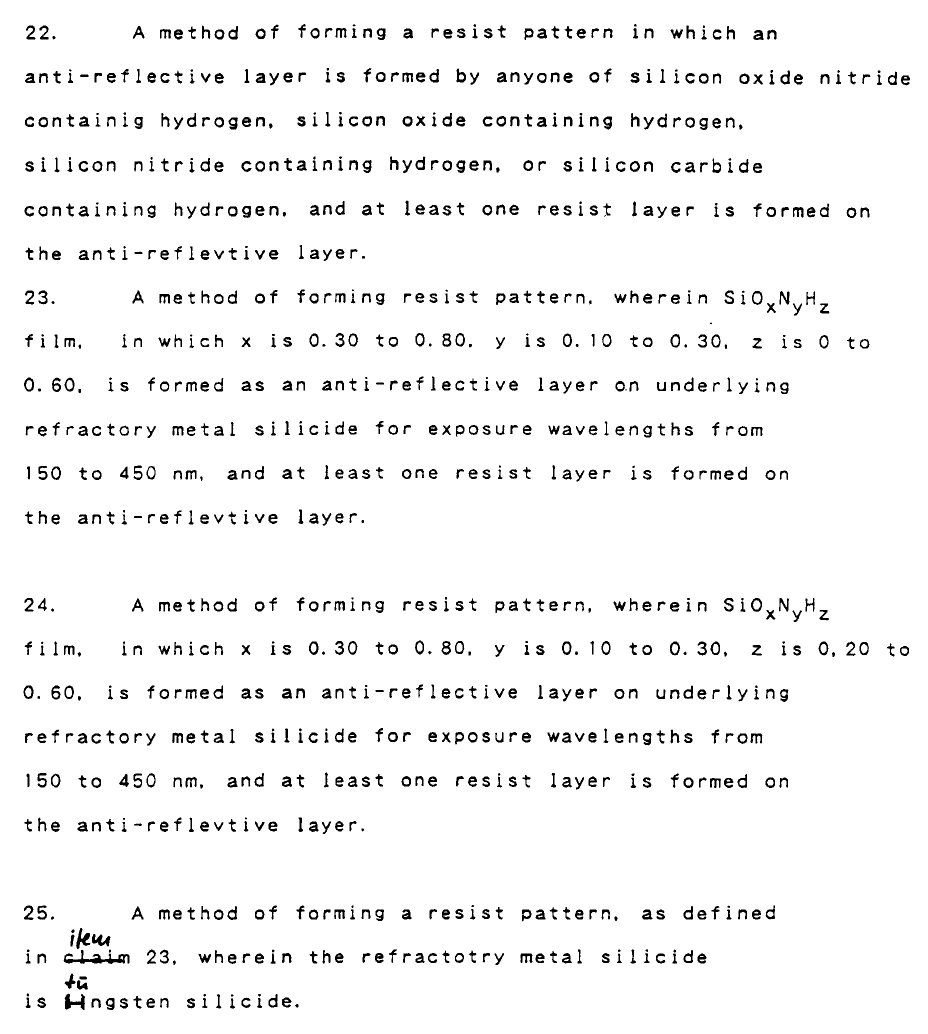

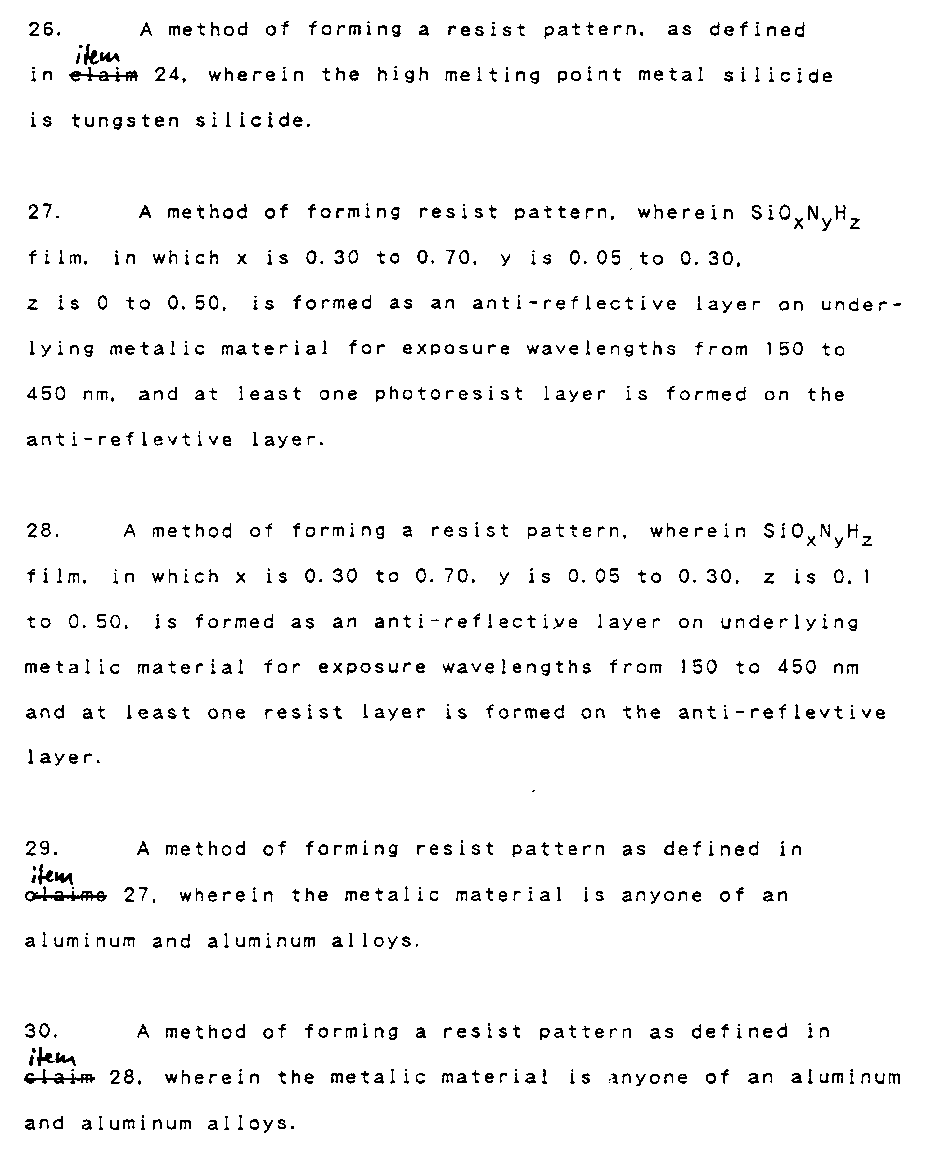

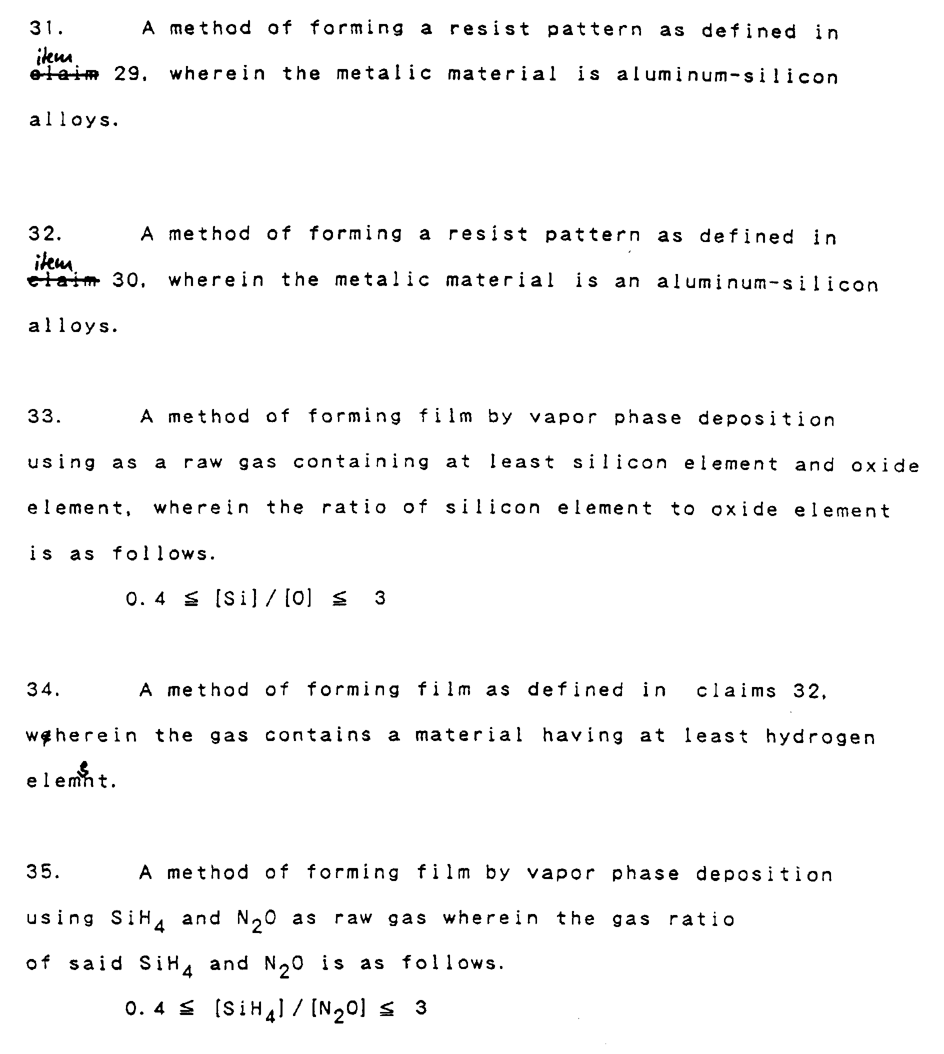

## Claims

1. A method of forming a resist pattern comprising the steps of
forming an anti-reflective layer on an underlying metallic material,
forming a photoresist layer on said anti-reflective layer,
exposing said photoresist to monochromatic light, and
developing said photoresist,
wherein said anti-reflective layer is a silicon carbide layer and
wherein the reflection refractive index n and the absorption refractive index k of said anti-reflective layer have a value near the optimal reflection refractive index and the optimal absorption refractive index, respectively, wherein said optimal reflection refractive index and said optimal absorption refractive index are obtainable by a method comprising the steps of
(I) determining an equi-contour line for the amount of energy absorption in a photoresist of an optionally determined film thickness using said reflection refractive index and said absorption refractive index of said anti-reflective layer as parameters,
(II) determining equi-contour lines for the amount of photoresist absorption for a plurality of resist film thicknesses in the same manner as in (I) above,
(III) finding a common region for the amount of the photoresist absorption for each of the equi-contour lines obtained in (II) above and setting the refractive indices defined by the common region as optimal refractive indices for the anti-reflective layer in the condition defined Initially in (I) above,
(IV) determining the optical condition for the anti-reflective layer by conducting the same procedures as described above while changing the thickness of the anti-reflective layer and
(V) finding the optimal refractive indices for the anti-reflective layer for various thicknesses of the anti-reflective layer according to (IV) above.

2. The method according to claim 1, wherein the underlying metallic material comprises a refractory metal silicide.

3. The method according to claim 1 or claim 2, wherein said metallic material is W-Si and said anti-reflective layer has a thickness of 50 ± 10 nm, a reflection refractive index n = 3.16 ± 0.2 and an absorption refractive index k = 0.24 ± 0.1 or a thickness of 30 ± 10 nm, a reflection refractive index n = 2.4 ± 0.6 and an absorption refractive index k = 0.7 ± 0.2.

4. The method according to anyone of claims 1 to 3, wherein said anti-reflective layer having said values for said reflection refractive index n and said absorption refractive index k for a given thickness of said anti-reflective layer is formed by a parallel plate plasma CVD process or a ECR plasma CVD process or a bias ECR plasma CVD process.

5. The method according to claim 4, wherein a microwave at 2.45 GHz is used.

6. The method according to claim 4 or claim 5, wherein said anti-reflective layer is formed from a gas mixture of SiH₄, CH₄ and H₂.

7. The method according to anyone of claims 1 to 3, wherein said anti-reflective layer is formed by utilizing a sputtering method using SiC as a target.
